# EUROPEAN PATENT SPECIFICATION

(11) **EP 3 126 368 B1**
(45) Date of publication and mention of the grant of the patent: **29.04.2020**
(21) Application number: 15712157.5
(22) Date of filing: 26.03.2015
(51) Int. Cl.: C07F 7/08, H01L 51/00, H01L 51/50

(54) **SILYL-BENZIMIDAZOLO[1,2-A]BENZIMIDAZOLE AS HOST FOR ORGANIC LIGHT EMITTING DIODES**
SILYL-BENZIMIDAZOLO[1,2-A]BENZIMIDAZOL ALS WIRT FÜR ORGANISCHE LICHTEMITTIERENDE DIODEN
SILYL-BENZIMIDAZOLO[1,2-A]BENZIMIDAZOLE EN TANT QU'HÔTE POUR DES DIODES ÉLECTROLUMINESCENTES ORGANIQUES

(30) Priority: 31.03.2014 EP 14162667
(43) Date of publication of application: 08.02.2017
(73) Proprietor: Idemitsu Kosan Co., Ltd, Tokyo 100-8321 (JP)
(72) Inventor: SCHÄFER, Thomas, CH-4410 Liestal (CH); STENGEL, Ilona, 79639 Grenzach-Wyhlen (DE); HEINEMEYER, Ute, 67433 Neustadt (DE); NAGASHIMA, Hideaki, CH-4057 Basel (CH); BARDON, Kristina, 79761 Waldshut (DE)
(74) Representative: Hollah, Dorothee
(86) International application number: PCT/EP2015/056609
(87) International publication number: WO 2015/150234

(56) References cited:
- WO-A1-2014/009317
- WO-A1-2014/044722

## Description

The present invention relates to compounds of formula I and their use in electronic devices, especially electroluminescent devices. When used as hole transport material in electroluminescent devices, the compounds of formula I may provide improved efficiency, stability, manufacturability, or spectral characteristics of electroluminescent devices.

DE102012000064 describes compounds of formula 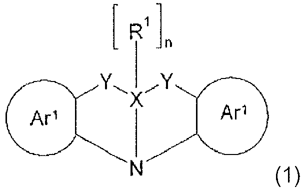 and their use in organic light emitting devices (OLEDs). Among others X can be C. If X is C, n is 1.

WO2012139692 relates to electronic devices which comprise an anode, a cathode and at least one organic layer, where the organic layer comprises one or more substituted benzene compounds of formula 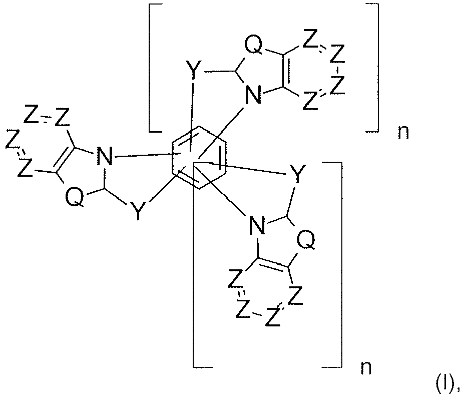 or 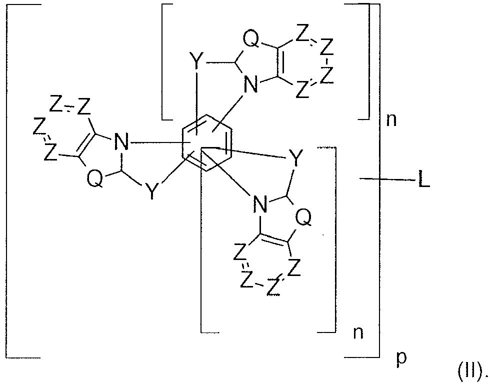 Y can be S and n can be 0 or 1, Z is CR¹ or N. R¹ can be an aromatic or hetero aromatic ring system.

WO2011/160757 relates to an electronic device comprising an anode, cathode and at least one organic layer which contains a compound of formulae 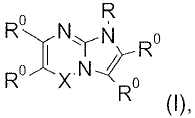 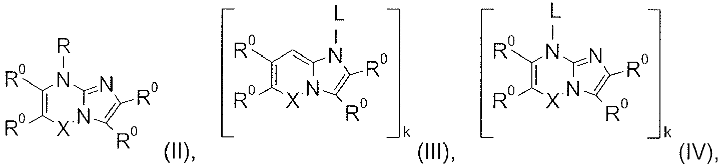 wherein X may be a single bond and L may be a divalent group. The following 4H-Imidazo[1,2-a]imidazole compounds are explicitly disclosed: 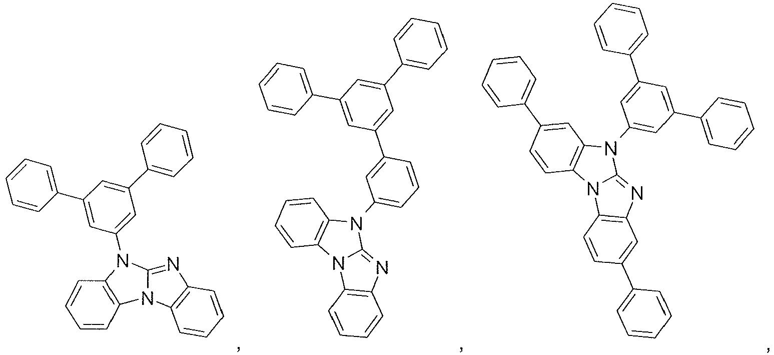 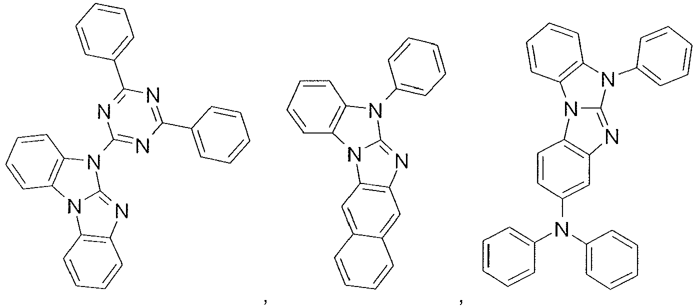 and

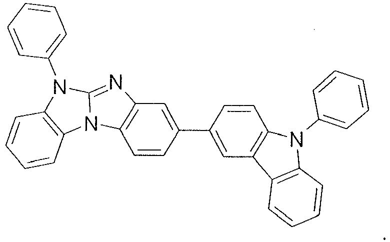

WO2012/130709 relates to 4H-Imidazo[1,2-a]imidazoles, 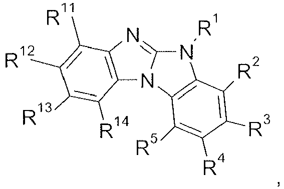 such as, for example, 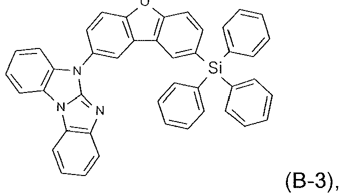 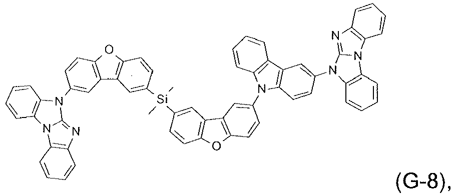 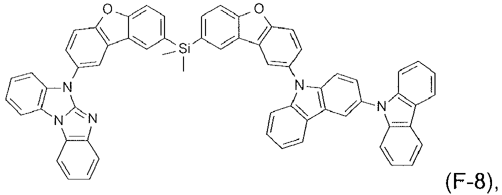 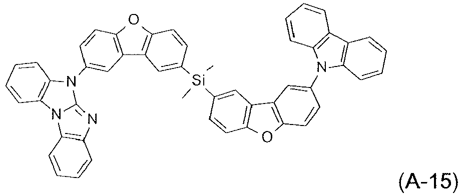 and 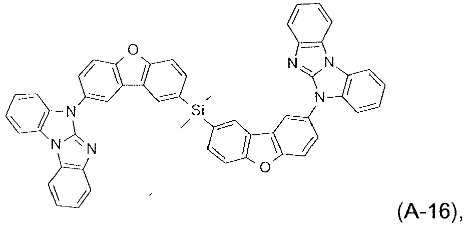 a process for their production and their use in electronic devices, especially electroluminescent devices.

WO2013/050401 describes 4H-imidazo[1,2-a]imidazoles of formula 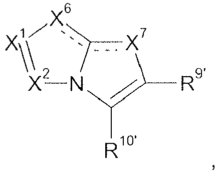 wherein X⁶ is -N= and X⁷ is -NR⁶-, or X⁷ is =N- and X⁶ is -NR⁶-, R⁶ is a group of formula 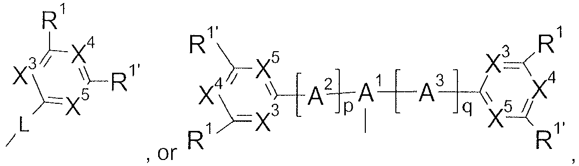 such as, for example, 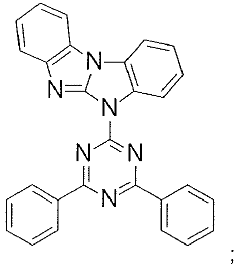 a process for their production and their use in electronic devices, especially electroluminescent devices.

WO2014/009317 relates to compounds of formula 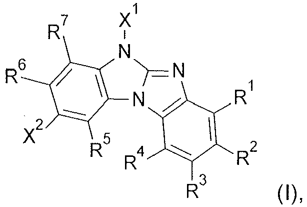 such as, for example, 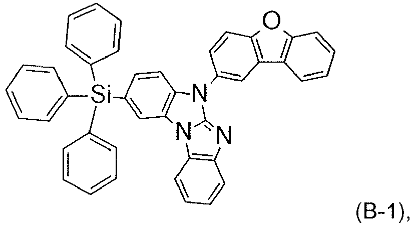 a process for their production and their use in electronic devices, especially electroluminescent devices. The 2,5-disubstituted benzimidazo[1,2-a]benzimidazole derivatives are suitable hole transporting materials, or host materials for phosphorescent emitters.

WO2014/044722 relates to compounds of formula 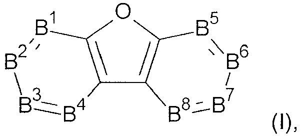 which are characterized in that they substituted by benzimidazo[1,2-a]benzimidazo-5-yl and/or benzimidazo[1,2-a]benzimidazo-2,5-ylene groups and in that at least one of the substituents B¹, B², B³, B⁴, B⁵, B⁶, B⁷ and B⁸ represents N, a process for their production and their use in electronic devices, especially electroluminescent devices. The compounds of WO2014/044722 may be used host material for phosphorescent emitters in electroluminescent devices.

PCT/EP2014/073038 relates to compounds of formula 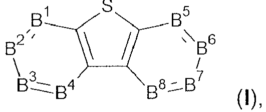 which are characterized in that they are substituted by benzimidazo[1,2-a]benzimidazo-5-yl and/or benzimidazo[1,2-a]benzimidazo-2,5-ylene groups and in that at least one of the substituents B¹, B², B³, B⁴, B⁵, B⁶, B⁷ and B⁸ represents N; a process for their production and their use in electronic devices, especially electroluminescent devices.

Notwithstanding these developments, there remains a need for organic light emitting devices comprising new hole transport materials to provide improved efficiency, stability, manufacturability, and/or spectral characteristics of electroluminescent devices.

Accordingly, it is an object of the present invention, with respect to the aforementioned prior art, to provide further materials suitable for use in OLEDs and further applications in organic electronics. More particularly, it should be possible to provide hole transport materials, electron/exciton blocker materials and matrix materials for use in OLEDs. The materials should be suitable especially for OLEDs which comprise at least one phosphorescence emitter, especially at least one green emitter or at least one blue emitter. Furthermore, the materials should be suitable for providing OLEDs which ensure good efficiencies, good operative lifetimes and a high stability to thermal stress, and a low use and operating voltage of the OLEDs.

Said object has been solved by compounds of the formula 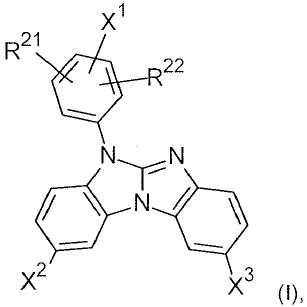 wherein
X¹ is H, a group of formula 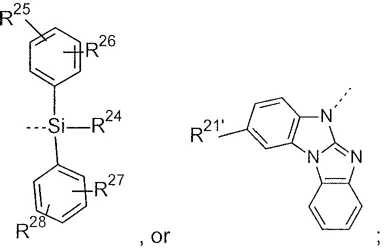
X² and X³ are independently of each other H, or a group of formula 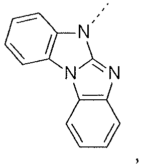 or 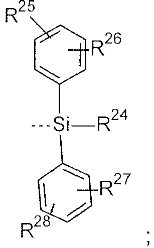
R24 is a group of formula 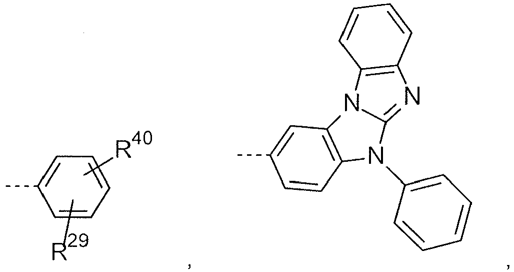 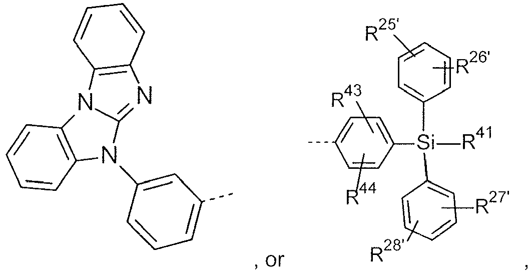
R⁴¹ is 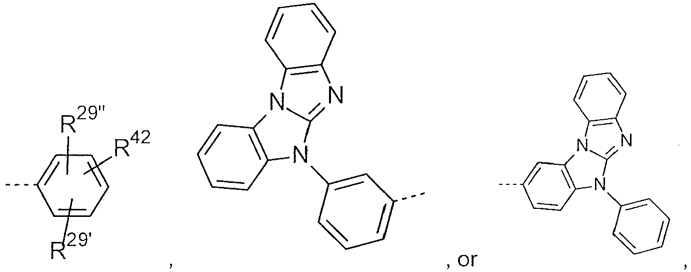
R⁴² is H, or 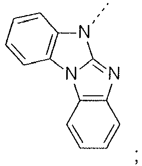
R²¹ and R^{21'} are independently of each other H, a C₁-C₁₈alkoxy group; a C₁-C₁₈alkyl group; or a C₁-C₁₈alkyl group which is interrupted by -O-, or a group of formula 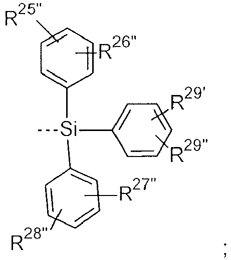
R²², R²⁵, R²⁶, R²⁷, R²⁸, R^{25'}, R^{26'}, R^{27'}, R^{28'}, R^{25'}, R^{26"}, R^{27"}, R^{28"}, R²⁹, R^{29'}, R^{29"}, R⁴³ and R⁴⁴ and R⁴⁰ are independently of each other H, a C₁-C₁₈alkoxy group; a C₁-C₁₈alkyl group; or a C₁-C₁₈alkyl group which is interrupted by -O-; with the proviso that at least one of X¹, X² and X³ is a group of formula 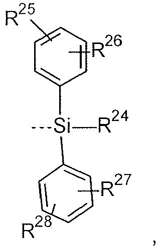 or comprises a group of formula

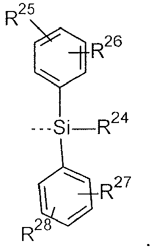

Certain compounds of the present invention have a HOMO level of 6.0 - 5.7 eV and show, when used as host in combination with phosphorescent emitters, excellent power efficiencies, in particular. electroluminescent (EL) devices comprising the compounds of the present invention exhibit reduced drive voltage while maintaining excellent luminance properties.

The compounds of the present invention have triplet energies of greater than 3.0 eV and, hence, are especially suitable as host for deep blue phosphorescent emitters and in display applications. Whereas the compound 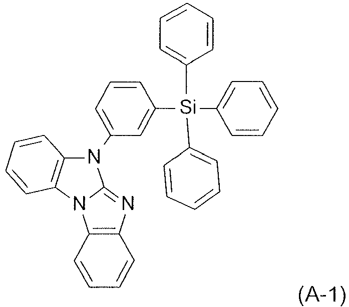 of the present invention has a triplet energy (T₁) of 3.3 eV, the compound of formula 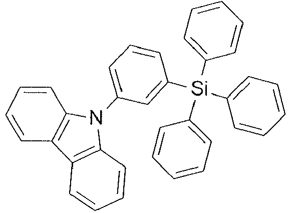 described in US 20070173657 has a T₁ of 3.05 eV.

The compounds of the present invention may be used for electrophotographic photoreceptors, photoelectric converters, organic solar cells (organic photovoltaics), switching elements, such as organic transistors, for example, organic FETs and organic TFTs, organic light emitting field effect transistors (OLEFETs), image sensors, dye lasers and electroluminescent devices, such as, for example, organic light-emitting diodes (OLEDs).

Accordingly, a further subject of the present invention is directed to an electronic device, comprising a compound according to the present invention. The electronic device is preferably an electroluminescent device.

The compounds of formula I can in principal be used in any layer of an EL device, but are preferably used as host, hole transport and electron blocking material. Particularly, the compounds of formula I are used as host material for blue light emitting phosphorescent emitters.

Hence, a further subject of the present invention is directed to an hole transport layer, comprising a compound of formula I according to the present invention.

A further subject of the present invention is directed to an emitting layer, comprising a compound of formula I according to the present invention. In said embodiment a compound of formula I is preferably used as host material in combination with a phosphorescent emitter.

The compounds of formula I have preferably a molecular weight below 1500 g/mol.

A further subject of the present invention is directed to an electron blocking layer, comprising a compound of formula I according to the present invention.

Compounds of formula (I) are preferred, wherein
X¹ is H, a group of formula 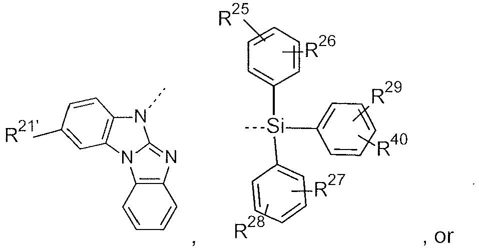 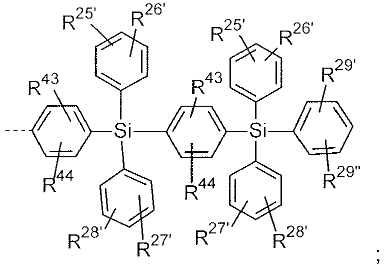
X² and X³ are independently of each other H, or a group of formula 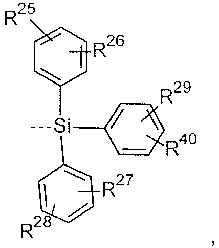 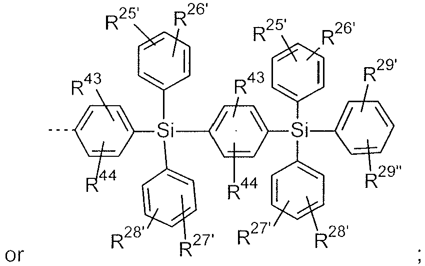
R²¹ and R^{21'} are independently of each other H, or a group of formula a group of formula 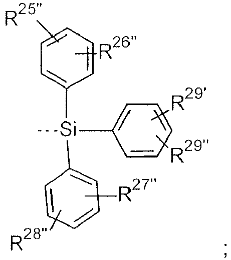
R²² is H;
R²⁵, R²⁶, R²⁷, R²⁸, R^{25'}, R^{26'}, R^{27'}, R^{28'}, R^{25'}, R^{26"}, R^{27"}, R^{28"}, R²⁹, R^{29'}, R^{29"}, R⁴⁰, R⁴³ and R⁴⁴ are independently of each other H, or a C₁-C₁₈alkyl group, with the proviso that at least one of X¹, X² and X³ is group of formula 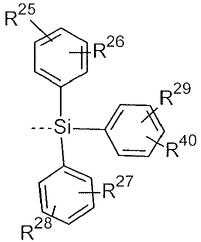 and/or 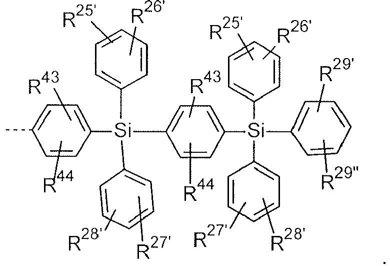 In said embodiment compounds are more preferred, wherein R²⁵, R²⁶, R²¹, R²⁸, R^{25'}, R^{26'}, R^{27'}, R^{28'}, R^{25'}, R^{26"}, R^{27"}, R^{28"}, R²⁹, R^{29'}, R^{29"}, R⁴⁰, R⁴³ and R⁴⁴ are H.

In addition, compounds of formula (I) are preferred, wherein
X¹ is a group of formula 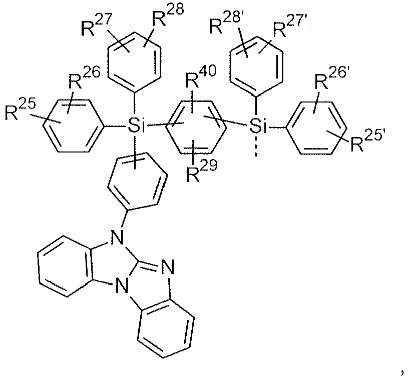 wherein R²⁵, R²⁶, R²⁷, R²⁸, R^{25'}, R^{26'}, R^{27'}, R^{28'}, R²⁹ and R⁴⁰ are independently of each other H, or a C₁-C₁₈alkyl group, and X², X³, R²¹, R²² and X³ are H.
R²⁵, R²⁶, R²⁷, R²⁸, R^{25'}, R^{26'}, R^{27'}, R^{28'}, R²⁹ and R⁴⁰ are preferably H.

In addition, compounds of formula (I) are preferred, wherein
X² is a group of formula 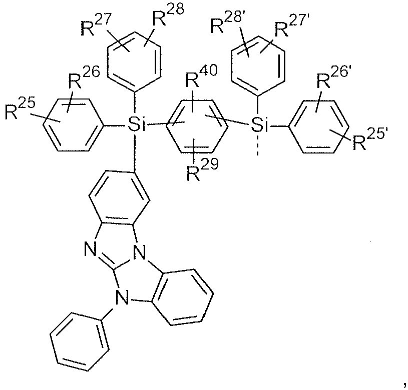 wherein R²⁵, R²⁶, R²⁷, R²⁸, R^{25'}, R^{26'}, R^{27'}, R^{28'}, R²⁹ and R⁴⁰ are independently of each other H, or a C₁-C₁₈alkyl group, and X¹, X³, R²¹, R²² and X³ are H.
R²⁵, R²⁶, R²⁷, R²⁸, R^{25'}, R^{26'}, R^{27'}, R^{28'}, R²⁹ and R⁴⁰ are preferably H.

In more preferred embodiments the present invention is directed to compounds of formula 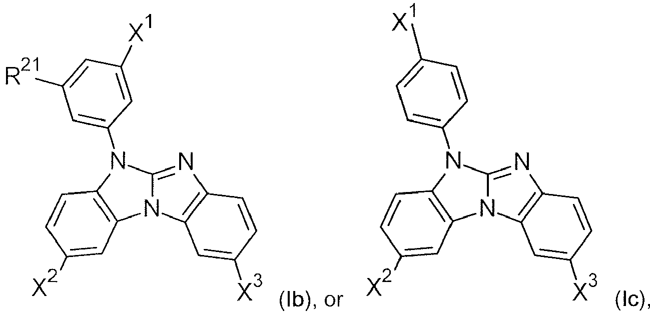 wherein
X¹ is H, a group of formula 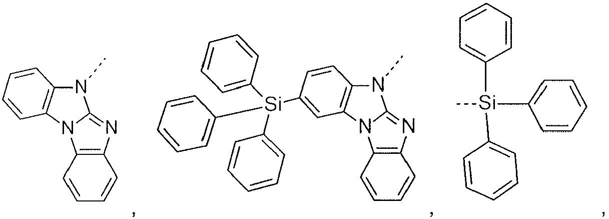 or 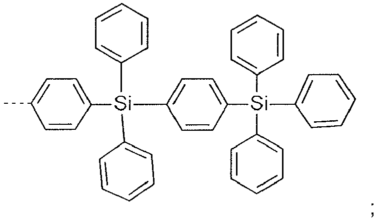
X² is H, a group of formula 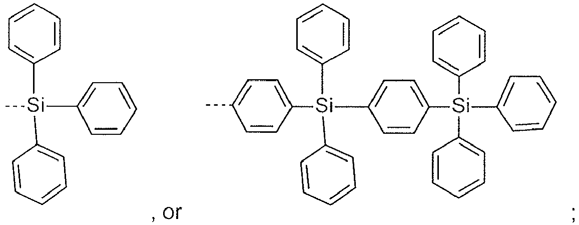
X³ is H, or a group of formula 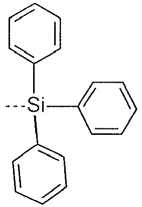 and
R²¹ is H, or a group of formula 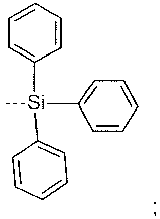 or
compounds of formula (Ib), or (Ic), wherein
X¹ is a group of formula 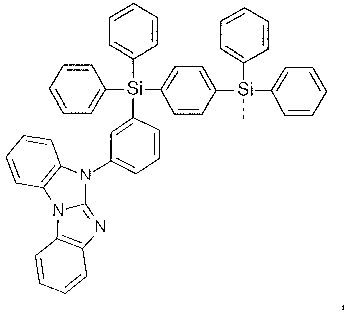 or 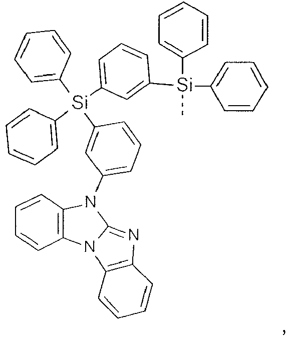 X² is H, X³ is H and R²¹ is H; or
compounds of formula (lb), or (Ic), wherein
X² is a group of formula 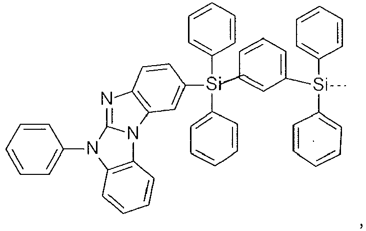 or 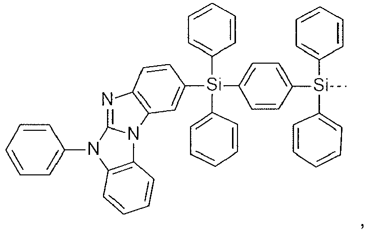 X¹ is H, X³ is H and R²¹ is H.

Compounds of formula (Ib), or (Ic) are even more preferred, wherein one of the groups X¹, X², or X³ is a group of formula 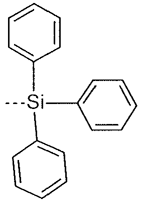 and the other two groups represent H.

In addition, compounds of formula (Ib), or (Ic) are even more preferred, wherein two of the groups X¹, X², or X³ are a group of formula 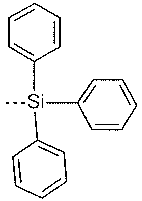 and the other group represent H.

In addition, compounds of formula (Ib), or (Ic) are even more preferred, wherein one of the groups X¹, X², or X³ is a group of formula 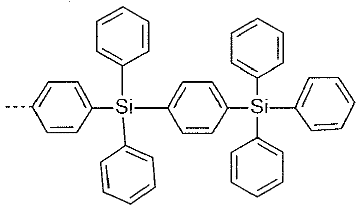 and the other two groups represent H.

Examples of particularly preferred compounds are shown below: 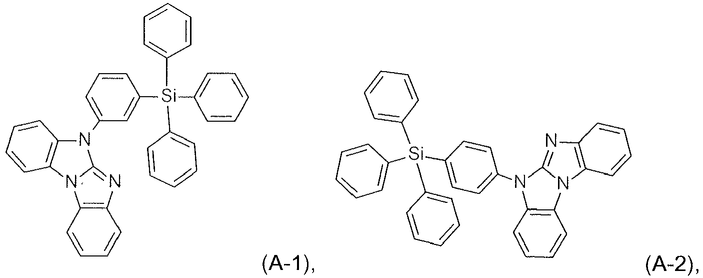 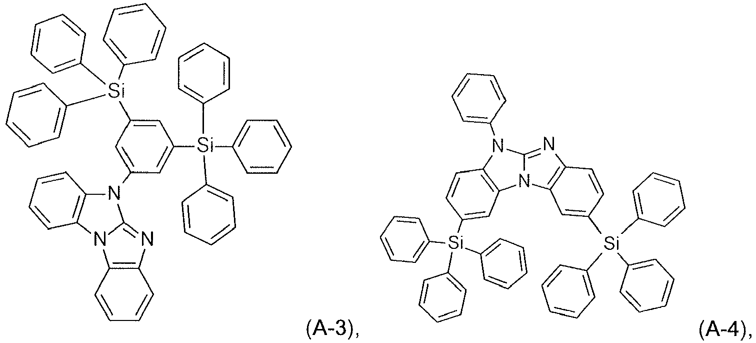 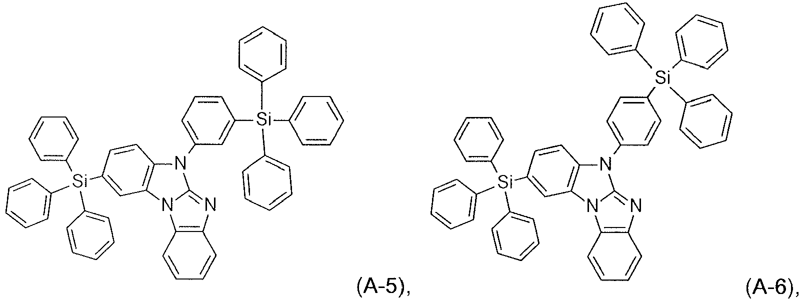 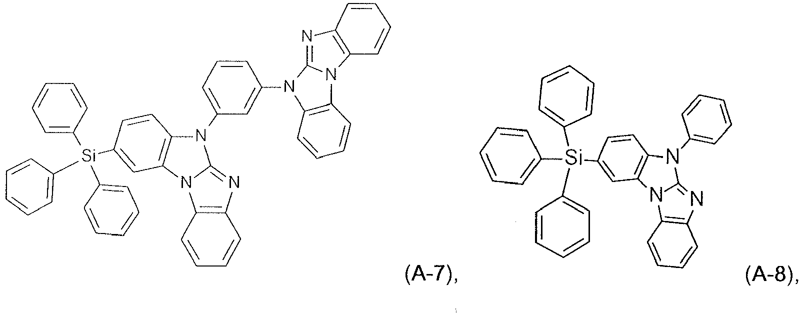 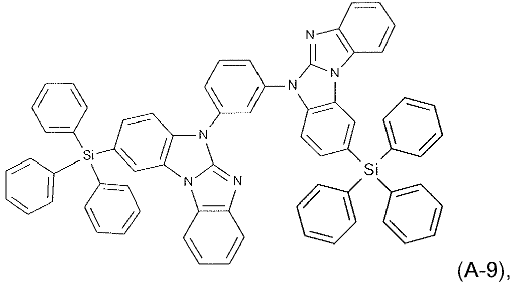 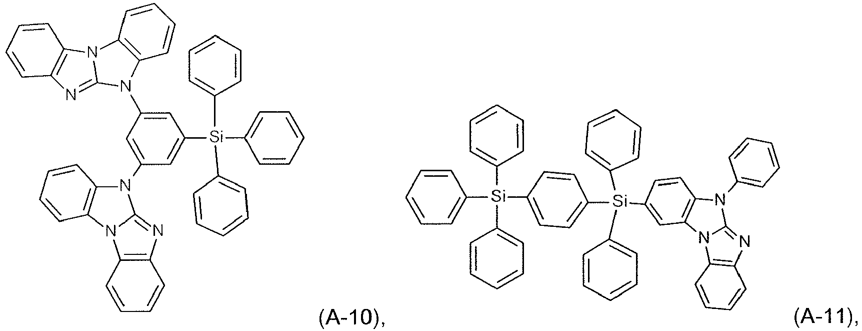 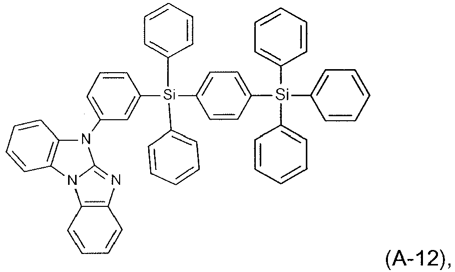 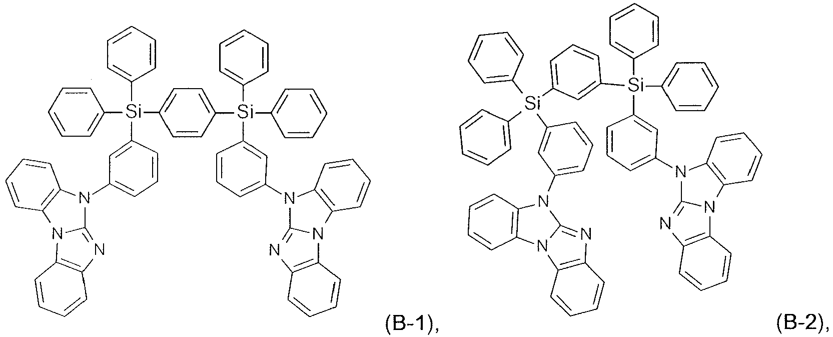 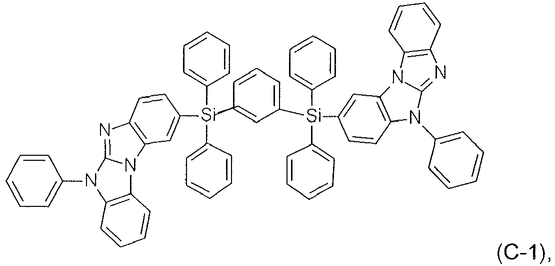 or

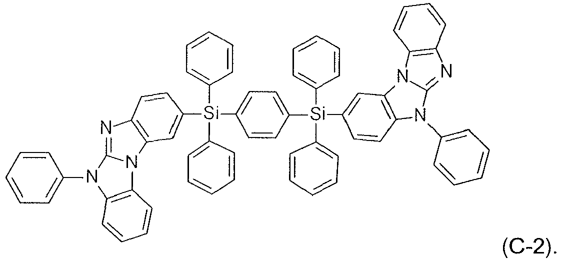

C₁-C₂₅alkyl (C₁-C₁₈alkyl) is typically linear or branched, where possible. Examples are methyl, ethyl, n-propyl, isopropyl, n-butyl, sec.-butyl, isobutyl, tert.-butyl, n-pentyl, 2-pentyl, 3-pentyl, 2,2-dimethylpropyl, 1,1,3,3-tetramethylpentyl, n-hexyl, 1-methylhexyl, 1,1,3,3,5,5-hexamethylhexyl, n-heptyl, isoheptyl, 1,1,3,3-tetramethylbutyl, 1-methylheptyl, 3-methylheptyl, n-octyl, 1,1,3,3-tetramethylbutyl and 2-ethylhexyl, n-nonyl, decyl, undecyl, dodecyl, tridecyl, tetradecyl, pentadecyl, hexadecyl, heptadecyl, or octadecyl.

C₁-C₁₈alkoxy groups are straight-chain or branched alkoxy groups, e.g. methoxy, ethoxy, n-propoxy, isopropoxy, n-butoxy, sec-butoxy, tert-butoxy, amyloxy, isoamyloxy or tert-amyloxy, heptyloxy, octyloxy, isooctyloxy, nonyloxy, decyloxy, undecyloxy, dodecyloxy, tetradecyloxy, pentadecyloxy, hexadecyloxy, heptadecyloxy and octadecyloxy. Examples of C₁-C₈alkoxy are methoxy, ethoxy, n-propoxy, isopropoxy, n-butoxy, sec.-butoxy, isobutoxy, tert.-butoxy, n-pentyloxy, 2-pentyloxy, 3-pentyloxy, 2,2-dimethylpropoxy, n-hexyloxy, n-heptyloxy, n-octyloxy, 1,1,3,3-tetramethylbutoxy and 2-ethylhexyloxy.

Examples of a "C₂-C₆heteroaryl" group are a imidazoyl group, a 4-(1,2,4-triazoyl) group and a 1-(1,2,4-triazolyl) group.

G is especially C₁-C₁₈alkyl, very especially C₁-C₈alkyl, such as methyl, ethyl, n-propyl, isopropyl, n-butyl, isobutyl, tert-butyl, sec-butyl, hexyl, octyl, or 2-ethyl-hexyl.

The wording "substituted by G" means that one, or more, especially one to three substituents G might be present. If a substituent occurs more than one time in a group, it can be different in each occurrence.

C₁-C₁₈alkyl interrupted by one or more units D is, for example, (CH₂CH₂O)₁₋₉-R^{x}, where R^{x} is H or C₁-C₁₀alkyl or C₂-C₁₀alkanoyl (e.g. CO-CH(C₂H₅)C₄H₉), CH₂-CH(OR^{y'})-CH₂-O-R^{y}, where R^{y} is C₁-C₁₈alkyl, C₅-C₁₂cycloalkyl, phenyl, C₇-C₁₅phenylalkyl, and R^{y'} embraces the same definitions as R^{y} or is H;

C₁-C₈alkylene-COO-R^{z}, e.g. CH₂COOR_{z}, CH(CH₃)COOR^{z}, C(CH₃)₂COOR^{z}, where R^{z} is H, C₁-C₁₈alkyl, (CH₂CH₂O)₁₋₉-R^{x}, and R^{x} embraces the definitions indicated above; CH₂CH₂-O-CO-CH=CH₂; CH₂CH(OH)CH₂-O-CO-C(CH₃)=CH₂.

The synthesis of 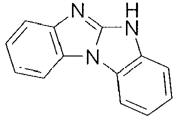 is described, for example, in Achour, Reddouane; Zniber, Rachid, Bulletin des Societes Chimiques Belges 96 (1987) 787-92.

For the nucleophilic substitution, diiodobenzoles may be used. The introduction of the group 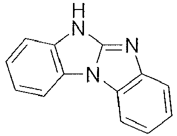 is performed in the presence of a base. Suitable bases are known to those skilled in the art and are preferably selected from the group consisting of alkali metal and alkaline earth metal hydroxides such as NaOH, KOH, Ca(OH)₂, alkali metal hydrides such as NaH, KH, alkali metal amides such as NaNH₂, alkali metal or alkaline earth metal carbonates such as K₂CO₃ or Cs₂CO₃, and alkali metal alkoxides such as Na-OMe, NaOEt. In addition, mixtures of the aforementioned bases are suitable. Particular preference is given to NaOH, KOH, NaH or K₂CO₃. Heteroarylation can be effected, for example, by copper-catalyzed coupling of 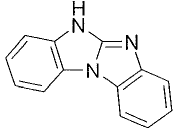 to a halogenated compound of the formula 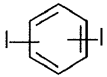 (Ullmann reaction).

The N-arylation was, for example, disclosed in H. Gilman and D. A. Shirley, J. Am. Chem. Soc. 66 (1944) 888; D. Li et al., Dyes and Pigments 49 (2001) 181 - 186 and Eur. J. Org. Chem. (2007) 2147-2151. The reaction can be performed in solvent or in a melt. Suitable solvents are, for example, (polar) aprotic solvents such as dimethyl sulfoxide, dimethylformamide, NMP, tridecane or alcohols.

The bromination of 5-phenylbenzimidazolo[1,2-a]benzimidazole can be carried out in analogy to the bromination of carbazole, which is, for example, described in J. Mater. Chem. 18 (2008) 1296-1301.

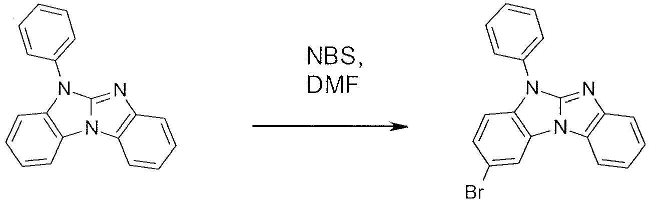

Other bromination methods are, for example, described in Helvetica Chimica Acta 89 (2006) 1123 and SYNLETT 17 (2006) 2841-2845. 10.206

The iodination of 5-phenylbenzimidazolo[1,2-a]benzimidazole can be done as described in example 4 of WO2014009317:

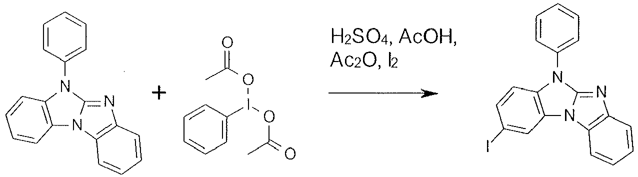

The halogen/metal exchange is done with nBuLi/THF at -78°C, or tBuLi/THF at -78°C. Reference is made to WO2010/079051, WO2011073149, Chemical Communications 2013, 49(64), 7108-7110, J. Org. Chem.; 1962, 27, 1418-1422; J. Org. Chem.; 1961, 26, 2013-2014.

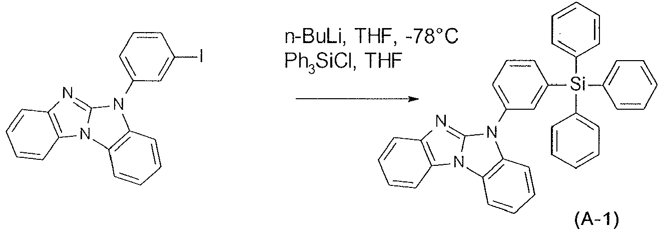

A possible synthetic route for compound (A-1) is shown in the reaction scheme below:

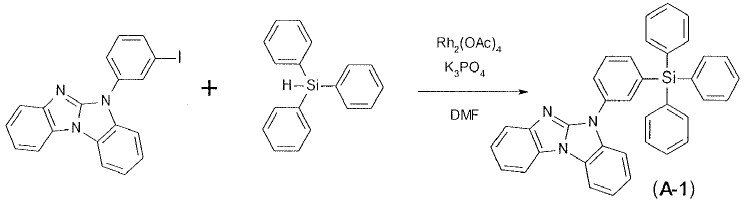

The synthesis of (4-diphenylsilylphenyl)-diphenyl-silane is described in J. Polymer Science: part A, 1964, 2, 15-19.

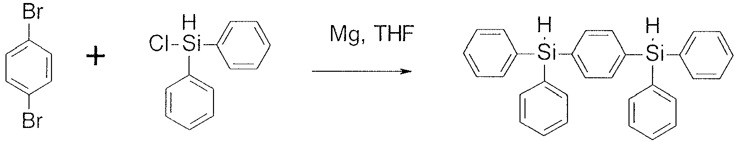

(4-Diphenylsilylphenyl)-diphenyl-silane can be prepated in in analogy to (4-diphenylsilylphenyl)-diphenyl-silane starting from 1,3-dibromobenzene and chloro(diphenyl)silane.

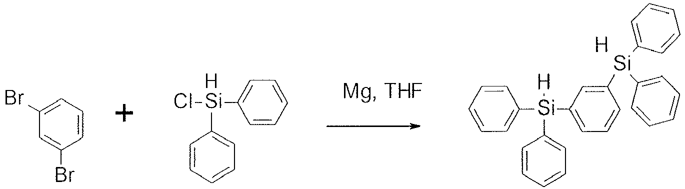

[3-(Benzimidazolo[1,2-a]benzimidazol-5-yl)phenyl]-[4-[[3-(benzimidazolo[1,2-a]benzimidazol-5-yl)phenyl]-diphenyl-silyl]phenyl]-diphenyl-silane (B-1) can be prepared as described in the following scheme.

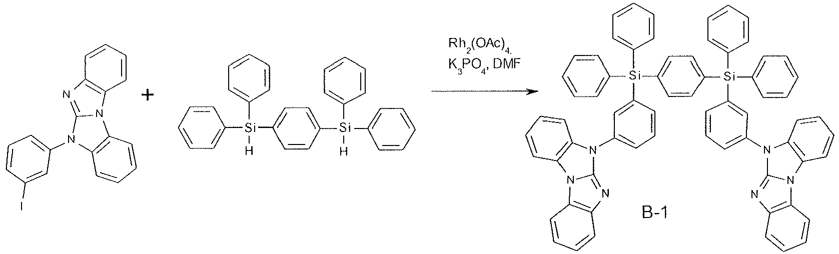

[4-[Diphenyl-(5-phenylbenzimidazolo[1,2-a]benzimidazol-2-yl)silyl]phenyl]-diphenyl-(6-phenylbenzimidazolo[1,2-a]benzimidazol-2-yl)silane (C-2) can be prepared as described in the following scheme.

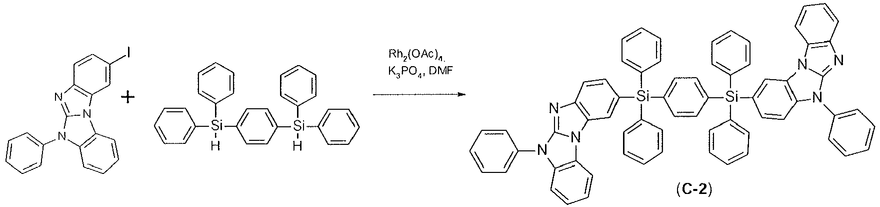

It has been found that the compounds of the formula I are particularly suitable for use in applications in which charge carrier conductivity is required, especially for use in organic electronics applications, for example selected from switching elements such as organic transistors, e.g. organic FETs and organic TFTs, organic solar cells and organic light-emitting diodes (OLEDs), the compounds of the formula I being particularly suitable in OLEDs for use as host material in a light-emitting layer and/or as electron and/or exciton blocker material and/or as hole transport material, especially in combination with a phosphorescence emitter, very especially blue, or green emitting phosphorescence emitters. In the case of use of the inventive compounds of the formula I in OLEDs, OLEDs which have good efficiencies and a long lifetime and which can be operated especially at a low use and operating voltage are obtained. Furthermore, the compounds of the formula I can be used as conductor/complementary materials in organic electronics applications selected from switching elements and organic solar cells.

In the emission layer or one of the emission layers of an OLED, it is also possible to combine an emitter material with a matrix material of the compound of the formula I and a further matrix material which has, for example, a good elctron transport property. This achieves a high quantum efficiency of this emission layer.

Suitable structures of organic electronic devices are known to those skilled in the art and are specified below.

The organic transistor generally includes a semiconductor layer formed from an organic layer with hole transport capacity and/or electron transport capacity; a gate electrode formed from a conductive layer; and an insulating layer introduced between the semiconductor layer and the conductive layer. A source electrode and a drain electrode are mounted on this arrangement in order thus to produce the transistor element. In addition, further layers known to those skilled in the art may be present in the organic transistor.

The organic solar cell (photoelectric conversion element) generally comprises an organic layer present between two plate-type electrodes arranged in parallel. The organic layer may be configured on a comb-type electrode. There is no particular restriction regarding the site of the organic layer and there is no particular restriction regarding the material of the electrodes. When, however, plate-type electrodes arranged in parallel are used, at least one electrode is preferably formed from a transparent electrode, for example an ITO electrode or a fluorine-doped tin oxide electrode. The organic layer is formed from two sublayers, i.e. a layer with p-type semiconductor properties or hole transport capacity, and a layer formed with n-type semiconductor properties or electron transport capacity. In addition, it is possible for further layers known to those skilled in the art to be present in the organic solar cell. The layer with hole transport capacity may comprise the compounds of formula I.

### Structure of the inventive OLED

The inventive organic light-emitting diode (OLED) generally has the following structure: an anode (a) and a cathode (i) and a light-emitting layer (e) arranged between the anode (a) and the cathode (i).

The inventive OLED may, for example - in a preferred embodiment - be formed from the following layers:
1. Anode (a)
2. Hole transport layer (c)
3. Light-emitting layer (e)
4. Blocking layer for holes/excitons (f)
5. Electron transport layer (g)
6. Cathode (i)

Layer sequences different than the aforementioned structure are also possible, and are known to those skilled in the art. For example, it is possible that the OLED does not have all of the layers mentioned; for example, an OLED with layers (a) (anode), (e) (light-emitting layer) and (i) (cathode) is likewise suitable, in which case the functions of the layers (c) (hole transport layer) and (f) (blocking layer for holes/excitons) and (g) (electron transport layer) are assumed by the adjacent layers. OLEDs which have layers (a), (c), (e) and (i), or layers (a), (e), (f), (g) and (i), are likewise suitable. In addition, the OLEDs may have a blocking layer for electrons/excitons (d) between the hole transport layer (c) and the Light-emitting layer (e).

It is additionally possible that a plurality of the aforementioned functions (electron/exciton blocker, hole/exciton blocker, hole injection, hole conduction, electron injection, electron conduction) are combined in one layer and are assumed, for example, by a single material present in this layer. For example, a material used in the hole transport layer, in one embodiment, may simultaneously block excitons and/or electrons.

Furthermore, the individual layers of the OLED among those specified above may in turn be formed from two or more layers. For example, the hole transport layer may be formed from a layer into which holes are injected from the electrode, and a layer which transports the holes away from the hole-injecting layer into the light-emitting layer. The electron transport layer may likewise consist of a plurality of layers, for example a layer in which electrons are injected by the electrode, and a layer which receives electrons from the electron injection layer and transports them into the light-emitting layer. These layers mentioned are each selected according to factors such as energy level, thermal resistance and charge carrier mobility, and also energy difference of the layers specified with the organic layers or the metal electrodes. The person skilled in the art is capable of selecting the structure of the OLEDs such that it is matched optimally to the organic compounds used in accordance with the invention.

In a preferred embodiment the OLED according to the present invention comprises in this order:
(a) an anode,
(b) optionally a hole injection layer,
(c) optionally a hole transport layer,
(d) optionally an electron/exciton blocking layer
(e) an emitting layer,
(f) optionally a hole/ exciton blocking layer
(g) optionally an electron transport layer,
(h) optionally an electron injection layer, and
(i) a cathode.

In a particularly preferred embodiment the OLED according to the present invention comprises in this order:
(a) an anode,
(b) optionally a hole injection layer,
(c) a hole transport layer,
(d) an electron/exciton blocking layer
(e) an emitting layer,
(f) a hole/ exciton blocking layer
(g) an electron transport layer, and
(h) optionally an electron injection layer, and
(i) a cathode.

The properties and functions of these various layers, as well as example materials are known from the prior art and are described in more detail below on basis of preferred embodiments.

### Anode (a):

The anode is an electrode which provides positive charge carriers. It may be composed, for example, of materials which comprise a metal, a mixture of different metals, a metal alloy, a metal oxide or a mixture of different metal oxides. Alternatively, the anode may be a conductive polymer. Suitable metals comprise the metals of groups 11, 4, 5 and 6 of the Periodic Table of the Elements, and also the transition metals of groups 8 to 10. When the anode is to be transparent, mixed metal oxides of groups 12, 13 and 14 of the Periodic Table of the Elements are generally used, for example indium tin oxide (ITO). It is likewise possible that the anode (a) comprises an organic material, for example polyaniline, as described, for example, in Nature, Vol. 357, pages 477 to 479 (June 11, 1992). Preferred anode materials include conductive metal oxides, such as indium tin oxide (ITO) and indium zinc oxide (IZO), aluminum zinc oxide (AlZnO), and metals. Anode (and substrate) may be sufficiently transparent to create a bottom-emitting device. A preferred transparent substrate and anode combination is commercially available ITO (anode) deposited on glass or plastic (substrate). A reflective anode may be preferred for some top-emitting devices, to increase the amount of light emitted from the top of the device. At least either the anode or the cathode should be at least partly transparent in order to be able to emit the light formed. Other anode materials and structures may be used.

### Hole injection layer (b):

Generally, injection layers are comprised of a material that may improve the injection of charge carriers from one layer, such as an electrode or a charge generating layer, into an adjacent organic layer. Injection layers may also perform a charge transport function. The hole injection layer may be any layer that improves the injection of holes from anode into an adjacent organic layer. A hole injection layer may comprise a solution deposited material, such as a spin-coated polymer, or it may be a vapor deposited small molecule material, such as, for example, CuPc, MTDATA, , or dipyrazino[2,3-f:2',3'-h]quinoxaline-2,3,6,7,10,11-hexacarbonitrile (HAT-CN). Polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS. Preferred examples of a material of the hole injecting layer are a porphyrin compound, an aromatic tertiary amine compound, or a styrylamine compound. Particularly preferable examples include an aromatic tertiary amine compound such as hexacyanohexaazatriphenylene (HAT).

### Hole transport layer (c):

Either hole-transporting molecules or polymers may be used as the hole transport material. Suitable hole transport materials for layer (c) of the inventive OLED are disclosed, for example, in Kirk-Othmer Encyclopedia of Chemical Technology, 4th Edition, Vol. 18, pages 837 to 860, 1996, US20070278938, US2008/0106190, US2011/0163302 (triarylamines with (di)benzothiophen/(di)benzofuran; Nan-Xing Hu et al. Synth. Met. 111 (2000) 421 (indolocarbazoles), WO2010002850 (substituted phenylamine compounds) and WO2012/16601 (in particular the hole transport materials mentioned on pages 16 and 17 of WO2012/16601). Combination of different hole transport material may be used. Reference is made, for example, to WO2013/022419, wherein 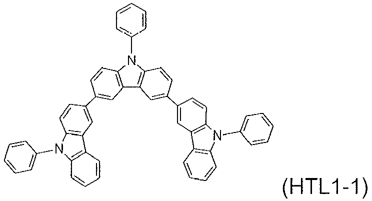 and 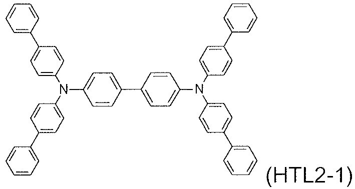 constitute the hole transport layer. Customarily used hole-transporting molecules are selected from the group consisting of 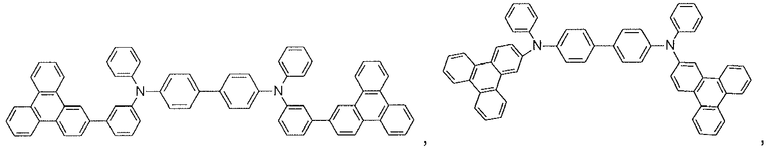 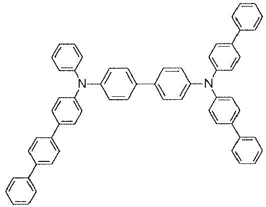 (4-phenyl-N-(4-phenylphenyl)-N-[4-[4-(N-[4-(4-phenyl-phenyl)phenyl]anilino)phenyl]phenyl]aniline), 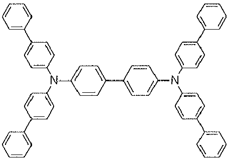 (4-phenyl-N-(4-phenylphenyl)-N-[4-[4-(4-phenyl-N-(4-phenylphenyl)anilino)phenyl]phenyl]aniline), 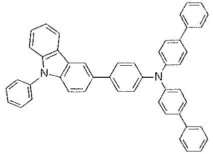 (4-phenyl-N-[4-(9-phenylcarbazol-3-yl)phenyl]-N-(4-phenylphenyl)aniline), 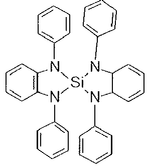 (1,1',3,3'-tetraphenylspiro[1,3,2-benzodiazasilole-2,2'-3a,7a-dihydro-1,3,2-benzodiazasilole]), 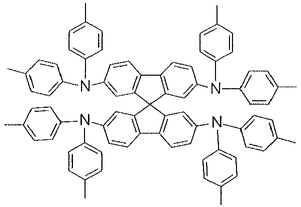 (N2,N2,N2',N2',N7,N7,N7',N7'-octakis(p-tolyl)-9,9'-spirobi[fluorene]-2,2',7,7'-tetramine),4,4'-bis[N-(1-naphthyl)-N-phenylamino]biphenyl (α-NPD), N,N'-diphenyl-N,N'-bis(3-methylphenyl)-[1,1'-biphenyl]-4,4'-diamine (TPD), 1,1-bis[(di-4-tolylamino)phenyl]-cyclohexane (TAPC), N,N'-bis(4-methylphenyl)-N,N'-bis(4-ethylphenyl)-[1,1'-(3,3'-dimethyl)-biphenyl]-4,4'-diamine (ETPD), tetrakis(3-methylphenyl)-N,N,N',N'-2,5-phenylenediamine (PDA), α-phenyl-4-N,N-diphenylaminostyrene (TPS), p-(diethylamino)benzaldehyde diphenylhydrazone (DEH), triphenylamine (TPA), bis[4-(N,N-diethylamino)2-methylphenyl](4-methylphenyl)methane (MPMP), 1-phenyl-3-[p-(diethylamino)styryl]5-[p-(diethylamino)phenyl]pyrazoline (PPR or DEASP), 1,2-trans-bis(9H-carbazol9-yl)-cyclobutane (DCZB), N,N,N',N'-tetrakis(4-methylphenyl)-(1,1'-biphenyl)-4,4'-diamine (TTB), fluorine compounds such as 2,2',7,7'-tetra(N,N-di-tolyl)amino9,9-spirobifluorene (spiro-TTB), N,N'-bis(naphthalen-1-yl)-N,N'-bis(phenyl)9,9-spirobifluorene (spiro-NPB) and 9,9-bis(4-(N,N-bis-biphenyl-4-yl-amino)phenyl-9Hfluorene, benzidine compounds such as N,N'-bis(naphthalen-1-yl)-N,N'-bis(phenyl)benzidine and porphyrin compounds such as copper phthalocyanines. In addition, polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PE-DOT/PSS. In addition, dibenzofurane and dibenzothiophene compounds mentioned as host below, such as, for example, 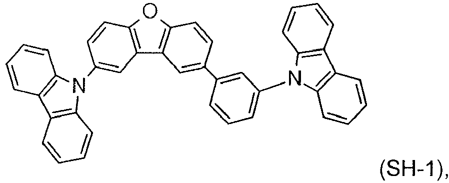 may be used as hole transport material and exciton blocker material.

In a preferred embodiment it is possible to use metal carbene complexes as hole transport materials. Suitable carbene complexes are, for example, carbene complexes as described in WO2005/019373A2, WO2006/056418 A2, WO2005/113704, WO2007/115970, WO2007/115981, WO2008/000727 and WO2014147134. One example of a suitable carbene complex is Ir(DPBIC)₃ with the formula: 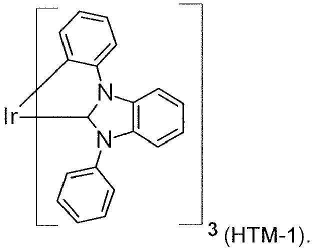 Another example of a suitable carbene complex is Ir(ABIC)₃ with the
Ia:

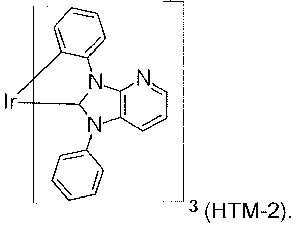

In another preferred embodiment compounds of formula (I), especially (Ia), (Ib) and (Ic), very especially compounds (A-1) to (A-12), (B-1), (B-2), (C-1) and (C-2) are used as hole transport material.

The hole-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, 2003, 359 (p-doped organic layers); A. G. Werner, F. Li, K. Harada, M. Pfeiffer, T. Fritz, K. Leo, Appl. Phys. Lett., Vol. 82, No. 25, 2003, 4495 and Pfeiffer et al., Organic Electronics 2003, 4, 89 - 103 and K. Walzer, B. Maennig, M. Pfeiffer, K. Leo, Chem. Soc. Rev. 2007, 107, 1233. For example it is possible to use mixtures in the hole-transporting layer, in particular mixtures which lead to electrical p-doping of the hole-transporting layer. p-Doping is achieved by the addition of oxidizing materials. These mixtures may, for example, be the following mixtures: mixtures of the abovementioned hole transport materials with at least one metal oxide, for example MoO₂, MoO₃, WOₓ, ReO₃ and/or V₂O₅, preferably MoO₃ and/or ReO₃, or mixtures comprising the aforementioned hole transport materials and one or more compounds selected from 7,7,8,8-tetracyanoquinodimethane (TCNQ), 2,3,5,6-tetrafluoro-7,7,8,8-tetracyanoquinodimethane (F₄-TCNQ), 2,5-bis(2-hydroxyethoxy)-7,7,8,8-tetracyanoquinodimethane, bis(tetra-n-butylammonium)tetracyanodiphenoquinodimethane, 2,5-dimethyl-7,7,8,8-tetracyanoquinodimethane, tetracyanoethylene, 11,11,12,12-tetracyanonaphtho2,6-quinodimethane, 2-fluoro-7,7,8,8-tetracyanoquino-dimethane, 2,5-difluoro-7,7,8,8etracyanoquinodimethane, dicyanomethylene-1,3,4,5,7,8-hexafluoro-6H-naphthalen-2-ylidene)malononitrile (F₆-TNAP), Mo(tfd)₃ (from Kahn et al., J. Am. Chem. Soc. 2009, 131 (35), 12530-12531), compounds as described in EP1988587, US2008265216, EP2180029, US20100102709, WO2010132236, EP2180029 and quinone compounds as mentioned in EP2401254. Preferred mixtures comprise the aforementioned carbene complexes, such as, for example, the carbene complexes HTM-1 and HTM-2, and MoO₃ and/or ReO₃. In a particularly preferred embodiment the hole transport layer comprises from 0.1 to 10 wt % of MoO₃ and 90 to 99.9 wt % carbene complex, especially of a carbene complex HTM-1 and HTM-2, wherein the total amount of the MoO₃ and the carbene complex is 100 wt %. In another particularly preferred embodiment the hole transport layer comprises from 0.1 to 10 wt % of MoO₃ and 90 to 99.9 wt % dibenzofurane compound, especially compound (SH-1), wherein the total amount of the MoO₃ and the carbene complex is 100 wt %.

### Exciton blocking layer (d):

Blocking layers may be used to reduce the number of charge carriers (electrons or holes) and/or excitons that leave the emissive layer. An electron/exciton blocking layer (d) may be disposed between the first emitting layer (e) and the hole transport layer (c), to block electrons from emitting layer (e) in the direction of hole transport layer (c). Blocking layers may also be used to block excitons from diffusing out of the emissive layer. Suitable metal complexes for use as electron/exciton blocker material are, for example, carbene complexes as described in WO2005/019373A2, WO2006/056418A2, WO2005/113704, WO2007/115970, WO2007/115981, WO2008/000727 and WO2014147134. Explicit reference is made here to the disclosure of the WO applications cited, and these disclosures shall be considered to be incorporated into the content of the present application. One example of a suitable carbene complex is compound HTM-1. Another example of a suitable carbene complex is compound HTM-2. In addition, all hole transport materials having sufficient high triplet energy are suitable exciton blocking materials. Additional examples of hole transporting materials having sufficient high triplet energy are (SH-1) and (SH-11).

In another preferred embodiment compounds of formula (I), especially (Ia), (Ib) and (Ic), very especially compounds (A-1) to (A-12), (B-1), (B-2), (C-1) and (C-2) are used as electron/exciton blocking material.

### Emitting layer (e)

The light-emitting layer (e) comprises at least one emitter material. In principle, it may be a fluorescence or phosphorescence emitter, suitable emitter materials being known to those skilled in the art. The at least one emitter material is preferably a phosphorescence emitter. The phosphorescence emitter compounds used with preference are based on metal complexes, and especially the complexes of the metals Ru, Rh, Ir, Pd and Pt, in particular the complexes of Ir, have gained significance. The compounds of the formula I can be used as the matrix in the light-emitting layer.

Suitable metal complexes for use in the inventive OLEDs are described, for example, in documents WO 02/60910 A1, US 2001/0015432 A1, US 2001/0019782 A1, US 2002/0055014 A1, US 2002/0024293 A1, US 2002/0048689 A1, EP 1 191 612 A2, EP 1 191 613 A2, EP 1 211 257 A2, US 2002/0094453 A1, WO 02/02714 A2, WO 00/70655 A2, WO 01/41512 A1, WO 02/15645 A1, WO 2005/019373 A2, WO 2005/113704 A2, WO 2006/115301 A1, WO 2006/067074 A1, WO 2006/056418, WO 2006121811 A1, WO 2007095118 A2, WO 2007/115970, WO 2007/115981, WO 2008/000727, WO2010129323, WO2010056669, WO10086089, US2011/0057559, WO2011/106344, US2011/0233528, WO2012/048266, WO2012/172482, WO2015000955 and PCT/EP2014/066272.

Further suitable metal complexes are the commercially available metal complexes tris(2-phenylpyridine)iridium(III), iridium(III) tris(2-(4-tolyl)pyridinato-N,C^{2'}), bis(2-phenylpyridine)(acetylacetonato)iridium(III), iridium(III) tris(1-phenylisoquinoline), iridium(III) bis(2,2'-benzothienyl)pyridinato-N,C^{3'})(acetylacetonate), tris(2-phenylquinoline)iridium(III), iridium(III) bis(2-(4,6-difluorophenyl)pyridinato-N,C²)picolinate, iridium(III) bis(1-phenylisoquinoline)(acetylacetonate), bis(2-phenylquinoline)(acetylacetonato)iridium(III), iridium(III) bis(di-benzo[f,h]quinoxaline)(acetylacetonate), iridium(III) bis(2-methyldibenzo[f,h]quinoxaline)(acetylacetonate) and tris(3-methyl-1-phenyl-4-trimethylacetyl-5-pyrazolino)terbium(III), bis[1-(9,9-dimethyl-9H-fluoren-2-yl)isoquinoline](acetyl-acetonato)iridium(III), bis(2-phenylbenzothiazolato)(acetylacetonato)iridium(III), bis(2-(9,9-dihexylfluorenyl)-1-pyridine)(acetylacetonato)iridium(III), bis(2-benzo[b]thiophen-2-yl-pyridine)(acetylacetonato)iridium(III).

In addition, the following commercially available materials are suitable: tris(dibenzoylacetonato)mono(phenanthroline)europium(III), tris(dibenzoylmethane)-mono(phenanthroline)europium(III), tris(dibenzoylmethane)mono(5-aminophenanthroline)-europium(III), tris(di-2-naphthoylmethane)mono(phenanthroline)europium(III), tris(4-bromobenzoylmethane)mono(phenanthroline)europium(III), tris(di(biphenyl)methane)-mono(phenanthroline)europium(III), tris(dibenzoylmethane)mono(4,7-diphenylphenanthroline)europium(III), tris(dibenzoylmethane)mono(4,7-di-methylphenanthroline)europium(III), tris(dibenzoylmethane)mono(4,7-dimethylphenanthrolinedisulfonic acid)europium(III) disodium salt, tris[di(4-(2-(2-ethoxyethoxy)ethoxy)-benzoylmethane)]mono(phenanthroline)europium(III) and tris[di[4-(2-(2-ethoxyethoxy)ethoxy)benzoylmethane)]mono(5-aminophenanthroline)europium(III), osmium(II) bis(3-(trifluoromethyl)-5-(4-tert-butylpyridyl)-1,2,4-triazolato)diphenylmethylphosphine, osmium(II) bis(3-(trifluoromethyl)-5-(2-pyridyl)-1,2,4-triazole)dimethylphenylphosphine, osmium(II) bis(3-(trifluoromethyl)-5-(4-tert-butylpyridyl)-1,2,4-triazolato)dimethylphenylphosphine, osmium(II) bis(3-(trifluoromethyl)-5-(2-pyridyl)-pyrazolato)dimethylphenylphosphine, tris[4,4'-di-tert-butyl(2,2')-bipyridine]ruthenium(III), osmium(II) bis(2-(9,9-dibutylfluorenyl)-1-isoquinoline(acetylacetonate).

Preferred phosphorescence emitters are carbine complexes. Suitable phosphorescent blue emitters are specified in the following publications: WO2006/056418A2, WO2005/113704, WO2007/115970, WO2007/115981, WO2008/000727, WO2009050281, WO2009050290, WO2011051404, US2011/057559 WO2011/073149, WO2012/121936A2, US2012/0305894A1, WO2012/170571, WO2012/170461, WO2012/170463, WO2006/121811, WO2007/095118, WO2008/156879, WO2008/156879, WO2010/068876, US2011/0057559, WO2011/106344, US2011/0233528, WO2012/048266, WO2012/172482, WO2015000955 and PCT/EP2014/066272.

Preferably, the light emitting layer (e) comprises at least one carbine complex as phosphorescence emitter. Suitable carbine complexes are, for example, compounds of the formula 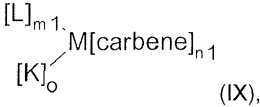 which are described in WO 2005/019373 A2, wherein the symbols have the following meanings:
M is a metal atom selected from the group consisting of Co, Rh, Ir, Nb, Pd, Pt, Fe, Ru, Os, Cr, Mo, W, Mn, Tc, Re, Cu, Ag and Au in any oxidation state possible for the respective metal atom;
Carbene is a carbene ligand which may be uncharged or monoanionic and monodentate, bidentate or tridentate, with the carbene ligand also being able to be a biscarbene or triscarbene ligand;
L is a monoanionic or dianionic ligand, which may be monodentate or bidentate;
K is an uncharged monodentate or bidentate ligand selected from the group consisting of phosphines; phosphonates and derivatives thereof, arsenates and derivatives thereof; phosphites; CO; pyridines; nitriles and conjugated dienes which form a π complex with M¹;
n1 is the number of carbene ligands, where n1 is at least 1 and when n1 > 1 the carbene ligands in the complex of the formula I can be identical or different;
m1 is the number of ligands L, where m1 can be 0 or ≥ 1 and when m1 > 1 the ligands L can be identical or different;
o is the number of ligands K, where o can be 0 or ≥ 1 and when o > 1 the ligands K can be identical or different;
where the sum n1 + m1 + o is dependent on the oxidation state and coordination number of the metal atom and on the denticity of the ligands carbene, L and K and also on the charge on the ligands, carbene and L, with the proviso that n1 is at least 1.

More preferred are metal-carbene complexes of the general formula 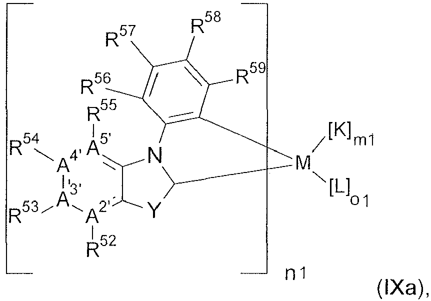 which are described in WO2011/073149, where M, n1, Y, A^{2'}, A^{3'}, A^{4'}, A^{5'}, R⁵¹, R⁵², R⁵³, R⁵⁴, R⁵⁵, R⁵⁶, R⁵⁷, R⁵⁸, R⁵⁹, K, L, m1 and o1 are each defined as follows:
M is Ir, or Pt,
n1 is an integer selected from 1, 2 and 3,
Y is NR⁵¹, O, S or C(R²⁵)₂,
A^{2'}, A^{3'}, A^{4'}, and A^{5'} are each independently N or C, where 2 A' = nitrogen atoms and at least one carbon atom is present between two nitrogen atoms in the ring,
R⁵¹ is a linear or branched alkyl radical optionally interrupted by at least one heteroatom, optionally bearing at least one functional group and having 1 to 20 carbon atoms, cycloalkyl radical optionally interrupted by at least one heteroatom, optionally bearing at least one functional group and having 3 to 20 carbon atoms, substituted or unsubstituted aryl radical optionally interrupted by at least one heteroatom, optionally bearing at least one functional group and having 6 to 30 carbon atoms, substituted or unsubstituted heteroaryl radical optionally interrupted by at least one heteroatom, optionally bearing at least one functional group and having a total of 5 to 18 carbon atoms and/or heteroatoms,
R⁵², R⁵³, R⁵⁴ and R⁵⁵ are each, if A^{2'}, A^{3'}, A^{4'} and/or A^{5'} is N, a free electron pair, or, if A^{2'}, A^{3'}, A^{4'} and/or A^{5'} is C, each independently hydrogen, linear or branched alkyl radical optionally interrupted by at least one heteroatom, optionally bearing at least one functional group and having 1 to 20 carbon atoms, cycloalkyl radical optionally interrupted by at least one heteroatom, optionally bearing at least one functional group and having 3 to 20 carbon atoms, substituted or unsubstituted aryl radical optionally interrupted by at least one heteroatom, optionally bearing at least one functional group and having 6 to 30 carbon atoms, substituted or unsubstituted heteroaryl radical optionally interrupted by at least one heteroatom, optionally bearing at least one functional group and having a total of 5 to 18 carbon atoms and/or heteroatoms, group with donor or acceptor action, or R⁵³ and R⁵⁴ together with A^{3'} and A^{4'} form an optionally substituted, unsaturated ring optionally interrupted by at least one further heteroatom and having a total of 5 to 18 carbon atoms and/or heteroatoms,
R⁵⁶, R⁵⁷, R⁵⁸ and R⁵⁹ are each independently hydrogen, linear or branched alkyl radical optionally interrupted by at least one heteroatom, optionally bearing at least one functional group and having 1 to 20 carbon atoms, cycloalkyl radical optionally interrupted by at least one heteroatom, optionally bearing at least one functional group and having 3 to 20 carbon atoms, cycloheteroalkyl radical optionally interrupted by at least one heteroatom, optionally bearing at least one functional group and having 3 to 20 carbon atoms, substituted or unsubstituted aryl radical optionally interrupted by at least one heteroatom, optionally bearing at least one functional group and having 6 to 30 carbon atoms, substituted or unsubstituted heteroaryl radical optionally interrupted by at least one heteroatom, optionally bearing at least one functional group and having a total of 5 to 18 carbon atoms and/or heteroatoms, group with donor or acceptor action, or
R⁵⁶ and R⁵⁷, R⁵⁷ and R⁵⁸ or R⁵⁸ and R⁵⁹, together with the carbon atoms to which they are bonded, form a saturated, unsaturated or aromatic, optionally substituted ring optionally interrupted by at least one heteroatom and having a total of 5 to 18 carbon atoms and/or heteroatoms, and/or
if A^{5'} is C, R⁵⁵ and R⁵⁶ together form a saturated or unsaturated, linear or branched bridge optionally comprising heteroatoms, an aromatic unit, heteroaromatic unit and/or functional groups and having a total of 1 to 30 carbon atoms and/or heteroatoms, to which is optionally fused a substituted or unsubstituted, five- to eight-membered ring comprising carbon atoms and/or heteroatoms,
R²⁵ is independently a linear or branched alkyl radical optionally interrupted by at least one heteroatom, optionally bearing at least one functional group and having 1 to 20 carbon atoms, cycloalkyl radical optionally interrupted by at least one heteroatom, optionally bearing at least one functional group and having 3 to 20 carbon atoms, substituted or unsubstituted aryl radical optionally interrupted by at least one heteroatom, optionally bearing at least one functional group and having 6 to 30 carbon atoms, substituted or unsubstituted heteroaryl radical optionally interrupted by at least one heteroatom, optionally bearing at least one functional group and having a total of 5 to 18 carbon atoms and/or heteroatoms,
K is an uncharged mono- or bidentate ligand,
L is a mono- or dianionic ligand, preferably monoanionic ligand, which may be mono- or bidentate,
m1 is 0, 1 or 2, where, when m1 is 2, the K ligands may be the same or different,
o1 is 0, 1 or 2, where, when o1 is 2, the L ligands may be the same or different.

The compound of formula IX is preferably a compound of the formula:

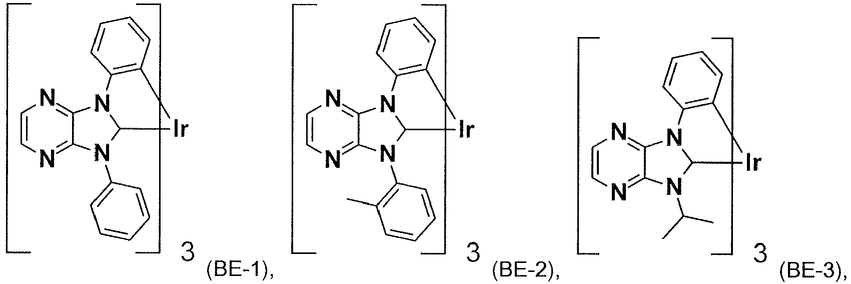

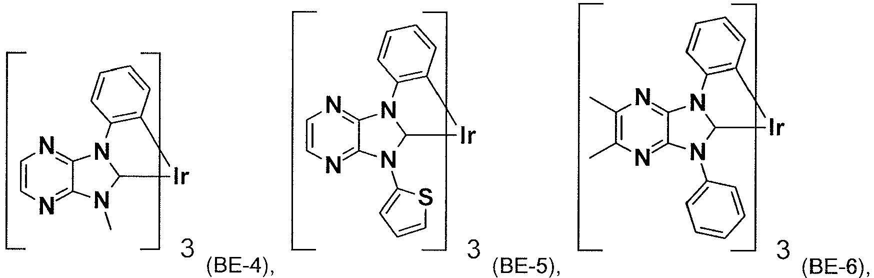

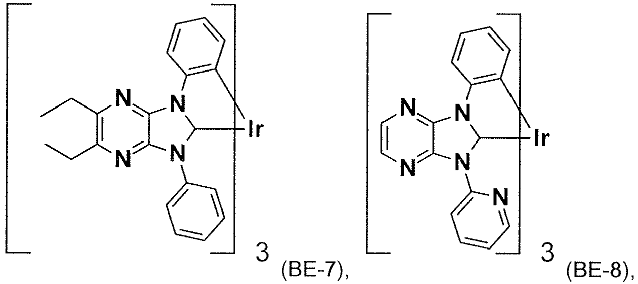

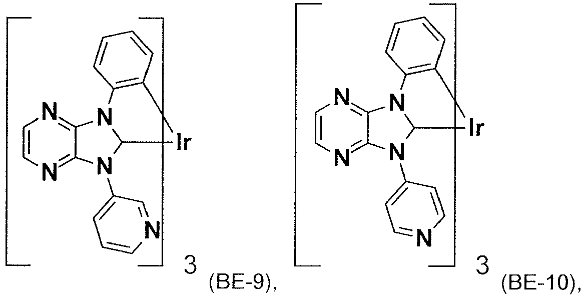

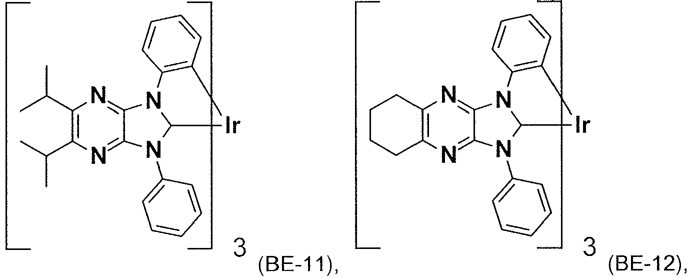

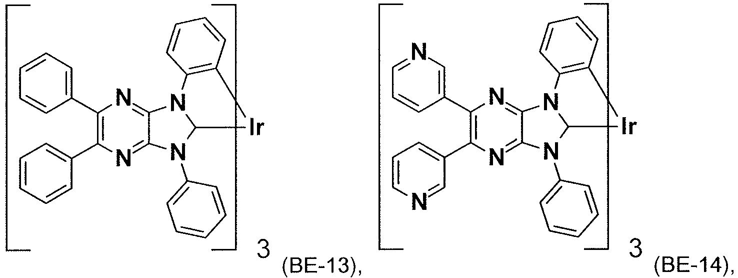

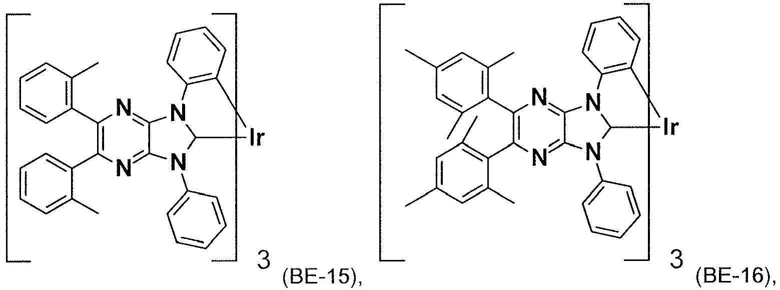

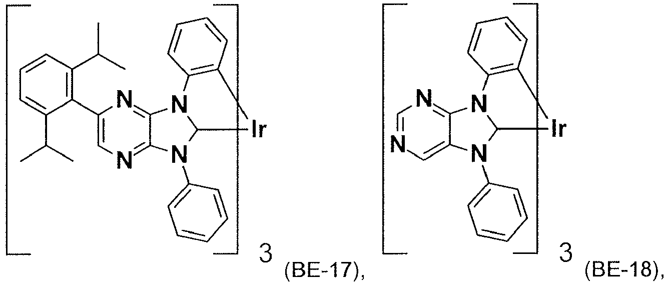

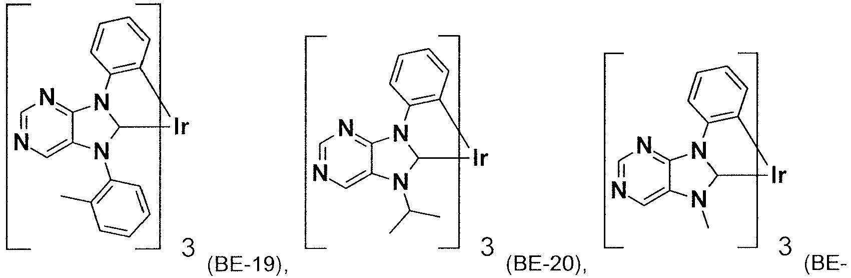

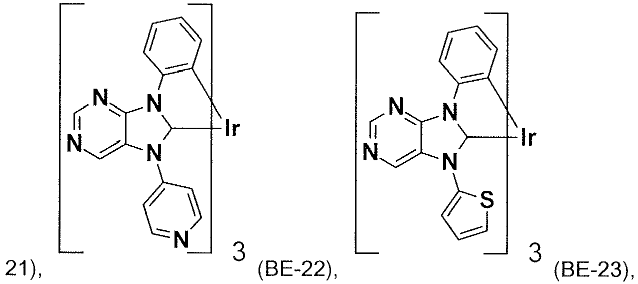

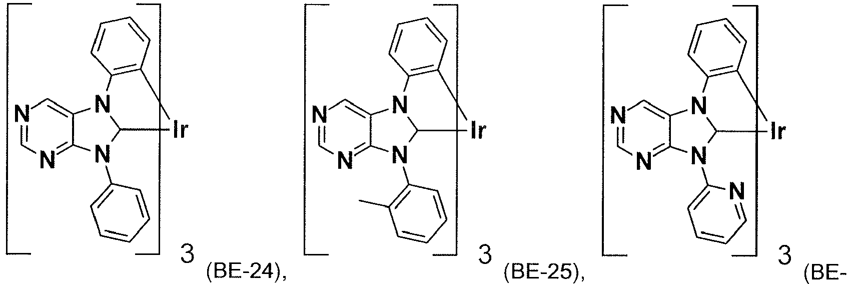

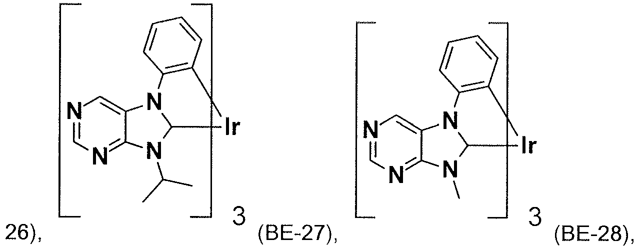

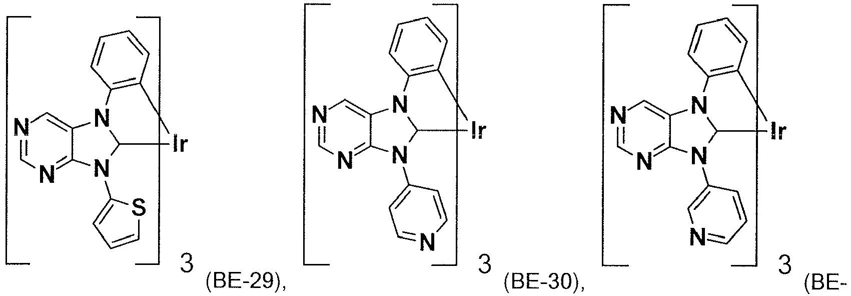

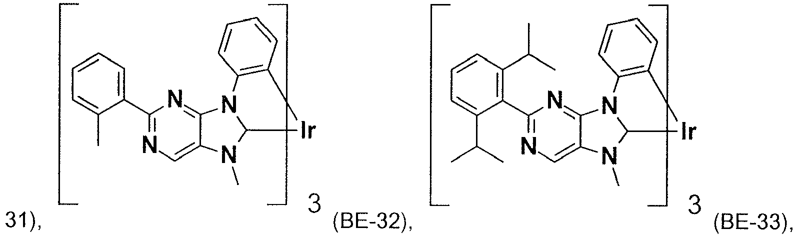

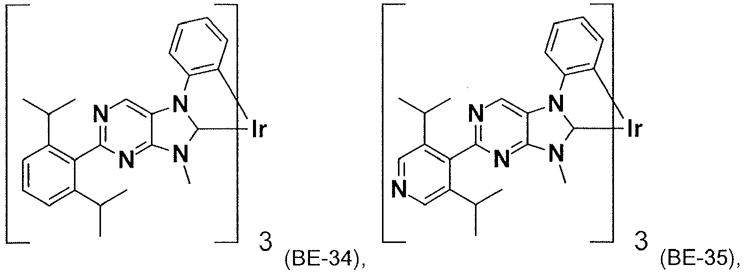

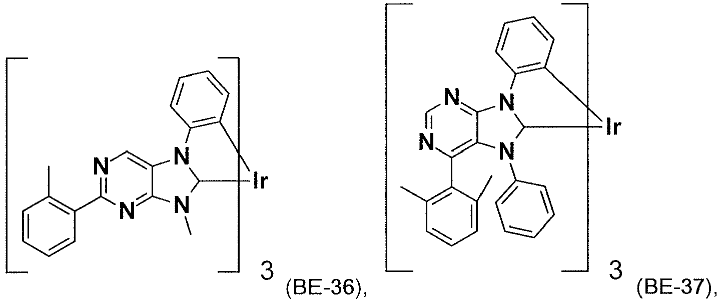

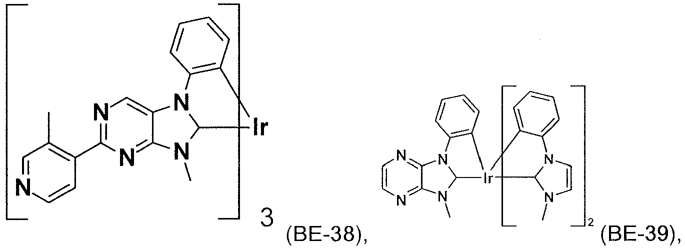

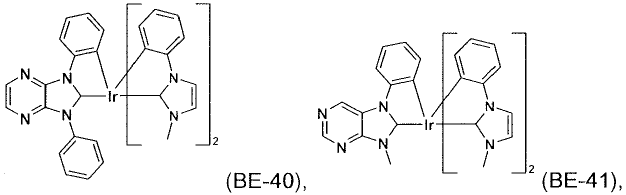

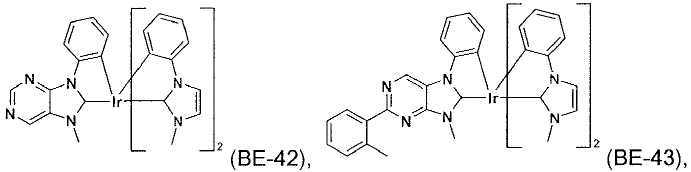

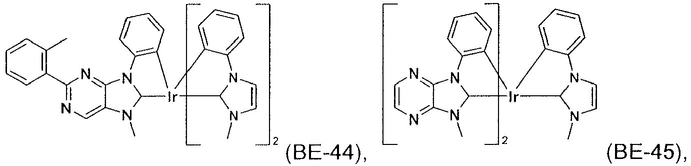

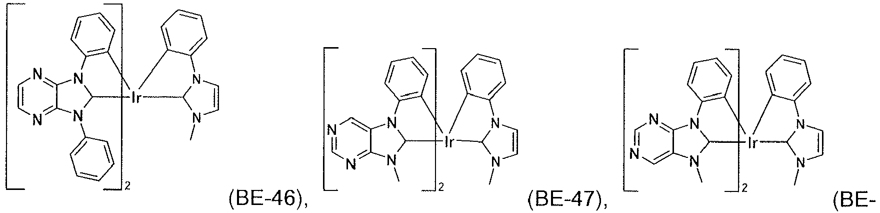

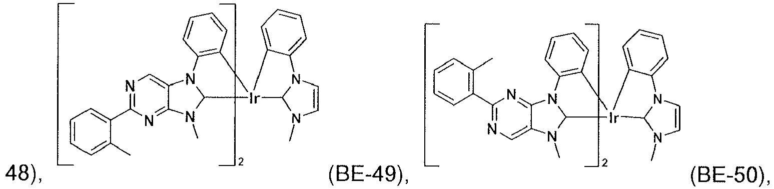

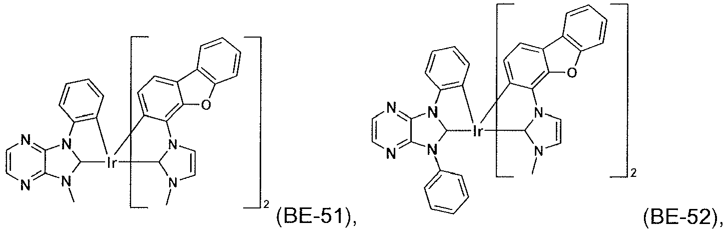

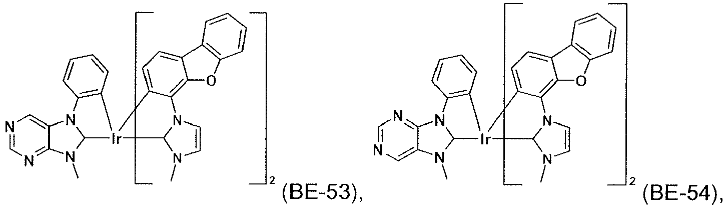

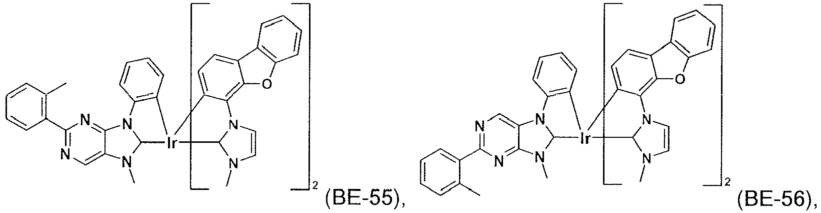

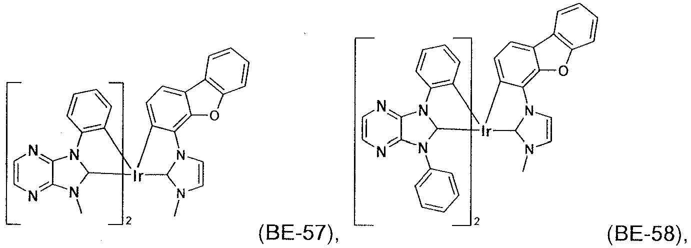

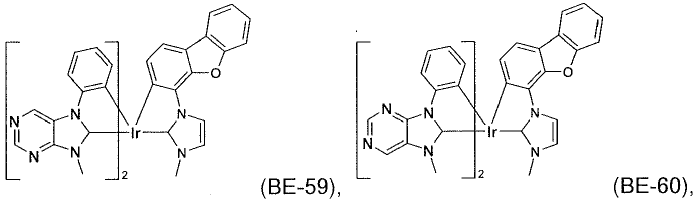

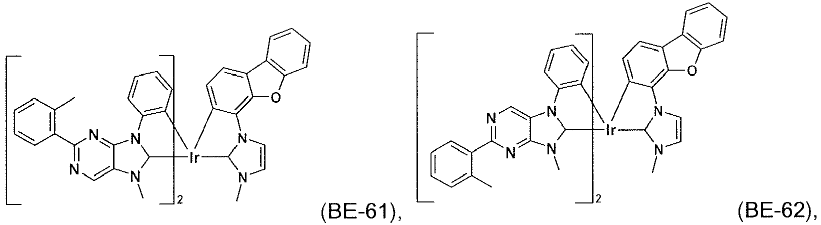

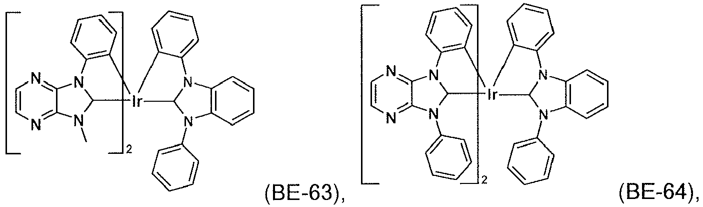

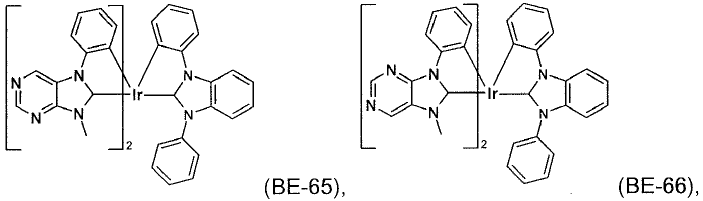

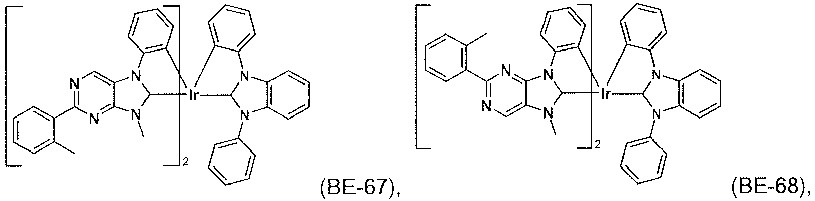

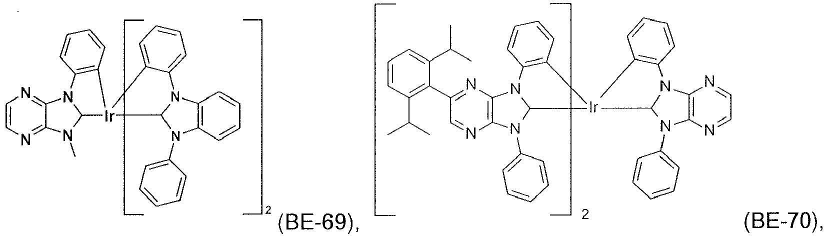

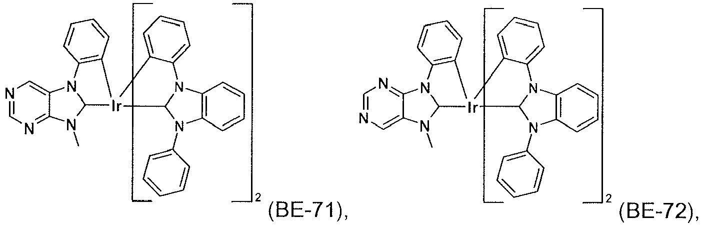

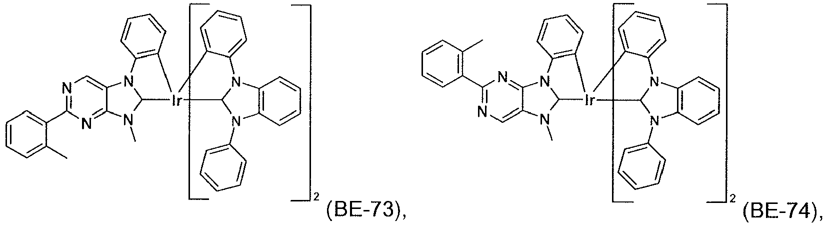

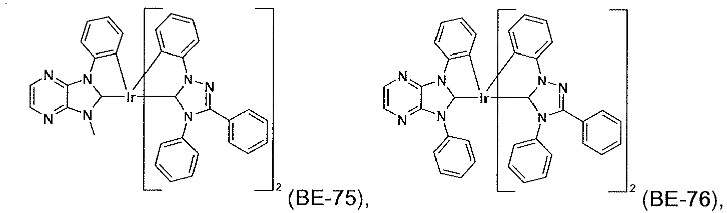

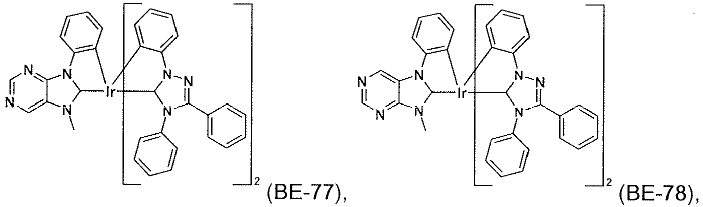

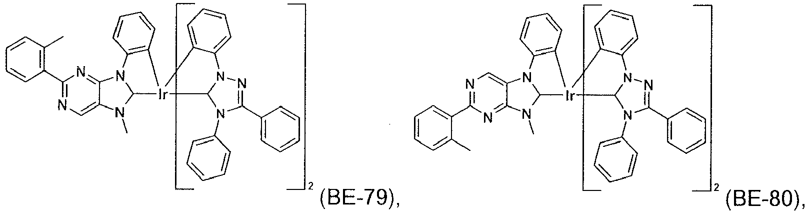

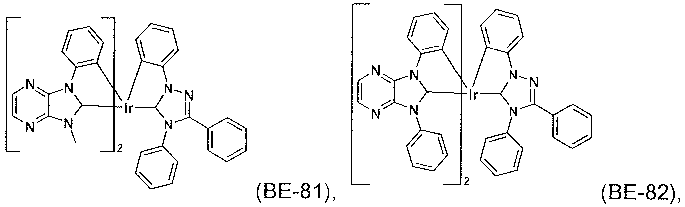

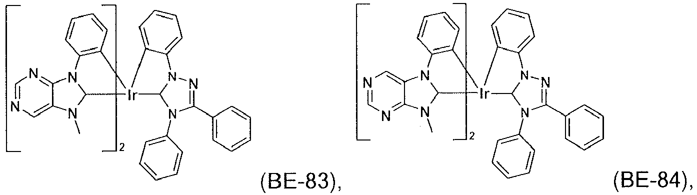

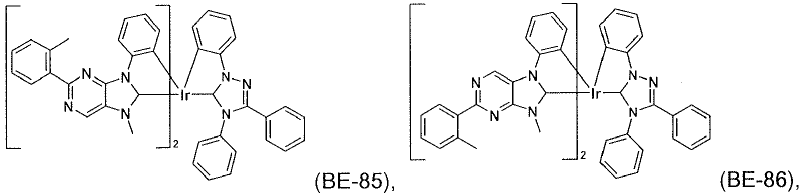

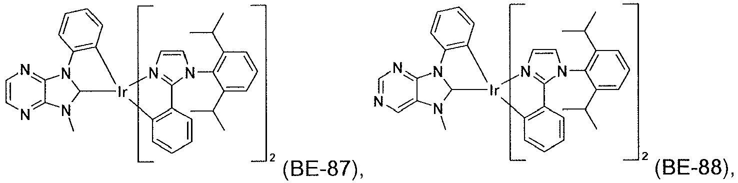

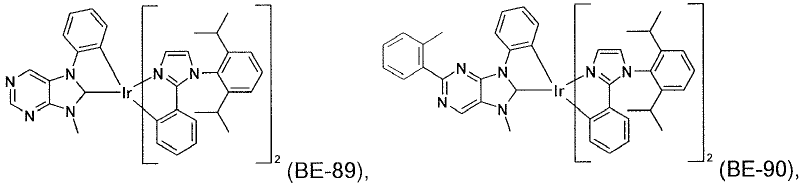

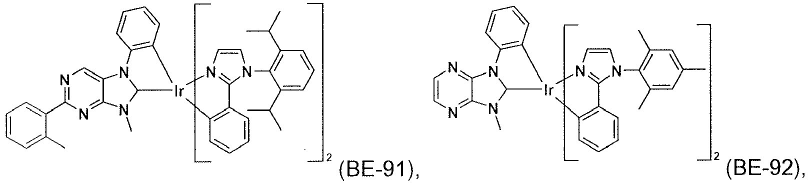

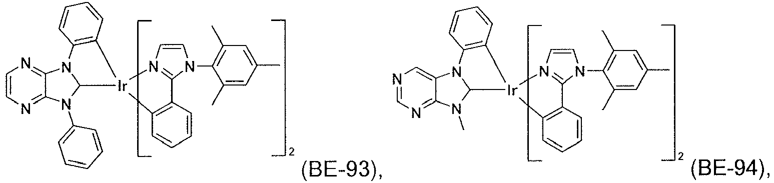

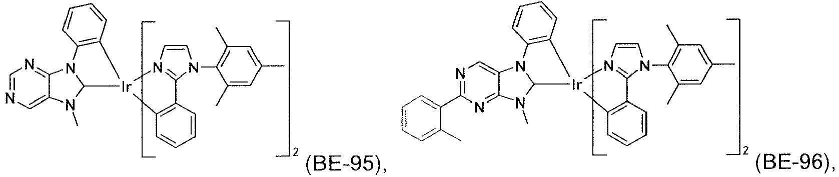

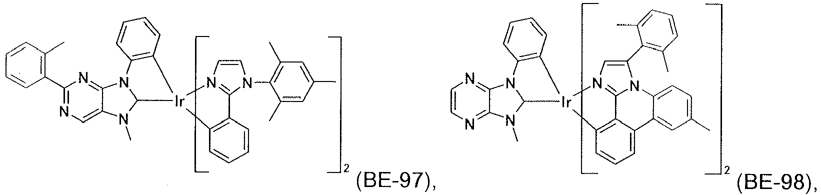

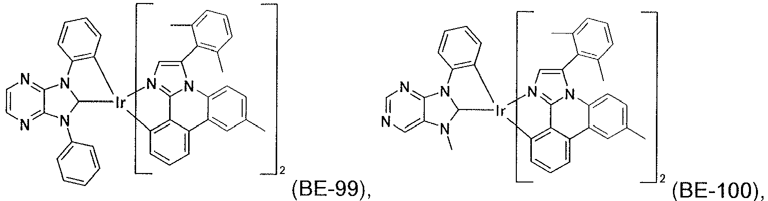

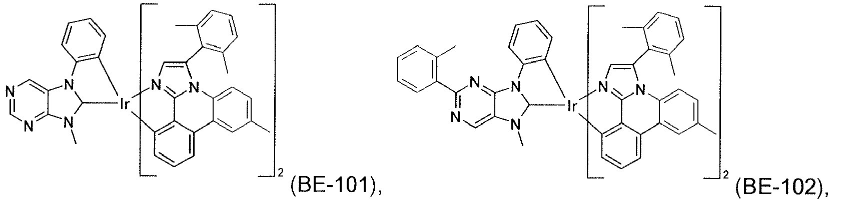

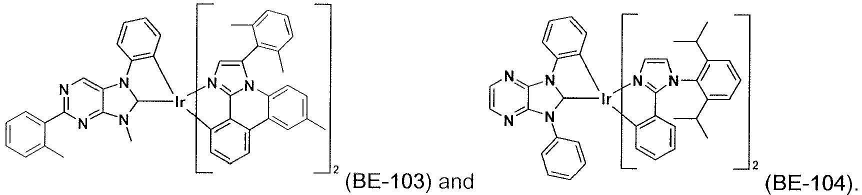

Further suitable non-carbene emitter materials are mentioned below: 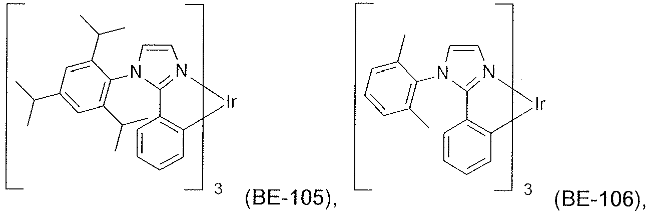 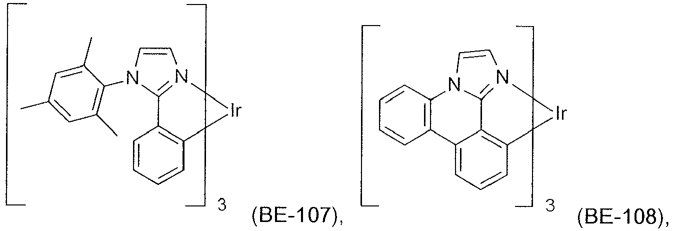 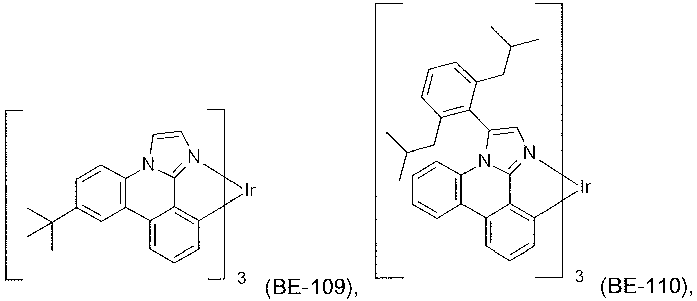 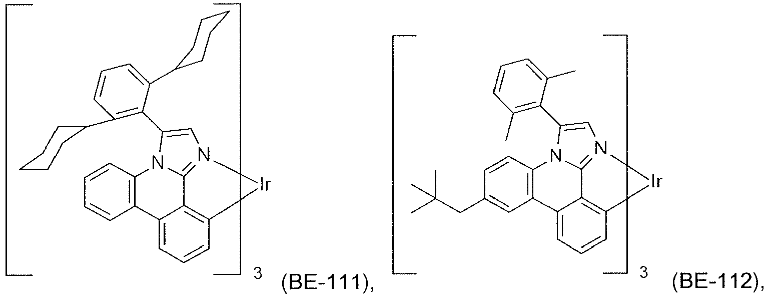 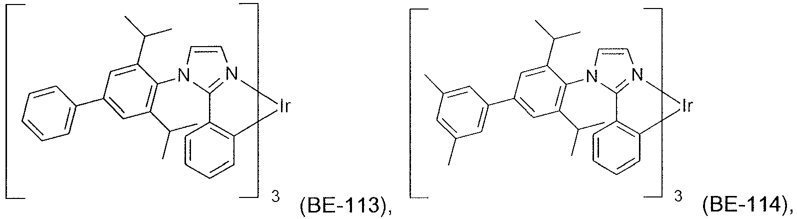 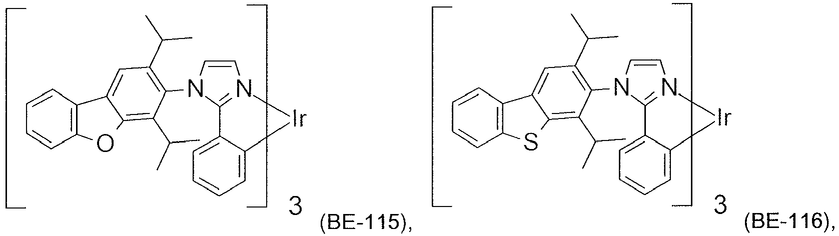 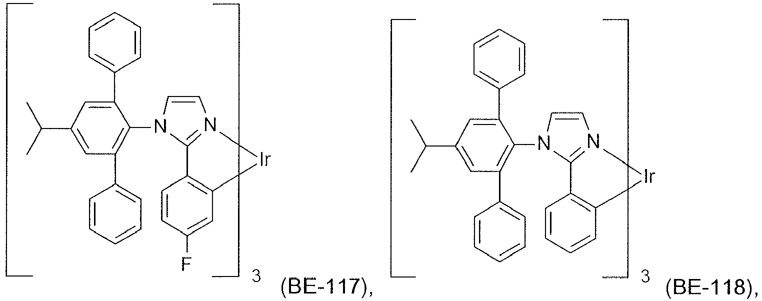 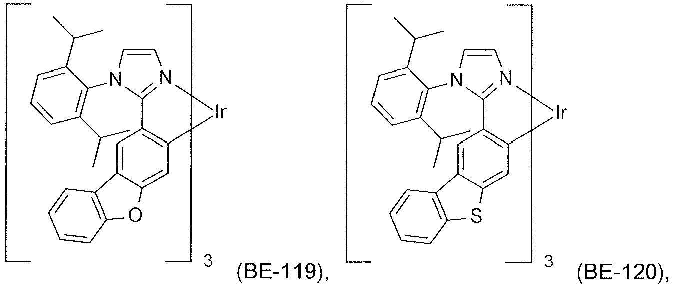 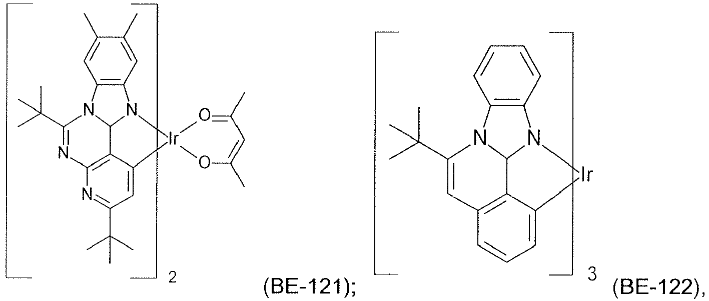 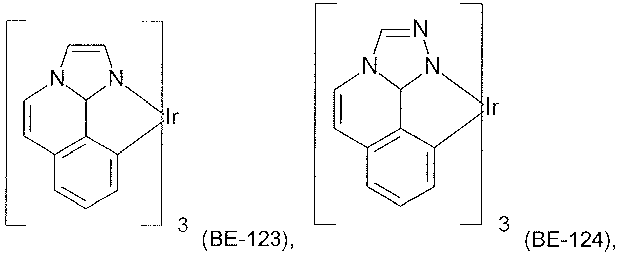 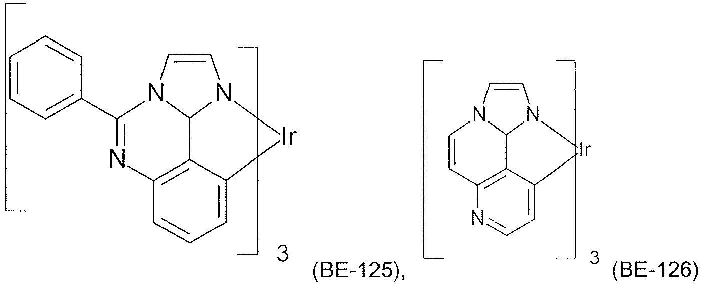 and

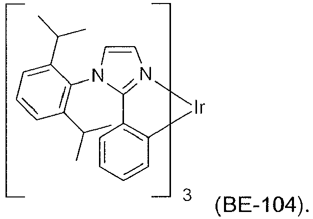

The compound of formula IX is more preferably a compound (BE-1), (BE-2), (BE-7), (BE-12), (BE-16), (BE-64), or (BE-70). The most preferred phosphorescent blue emitters are compounds (BE-1) and (BE-12).

The homoleptic metal-carbene complexes may be present in the form of facial or meridional isomers, preference being given to the facial isomers.

Suitable carbene complexes of formula (IX) and their preparation process are, for example, described in WO2011/073149.

The compounds of the present invention can also be used as host for phosphorescent green emitters. Suitable phosphorescent green emitters are, for example, specified in the following publications: WO2006014599, WO20080220265, WO2009073245, WO2010027583, WO2010028151, US20110227049, WO2011090535, WO2012/08881, WO20100056669, WO20100118029, WO20100244004, WO2011109042, WO2012166608, US20120292600, EP2551933A1; US6687266, US20070190359, US20070190359, US20060008670; WO2006098460, US20110210316, WO 2012053627; US6921915, US20090039776; JP2007123392 and European patent application no. 14180422.9.

Examples of suitable phosphorescent green emitters are shown below:

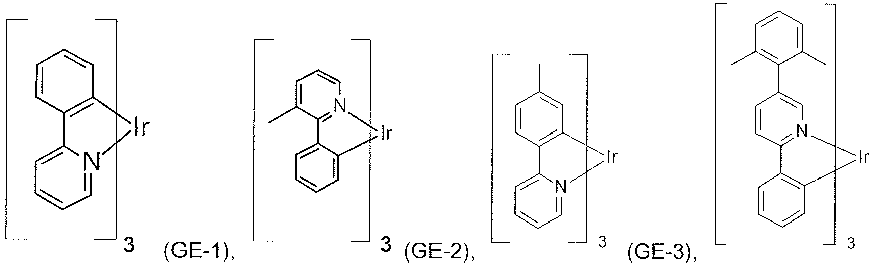

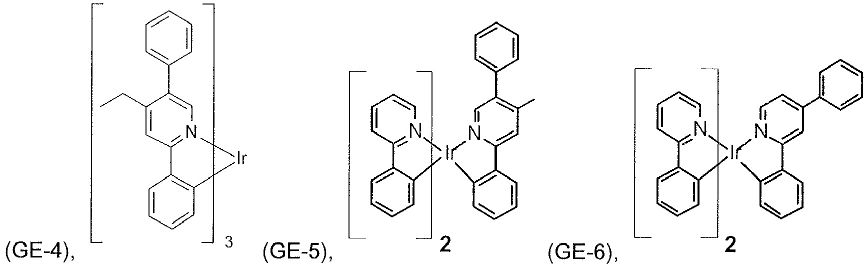

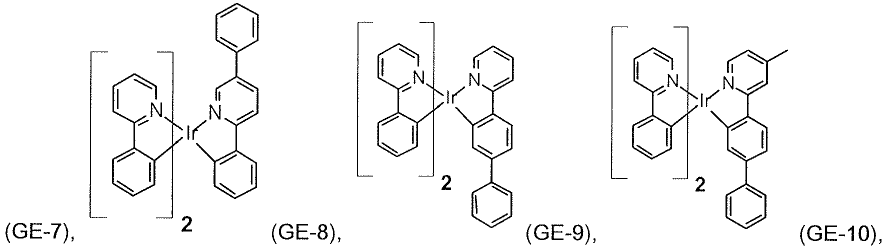

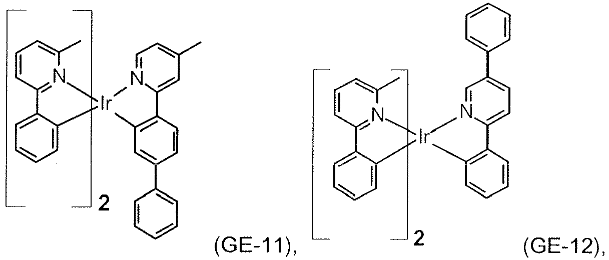

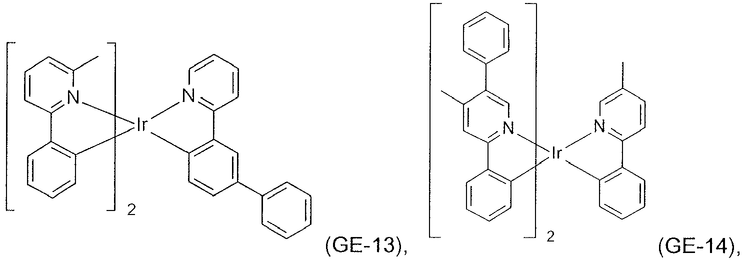

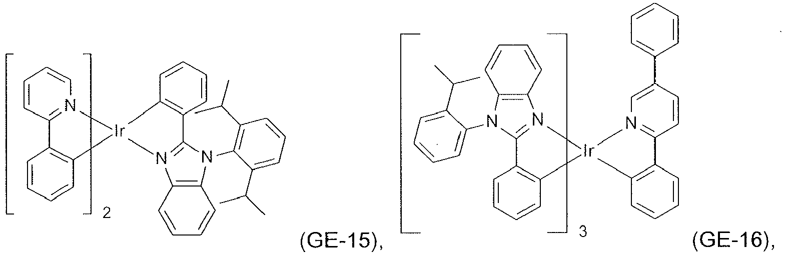

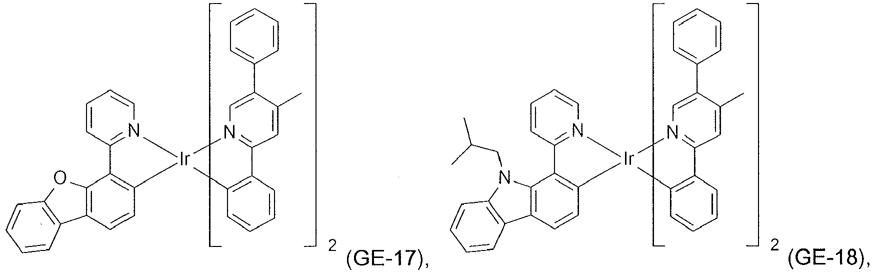

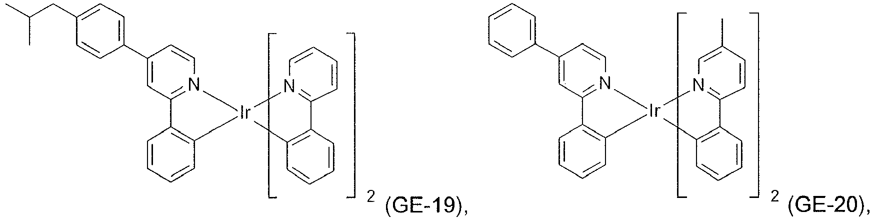

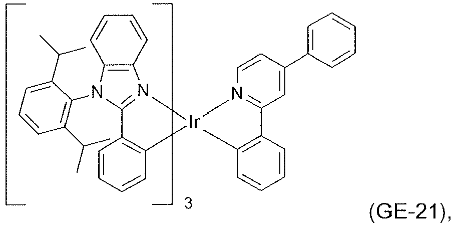

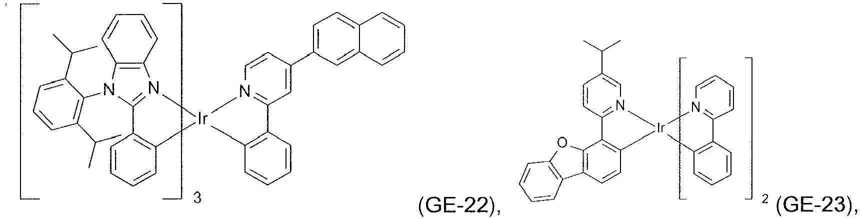

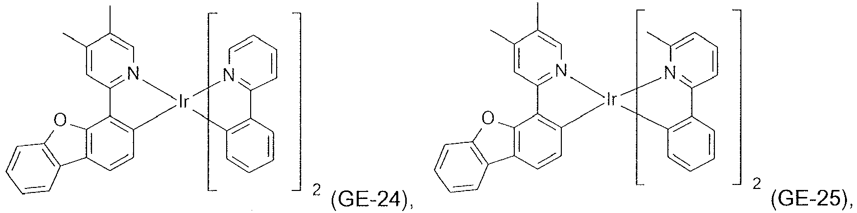

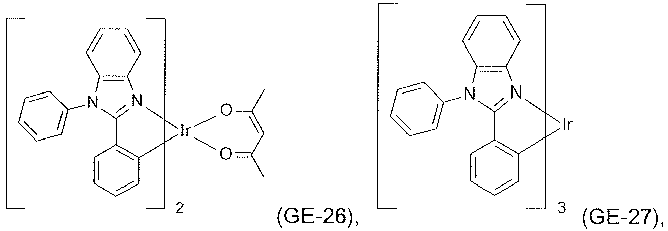

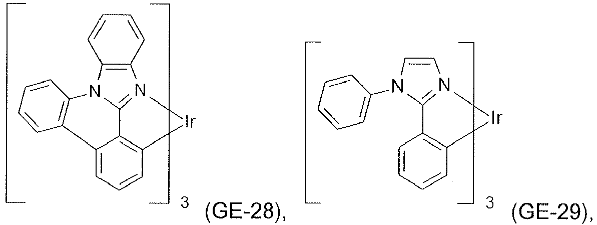

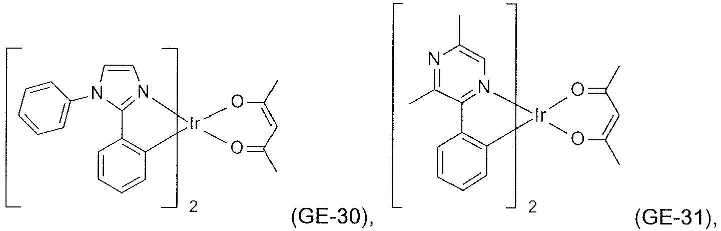

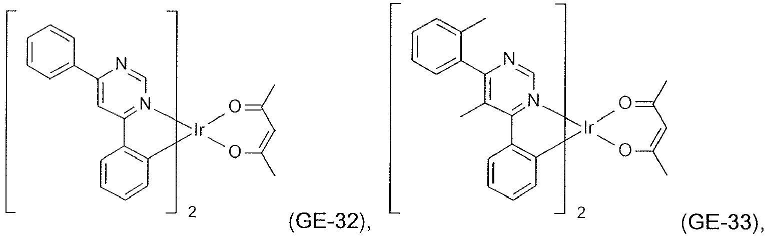

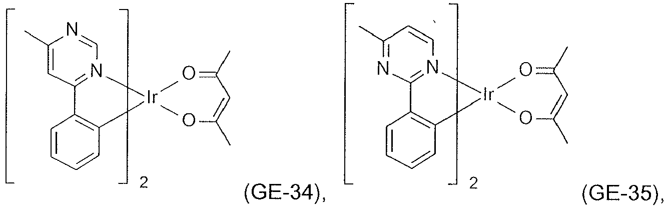

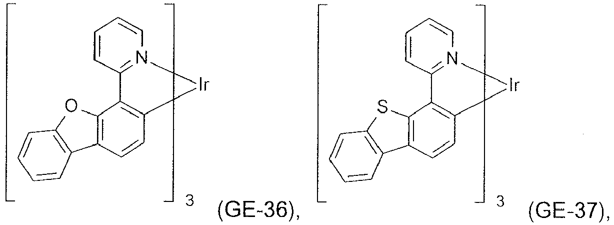

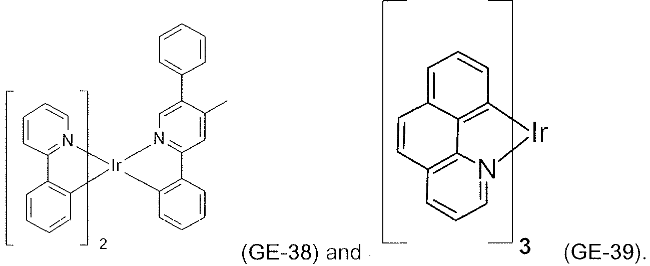

### Host (matrix) materials

The light-emitting layer may comprise further components in addition to the emitter material. For example, a fluroescent dye may be present in the light-emitting layer in order to alter the emission color of the emitter material. In addition - in a preferred embodiment - a matrix material can be used. This matrix material may be a polymer, for example poly(N-vinylcarbazole) or polysilane. The matrix material may, however, be a small molecule, for example 4,4'-N,N'-dicarbazolebiphenyl (CDP=CBP) or tertiary aromatic amines, for example TCTA.

In a preferred embodiment compounds of formula (I), especially (Ia), (Ib) and (Ic), very especially compounds (A-1) to (A-12), (B-1), (B-2), (C-1) and (C-2) are used as host.

In a preferred embodiment, the light-emitting layer is formed from 2 to 40% by weight, preferably 5 to 35% by weight, of at least one of the aforementioned emitter materials and 60 to 98% by weight, preferably 75 to 95% by weight, of at least one of the aforementioned, or belowmentioned matrix materials - in one embodiment at least one compound of the formula I - where the sum total of the emitter material and of the matrix material adds up to 100% by weight.

Suitable metal complexes for use together with the compounds of the formula I as matrix material in OLEDs are, for example, also carbene complexes as described in WO 2005/019373 A2, WO 2006/056418 A2, WO 2005/113704, WO 2007/115970, WO 2007/115981 and WO 2008/000727.

Further suitable host materials, which may be small molecules or (co)polymers of the small molecules mentioned, are specified in the following publications: WO2007108459 (H-1 to H-37), preferably H-20 to H-22 and H-32 to H-37, most preferably H-20, H-32, H-36, H-37, WO2008035571 A1 (Host 1 to Host 6), JP2010135467 (compounds 1 to 46 and Host-1 to Host-39 and Host-43), WO2009008100 compounds No.1 to No.67, preferably No.3, No.4, No.7 to No. 12, No.55, No.59, No. 63 to No.67, more preferably No. 4, No. 8 to No. 12, No. 55, No. 59, No.64, No.65, and No. 67, WO2009008099 compounds No. 1 to No. 110, WO2008140114 compounds 1-1 to 1-50, WO2008090912 compounds OC-7 to OC-36 and the polymers of Mo-42 to Mo-51, JP2008084913 H-1 to H-70, WO2007077810 compounds 1 to 44, preferably 1, 2, 4-6, 8, 19-22, 26, 28-30, 32, 36, 39-44, WO201001830 the polymers of monomers 1-1 to 1-9, preferably of 1-3, 1-7, and 1-9, WO2008029729 the (polymers of) compounds 1-1 to 1-36, WO20100443342 HS-1 to HS-101 and BH-1 to BH-17, preferably BH-1 to BH-17, JP2009182298 the (co)polymers based on the monomers 1 to 75, JP2009170764, JP2009135183 the (co)polymers based on the monomers 1-14, WO2009063757 preferably the (co)polymers based on the monomers 1-1 to 1-26, WO2008146838 the compounds a-1 to a-43 and 1-1 to 1-46, JP2008207520 the (co)polymers based on the monomers 1-1 to 1-26, JP2008066569 the (co)polymers based on the monomers 1-1 to 1-16, WO2008029652 the (co)polymers based on the monomers 1-1 to 1-52, WO2007114244 the (co)polymers based on the monomers 1-1 to 1-18, JP2010040830 the compounds HA-1 to HA-20, HB-1 to HB-16, HC-1 to HC-23 and the (co)polymers based on the monomers HD-1 to HD-12, JP2009021336, WO2010090077 the compounds 1 to 55, WO2010079678 the compounds H1 to H42, WO2010067746, WO2010044342 the compounds HS-1 to HS-101 and Poly-1 to Poly-4, JP2010114180 the compounds PH-1 to PH-36, US2009284138 the compounds 1 to 111 and H1 to H71, WO2008072596 the compounds 1 to 45, JP2010021336 the compounds H-1 to H-38, preferably H-1, WO2010004877 the compounds H-1 to H-60, JP2009267255 the compounds 1-1 to 1-105, WO2009104488 the compounds 1-1 to 1-38, WO2009086028, US2009153034, US2009134784, WO2009084413 the compounds 2-1 to 2-56, JP2009114369 the compounds 2-1 to 2-40, JP2009114370 the compounds 1 to 67, WO2009060742 the compounds 2-1 to 2-56, WO2009060757 the compounds 1-1 to 1-76, WO2009060780 the compounds 1-1 to 1-70, WO2009060779 the compounds 1-1 to 1-42, WO2008156105 the compounds 1 to 54, JP2009059767 the compounds 1 to 20, JP2008074939 the compounds 1 to 256, JP2008021687 the compounds 1 to 50, WO2007119816 the compounds 1 to 37, WO2010087222 the compounds H-1 to H-31, WO2010095564 the compounds HOST-1 to HOST-61, WO2007108362, WO2009003898, WO2009003919, WO2010040777, US2007224446, WO06128800, WO2012014621, WO2012105310, WO2012/130709, WO2014/009317 (in particular compound A-24), PCT/EP2013/069403 and PCT/EP2013/073120 (in particular page 25 to 29 of PCT/EP2013/073120).

The above-mentioned small molecules are more preferred than the above-mentioned (co)polymers of the small molecules.

Further suitable host materials, are described in WO2011137072 (for example, 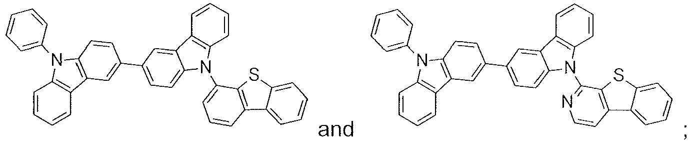 best results are achieved if said compounds are combined with 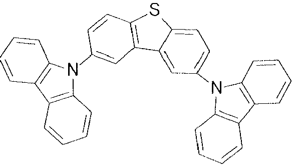 ); WO2012048266 (for example, 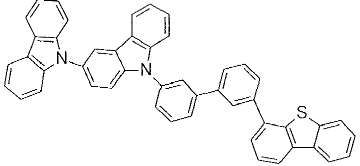 and 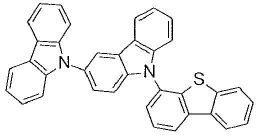 ); WO2012162325 (for example, 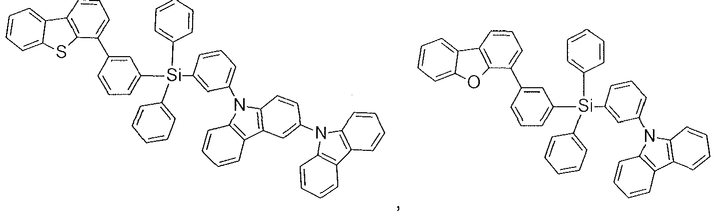 and 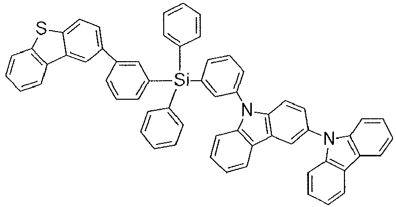 ); and EP2551932 (for example, 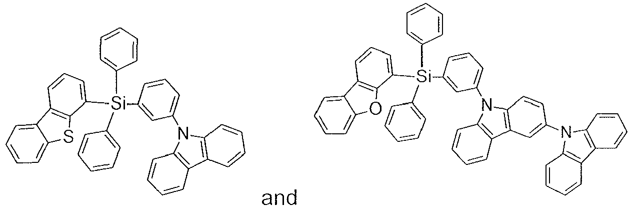 ).

In a particularly preferred embodiment, one or more compounds of the general formula (X) specified hereinafter are used as second host material. 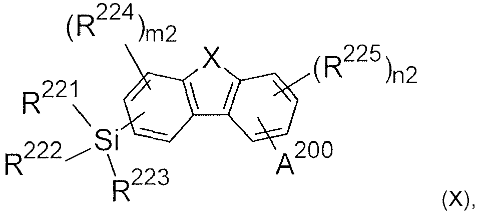 wherein
X is NR, S, O or PR;
R is aryl, heteroaryl, alkyl, cycloalkyl, or heterocycloalkyl;
A²⁰⁰ is -NR²⁰⁶R²⁰⁷, -P(O)R²⁰⁸R²⁰⁹, -PR²¹⁰R²¹¹, -S(O)₂R²¹², -S(O)R²¹³, -SR²¹⁴, or -OR²¹⁵; R²²¹, R²²² and R²²³ are independently of each other aryl, heteroaryl, alkyl, cycloalkyl, or heterocycloalkyl, wherein at least on of the groups R²²¹, R²²², or R²²³ is aryl, or heteroaryl;
R²²⁴ and R²²⁵ are independently of each other alkyl, cycloalkyl, heterocycloalkyl, aryl, heteroaryl, a group A²⁰⁰, or a group having donor, or acceptor characteristics;
n2 and m2 are independently of each other 0, 1, 2, or 3;
R²⁰⁶ and R²⁰⁷ form together with the nitrogen atom a cyclic residue having 3 to 10 ring atoms, which can be unsubstituted, or which can be substituted with one, or more substituents selected from alkyl, cycloalkyl, heterocycloalkyl, aryl, heteroaryl and a group having donor, or acceptor characteristics; and/or which can be annulated with one, or more further cyclic residues having 3 to 10 ring atoms, wherein the annulated residues can be unsubstituted, or can be substituted with one, or more substituents selected from alkyl, cycloalkyl, heterocycloalkyl, aryl, heteroaryl and a group having donor, or acceptor characteristics; and R²⁰⁸, R²⁰⁹, R²¹⁰, R²¹¹, R²¹², R²¹³, R²¹⁴ und R²¹⁵ are independently of each other aryl, heteroaryl, alkyl, cycloalkyl, or heterocycloalkyl. Compounds of formula X, such as, for example, 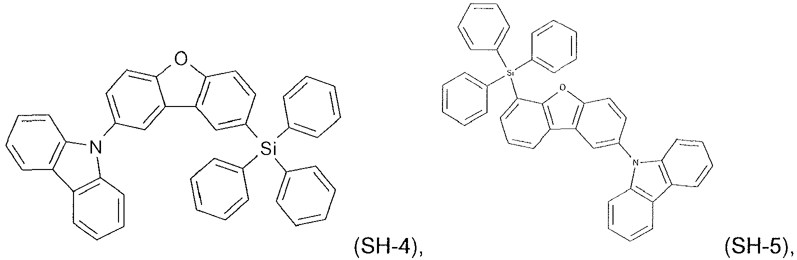 or 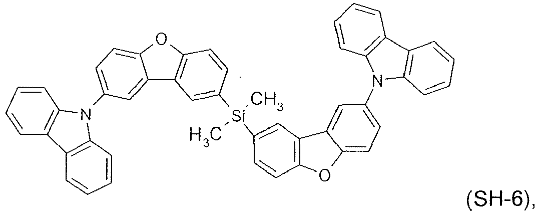 are described in WO2010079051 (in particular pages on 19 to 26 and in tables on pages 27 to 34, pages 35 to 37 and pages 42 to 43).

Additional host materials on basis of dibenzofurane are, for example, described in US2009066226, EP1885818B1, EP1970976, EP1998388 and EP2034538. Examples of particularly preferred host materials are shown below:

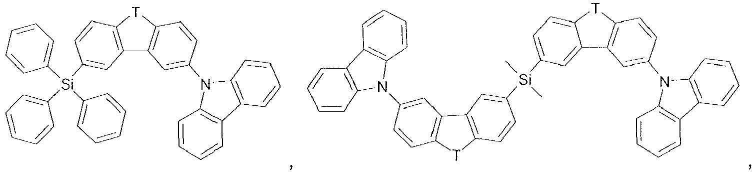

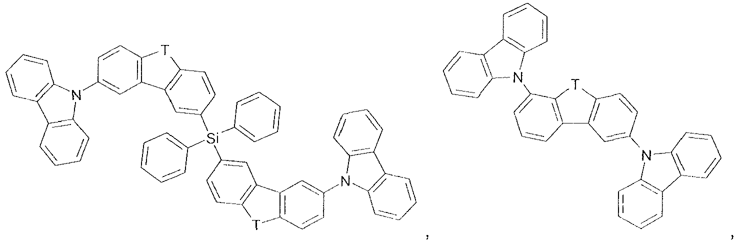

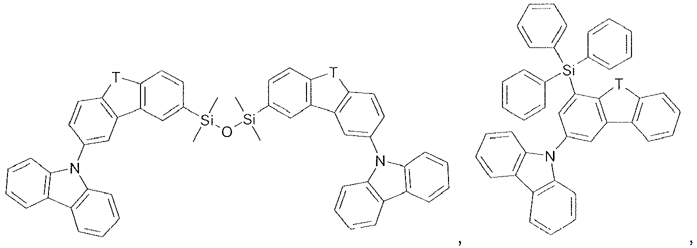

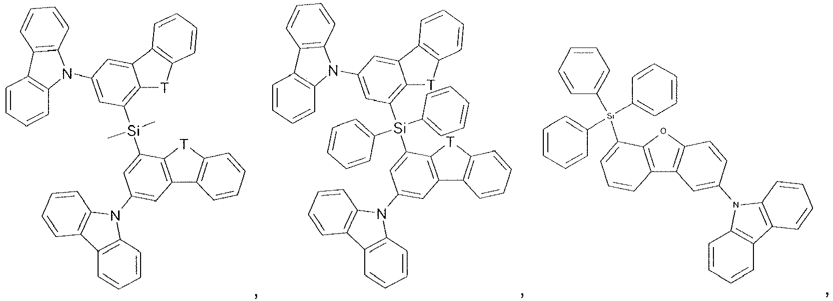

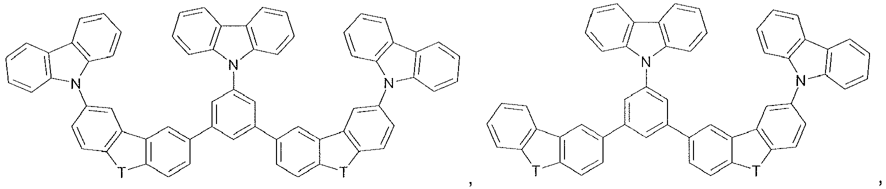

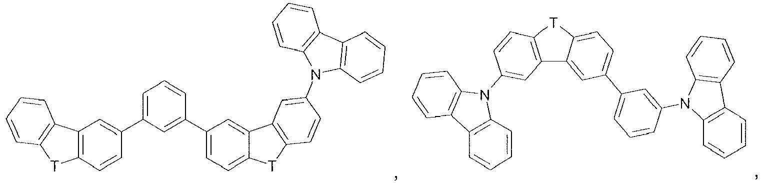

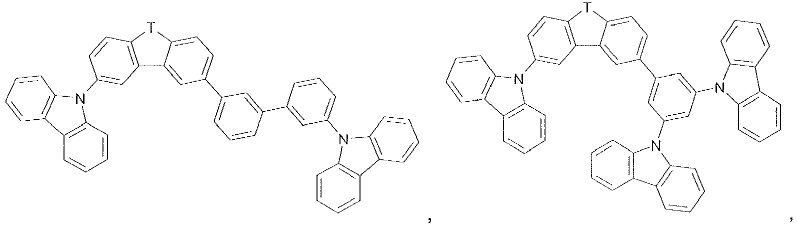

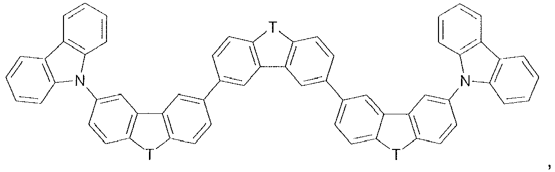

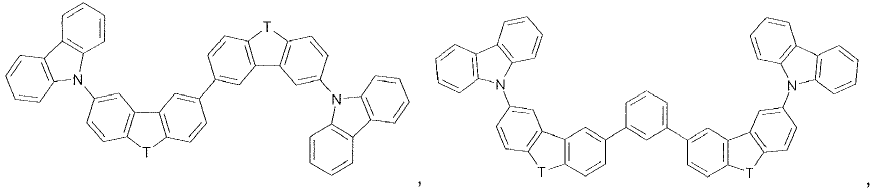

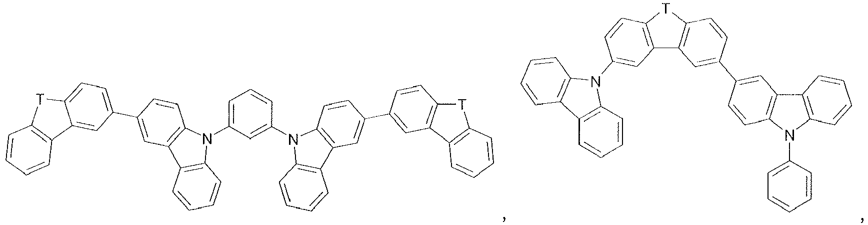

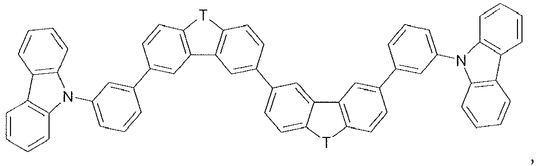

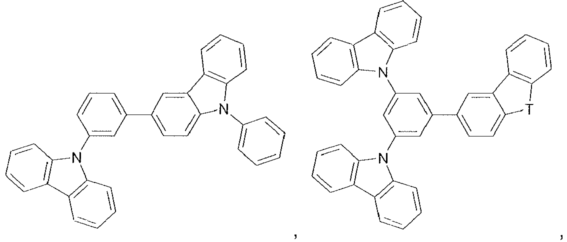

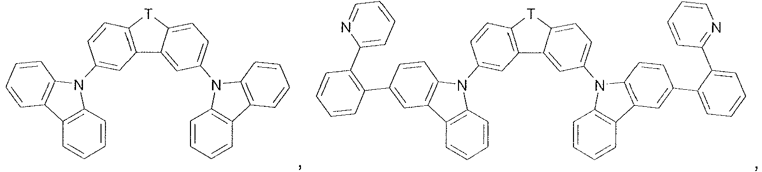

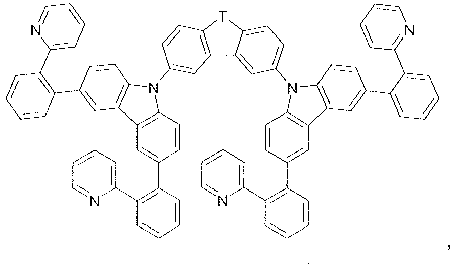

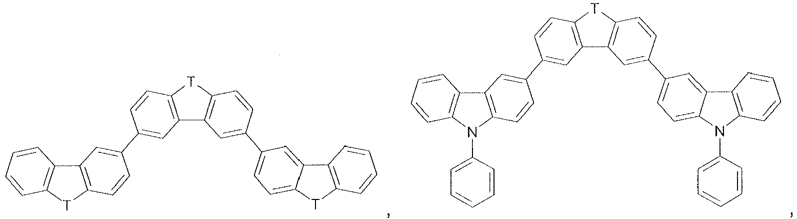

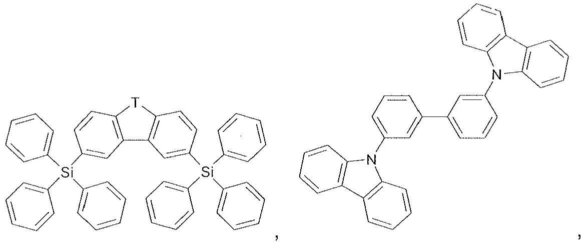

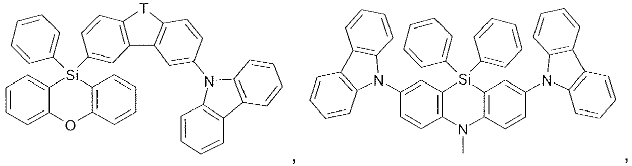

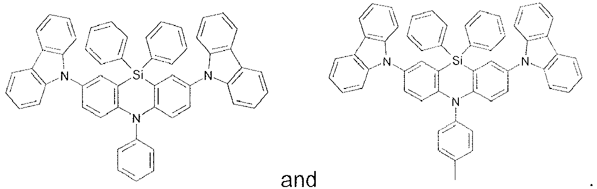

In the above-mentioned compounds T is O, or S, preferably O. If T occurs more than one time in a molecule, all groups T have the same meaning. Compounds (SH-1), 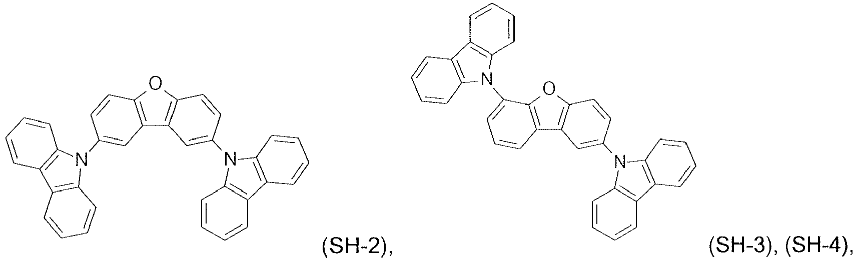 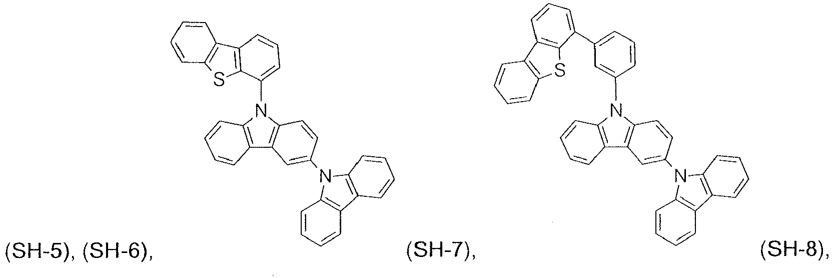 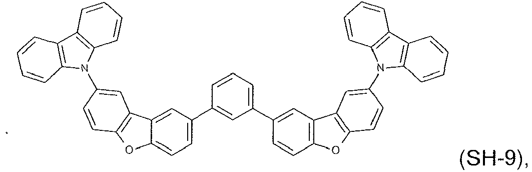 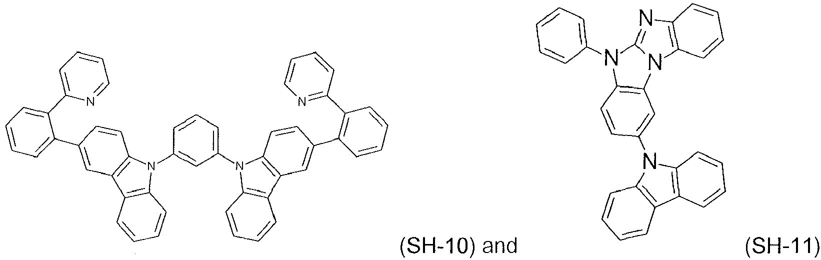 are most preferred.

### Hole/exciton blocking layer (f):

Blocking layers may be used to reduce the number of charge carriers (electrons or holes) and/or excitons that leave the emissive layer. The hole blocking layer may be disposed between the emitting layer (e) and electron transport layer (g), to block holes from leaving layer (e) in the direction of electron transport layer (g). Blocking layers may also be used to block excitons from diffusing out of the emissive layer.

Hole blocker materials typically used in OLEDs are 2,6-bis(N-carbazolyl)pyridine (mCPy), 2,9-dimethyl-4,7-diphenyl-1,10-phenanthroline (bathocuproin, (BCP)), bis(2-methyl-8-quinolinato)-4-phenylphenylato)aluminum(III) (BAlq), phenothiazine *S,S-*dioxide derivates and 1,3,5-tris(N-phenyl-2-benzylimidazolyl)benzene) (TPBI), TPBI also being suitable as electron-transport material. Further suitable hole blockers and/or electron conductor materials are 2,2',2"-(1,3,5-benzenetriyl)tris(1-phenyl-1-H-benzimidazole), 2-(4-biphenylyl)-5-(4-tert-butylphenyl)-1,3,4-oxadiazole, 8-hydroxyquinolinolatolithium, 4-(naphthalen-1-yl)-3,5-diphenyl-4H-1,2,4-triazole, 1,3-bis[2-(2,2'-bipyridin-6-yl)-1,3,4-oxadiazo-5-yl]benzene, 4,7-diphenyl-1,10-phenanthroline, 3-(4-biphenylyl)-4-phenyl-5-tert-butylphenyl-1,2,4-triazole, 6,6'-bis[5-(biphenyl-4-yl)-1,3,4-oxadiazo-2-yl]-2,2'-bipyridyl, 2-phenyl-9,10-di(naphthalene-2-yl)anthracene, 2,7-bis[2-(2,2'-bipyridin-6-yl)-1,3,4-oxadiazo-5-yl]-9,9-dimethylfluorene, 1,3-bis[2-(4-tert-butylphenyl)-1,3,4-oxadiazo-5-yl]benzene, 2-(naphthalene-2-yl)-4,7-diphenyl-1,10-phenanthroline, tris(2,4,6-trimethyl-3-(pyridin-3-yl)phenyl)borane, 2,9-bis(naphthalene-2-yl)-4,7-diphenyl-1,10-phenanthroline, 1-methyl-2-(4-(naphthalene-2-yl)phenyl)-1H-imidazo[4,5-f][1,10]phenanthroline. In a further embodiment, it is possible to use compounds which comprise aromatic or heteroaromatic rings joined via groups comprising carbonyl groups, as disclosed in WO2006/100298, disilyl compounds selected from the group consisting of disilylcarbazoles, disilylbenzofurans, disilylbenzothiophenes, disilylbenzophospholes, disilylbenzothiophene S-oxides and disilylbenzothiophene S,S-dioxides, as specified, for example, in PCT applications WO2009/003919 and WO2009003898 and disilyl compounds as disclosed in WO2008/034758, as a blocking layer for holes/excitons (f).

In another preferred embodiment compounds (SH-1), (SH-2), (SH-3), (SH-4), (SH-5), (SH-6), (SH-7), (SH-8), (SH-9), (SH-10) and (SH-11) may be used as hole/exciton blocking materials.

### Electron transport layer (g):

Electron transport layer may include a material capable of transporting electrons. Electron transport layer may be intrinsic (undoped), or doped. Doping may be used to enhance conductivity. Suitable electron-transporting materials for layer (g) of the inventive OLEDs comprise metals chelated with oxinoid compounds, such as tris(8-hydroxyquinolato)aluminum (Alq₃), compounds based on phenanthroline such as 2,9-dimethyl-4,7-diphenyl-1,10-phenanthroline (DDPA = BCP), 4,7-diphenyl-1,10-phenanthroline (Bphen), 2,4,7,9-tetraphenyl-1,10-phenanthroline, 4,7-diphenyl-1,10-phenanthroline (DPA) or phenanthroline derivatives disclosed in EP1786050, in EP1970371, or in EP1097981, and azole compounds such as 2-(4-biphenylyl)-5-(4-t-butylphenyl)-1,3,4-oxadiazole (PBD) and 3-(4-biphenylyl)-4phenyl-5-(4-t-butylphenyl)-1,2,4-triazole (TAZ).

It is likewise possible to use mixtures of at least two materials in the electron-transporting layer, in which case at least one material is electron-conducting. Preferably, in such mixed electron-transport layers, at least one phenanthroline compound is used, preferably BCP, or at least one pyridine compound according to the formula (VIII) below, preferably a compound of the formula (Vlllaa) below. More preferably, in mixed electron-transport layers, in addition to at least one phenanthroline compound, alkaline earth metal or alkali metal hydroxyquinolate complexes, for example Liq, are used. Suitable alkaline earth metal or alkali metal hydroxyquinolate complexes are specified below (formula VII). Reference is made to WO2011/157779.

The electron-transport layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, No. 1, 1 July 2003 (p-doped organic layers); A. G. Werner, F. Li, K. Harada, M. Pfeiffer, T. Fritz, K. Leo, Appl. Phys. Lett., Vol. 82, No. 25, 23 June 2003 and Pfeiffer et al., Organic Electronics 2003, 4, 89 - 103 and K. Walzer, B. Maennig, M. Pfeiffer, K. Leo, Chem. Soc. Rev. 2007, 107, 1233. For example, it is possible to use mixtures which lead to electrical n-doping of the electron-transport layer. n-Doping is achieved by the addition of reducing materials. These mixtures may, for example, be mixtures of the abovementioned electron transport materials with alkali/alkaline earth metals or alkali/alkaline earth metal salts, for example Li, Cs, Ca, Sr, Cs₂CO₃, with alkali metal complexes and with Y, Ce, Sm, Gd, Tb, Er, Tm, Yb, Li₃N, Rb₂CO₃, dipotassium phthalate, W(hpp)₄ from EP1786050, or with compounds described in EP1837926B1, EP1837927, EP2246862 and WO2010132236.

In a preferred embodiment, the electron-transport layer comprises at least one compound of the general formula (VII) 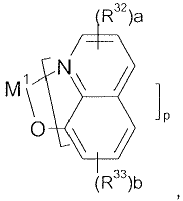 in which
R³² and R³³ are each independently F, C₁-C₈-alkyl, or C₆-C₁₄-aryl, which is optionally substituted by one or more C₁-C₈-alkyl groups, or
two R³² and/or R³³ substituents together form a fused benzene ring which is optionally substituted by one or more C₁-C₈-alkyl groups;
a and b are each independently 0, or 1, 2 or 3,
M¹ is an alkaline metal atom or alkaline earth metal atom,
p is 1 when M¹ is an alkali metal atom, p is 2 when M¹ is an earth alkali metal atom.

A very particularly preferred compound of the formula (VII) is 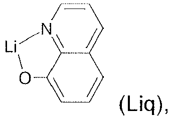 which may be present as a single species, or in other forms such as Li_{g}Q_{g} in which g is an integer, for example Li₆Q₆. Q is an 8-hydroxyquinolate ligand or an 8-hydroxyquinolate derivative.

In a further preferred embodiment, the electron-transport layer comprises at least one compound of the formula (VIII), 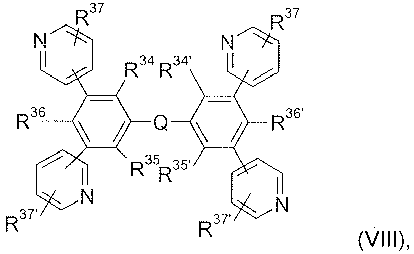 in which
R³⁴, R³⁵, R³⁶, R³⁷, R^{34'}, R^{35'}, R^{36'} and R^{37'} are each independently H, C₁-C₁₈-alkyl, C₁-C₁₈-alkyl which is substituted by E and/or interrupted by D, C₆-C₂₄-aryl, C₆-C₂₄-aryl which is substituted by G, C₂-C₂₀-heteroaryl or C₂-C₂₀-heteroaryl which is substituted by G,
Q is an arylene or heteroarylene group, each of which is optionally substituted by G;
D is -CO-; -COO-; -S-; -SO-; -SO₂-; -O-; -NR¹⁴⁶-; -SiR¹⁴⁵R¹⁴⁶-; -POR¹⁴⁷-; -CR³⁸=CR³⁹-; or-C≡C-; E is -OR¹⁴⁴; -SR¹⁴⁴; -NR¹⁴⁰R¹⁴¹; -COR¹⁴³; -COOR¹⁴²; -CONR¹⁴⁰R¹⁴¹; -CN; or F;
G is E, C₁-C₁₈-alkyl, C₁-C₁₈-alkyl which is interrupted by D, C₁-C₁₈-perfluoroalkyl, C₁-C₁₈-alkoxy, or C₁-C₁₈-alkoxy which is substituted by E and/or interrupted by D, in which R³⁸ and R³⁹ are each independently H, C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-; R¹⁴⁰ and R¹⁴¹ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-; or R¹⁴⁰ and R¹⁴¹ together form a 6-membered ring;
R¹⁴² and R¹⁴³ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-, R¹⁴⁴ is C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R¹⁴⁵ and R¹⁴⁶ are each independently C₁-C₁₈-alkyl, C₆-C₁₈-aryl or C₆-C₁₈-aryl which is substituted by C₁-C₁₈-alkyl,
R¹⁴⁷ is C₁-C₁₈-alkyl, C₆-C₁₈-aryl or C₆-C₁₈-aryl which is substituted by C₁-C₁₈-alkyl.

Preferred compounds of the formula (VIII) are compounds of the formula (Villa) 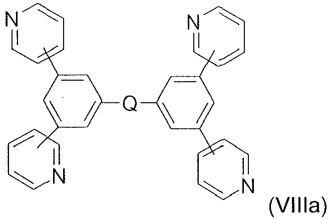
in which Q is: 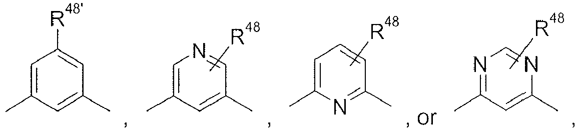
R48 is H or C₁-C₁₈-alkyl and
R^{48'} is H, C₁-C₁₈-alkyl or

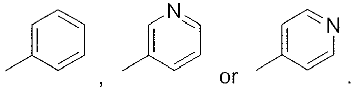

Particular preference is given to a compound of the formula

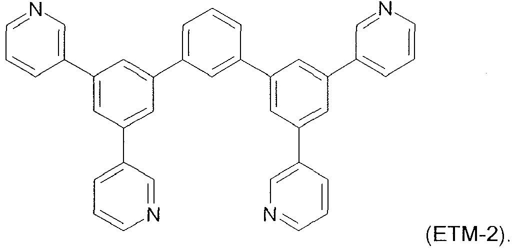

In a further, very particularly preferred embodiment, the electron-transport layer comprises a compound Liq and a compound ETM-2.

In a preferred embodiment, the electron-transport layer comprises the compound of the formula (VII) in an amount of 99 to 1% by weight, preferably 75 to 25% by weight, more preferably about 50% by weight, where the amount of the compounds of the formulae (VII) and the amount of the compounds of the formulae (VIII) adds up to a total of 100% by weight.

The preparation of the compounds of the formula (VIII) is described in J. Kido et al., Chem. Commun. (2008) 5821-5823, J. Kido et al., Chem. Mater. 20 (2008) 5951-5953 and JP2008/127326, or the compounds can be prepared analogously to the processes disclosed in the aforementioned documents.

It is likewise possible to use mixtures of alkali metal hydroxyquinolate complexes, preferably Liq, and dibenzofuran compounds in the electron-transport layer. Reference is made to WO2011/157790. Dibenzofuran compounds A-1 to A-36 and B-1 to B-22 described in WO2011/157790 are preferred, wherein dibenzofuran compound 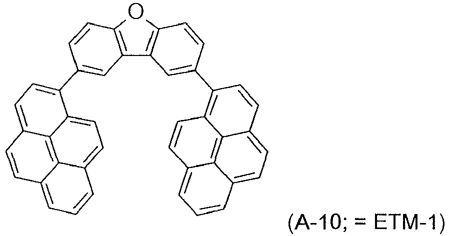 is most preferred.

In a preferred embodiment, the electron-transport layer comprises Liq in an amount of 99 to 1% by weight, preferably 75 to 25% by weight, more preferably about 50% by weight, where the amount of Liq and the amount of the dibenzofuran compound(s), especially ETM-1, adds up to a total of 100% by weight.

In a preferred embodiment, the electron-transport layer comprises at least one phenanthroline derivative and/or pyridine derivative.

In a further preferred embodiment, the electron-transport layer comprises at least one phenanthroline derivative and/or pyridine derivative and at least one alkali metal hydroxyquinolate complex.

In a further preferred embodiment, the electron-transport layer comprises at least one of the dibenzofuran compounds A-1 to A-36 and B-1 to B-22 described in WO2011/157790, especially ETM-1.

In a further preferred embodiment, the electron-transport layer comprises a compound described in WO2012/111462, WO2012/147397, WO2012014621, such as, for example, a compound of formula 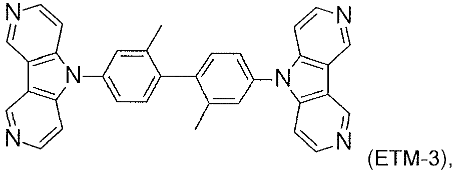 US2012/0261654 , such as, for example, a compound of formula 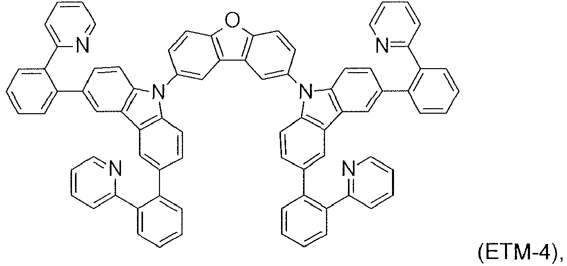 and WO2012/115034, such as for example, such as, for example, a compound of formula

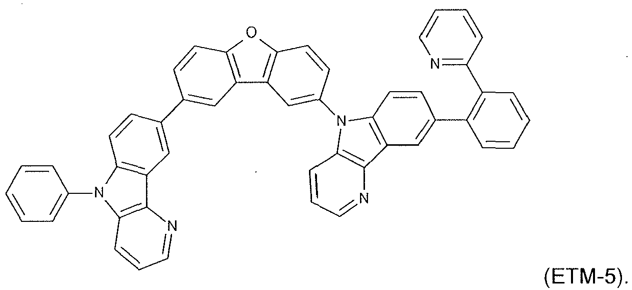

### Electron injection layer (h):

The electron injection layer may be any layer that improves the injection of electrons into an adjacent organic layer. Lithium-comprising organometallic compounds such as 8-hydroxyquinolatolithium (Liq), CsF, NaF, KF, Cs₂CO₃ or LiF may be applied between the electron transport layer (g) and the cathode (i) as an electron injection layer (h) in order to reduce the operating voltage.

### Cathode (i):

The cathode (i) is an electrode which serves to introduce electrons or negative charge carriers. The cathode may be any metal or nonmetal which has a lower work function than the anode. Suitable materials for the cathode are selected from the group consisting of alkali metals of group 1, for example Li, Cs, alkaline earth metals of group 2, metals of group 12 of the Periodic Table of the Elements, comprising the rare earth metals and the lanthanides and actinides. In addition, metals such as aluminum, indium, calcium, barium, samarium and magnesium, and combinations thereof, may be used.

In general, the different layers, if present, have the following thicknesses:
anode (a): 500 to 5000 Å (ångström), preferably 1000 to 2000 Å;
hole injection layer (b): 50 to 1000 Å, preferably 200 to 800 Å,
hole-transport layer (c): 50 to 1000 Å, preferably 100 to 800 Å,
electron/exciton blocking layer (d): 10 to 500 Å, preferably 50 to 100 Å,
light-emitting layer (e): 10 to 1000 Å, preferably 50 to 600 Å,
hole/ exciton blocking layer (f): 10 to 500 Å, preferably 50 to 100 Å,
electron-transport layer (g): 50 to 1000 Å, preferably 200 to 800 Å,
electron injection layer (h): 10 to 500 Å, preferably 20 to 100 Å,
cathode (i): 200 to 10 000 Å, preferably 300 to 5000 Å.

The person skilled in the art is aware (for example on the basis of electrochemical studies) of how suitable materials have to be selected. Suitable materials for the individual layers are known to those skilled in the art and are disclosed, for example, in WO 00/70655.

In addition, it is possible that some of the layers used in the inventive OLED have been surface-treated in order to increase the efficiency of charge carrier transport. The selection of the materials for each of the layers mentioned is preferably determined by obtaining an OLED with a high efficiency and lifetime.

The inventive OLED can be produced by methods known to those skilled in the art. In general, the inventive OLED is produced by successive vapor deposition of the individual layers onto a suitable substrate. Suitable substrates are, for example, glass, inorganic semiconductors or polymer films. For vapor deposition, it is possible to use customary techniques, such as thermal evaporation, chemical vapor deposition (CVD), physical vapor deposition (PVD) and others. In an alternative process, the organic layers of the OLED can be applied from solutions or dispersions in suitable solvents, employing coating techniques known to those skilled in the art.

Use of the compounds of the formula I in at least one layer of the OLED, preferably in the light-emitting layer (preferably as a matrix material), charge transport layer and/or in the charge/exciton blocking layer makes it possible to obtain OLEDs with high efficiency and with low use and operating voltage. Frequently, the OLEDs obtained by the use of the compounds of the formula I additionally have high lifetimes. The efficiency of the OLEDs can additionally be improved by optimizing the other layers of the OLEDs. For example, high-efficiency cathodes such as Ca or Ba, if appropriate in combination with an intermediate layer of LiF, can be used. Moreover, additional layers may be present in the OLEDs in order to adjust the energy level of the different layers and to facilitate electroluminescence.

The OLEDs may further comprise at least one second light-emitting layer. The overall emission of the OLEDs may be composed of the emission of the at least two light-emitting layers and may also comprise white light.

The OLEDs can be used in all apparatus in which electroluminescence is useful. Suitable devices are preferably selected from stationary and mobile visual display units and illumination units. Stationary visual display units are, for example, visual display units of computers, televisions, visual display units in printers, kitchen appliances and advertising panels, illuminations and information panels. Mobile visual display units are, for example, visual display units in cellphones, tablet PCs, laptops, digital cameras, MP3 players, vehicles and destination displays on buses and trains. Further devices in which the inventive OLEDs can be used are, for example, keyboards; items of clothing; furniture; wallpaper. In addition, the present invention relates to a device selected from the group consisting of stationary visual display units such as visual display units of computers, televisions, visual display units in printers, kitchen appliances and advertising panels, illuminations, information panels, and mobile visual display units such as visual display units in cellphones, tablet PCs, laptops, digital cameras, MP3 players, vehicles and destination displays on buses and trains; illumination units; keyboards; items of clothing; furniture; wallpaper, comprising at least one inventive organic light-emitting diode or at least one inventive light-emitting layer.

The following examples are included for illustrative purposes only and do not limit the scope of the claims. Unless otherwise stated, all parts and percentages are by weight.

### Examples

### Example 1

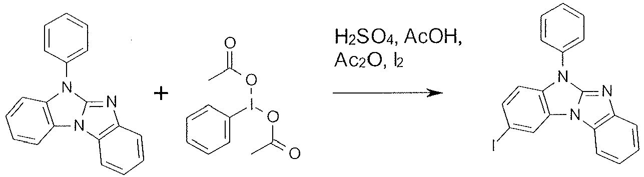

a) 1.00 g (3.53 mmol) 5-phenylbenzimidazolo[1,2-a]benzimidazole (example 2a) and 850 mg (2.65 mmol) diacetoxy-iodobenzene in 10 ml acetic acid and 10 ml acetic acid anhydride are heated to 60 °C and then cooled to 25 °C. 340 mg (1.34 mmol) iodine are added. 10 drops of sulfuric acid are added and the reaction mixture is stireed under nitrogen at 25 °C for 18 h. The product is filtered off and is washed with acetic acid, ethanol, water and again ethanol. The product is decocted with methyl ethyl ketone (yield: 560 mg (40 %)).
   ¹H NMR (400 MHz, THF-d8): δ = 8.39 (d, J= 1.6 Hz, 1H), 8.11-8.14 (m, 1H), 7.97-8.00 (m, 2H), 7.61-7.71 (m, 4H), 7.37-7.48 (m, 4H). MS (APCI(pos), m/z): 444 (M⁺¹), 442 (M⁺¹), 441 (M⁺¹). 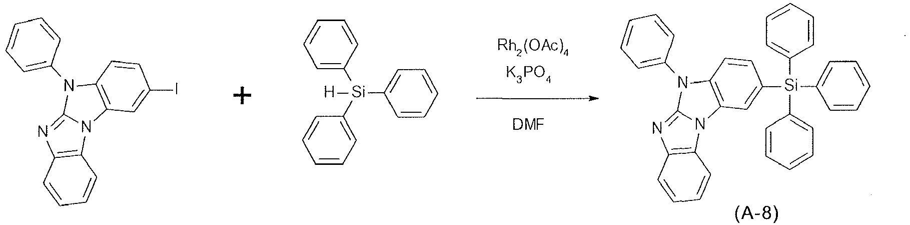
b) To 5.00 g (12.2 mmol) 2-iodo-5-phenyl-benzimidazolo[1,2-a]benzimidazole, 4.77 g (18.3 mmol) triphenylsilane, 5.19 g (24.4 mmol) potassium phosphate in 150 ml dimethylformamide is degassed with argon. 160 mg (0.37 mmol) Rhodium(II)-acetate is added and the reaction mixture is degassed with argon. The reaction mixture is stirred at 60 °C for 5 h under argon. Reaction mixture is poured in water and the water phase is extracted with dichloromethane. The organic phase is washed with 1 % KCN solution in water. The organic phase is dried with magnesium sulfate. The organic phase is filtered on Hyflo. The solvent is distilled off. Product is filtered off and is washed with ethanol. The product is decocted with methyl ethyl ketone. Yield 5.55 g (84 %)
   ¹H NMR (400 MHz, DMSO-d6): δ = 8.18 (s, 1H), 7.91-7.93 (m, 2H), 7.85-7.87 (m, 1H), 7.67-7.72 (m, 3H), 7.58-7.64 (m, 7H), 7.45-7.54 (m, 10 H), 7.37-7.41 (m, 3H)

### Example 2

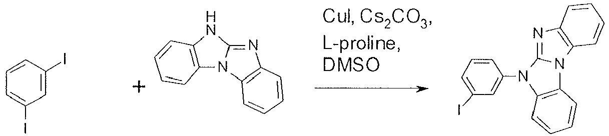

a) 31.7 g (96.1 mmol) diiodobenzene, 14.9 g (72.1 mmol) 6H-benzimidazolo[1,2-a]benzimidazole, 23.5 g (72.1 mmol) cesium carbonate, 1.83 g (9.61 mmol) cupper (I) iodide, 2.21 g (19.3 mmol) L-proline in 400 ml DMSO was stirred under nitrogen at 100 °C for 3 h. The reaction mixture was poured in 600 ml water and the product was filtered off. The product is washed with water and ethanol. 100 ml diethyl ether is added and the mixture is stirred for 3 h. Product is filtered off and is washed with ether. To the product 200 ml dichloromethane is added and the mixture is refluxed for 2 h. The mixture is filtered and washed with dichloromethane. The solvent of the filtrate is distilled off. Colum chromatography on silica gel with toluene/ethyl acetate 19/1 gave the product 6.47 g (22 %).
   ¹H NMR (400 MHz, DMSO-d6): δ = 8.32 (t, J =1.8 Hz, 1H), 8.19-8.24 (m, 2H), 7.93-7.96 (m, 1H) 7.86-7.88 (m, 1H), 7.63-7.68 (m 2H), 7.38-7.49 (m, 3H), 7.28-7.36 (m, 2H). 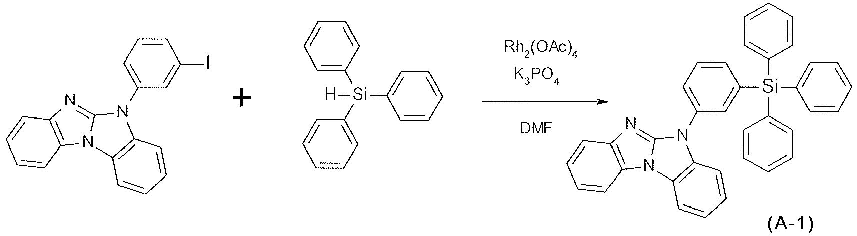
b) 5.00 g (12.2 mmol) 5-(3-iodophenyl)benzimidazolo[1,2-a]benzimidazole, 4.77 g (18.3 mmol) triphenylsilane, 3.53 g (16.5 mmol) potassium phosphate in 100 ml dimethylformamide is degassed with argon. 160 mg (0.37 mmol) Rhodium(II)-acetate is added and the reaction mixture is degassed with argon. The reaction mixture is stirred at 60 °C for 5 h under argon. Reaction mixture is poured in water and the water phase is extracted with dichloromethane. The organic phase is washed with 1 % KCN solution in water. The organic phase is dried with magnesium sulfate. The organic phase is filtered on silica gel and Hyflo with dichloromethane. The solvent is distilled off. 50 ml diethyl ether is added and the crystalized product is filtered of. The product is soxhlet extracted with methyl ethyl ketone.
   Yield 3.31 g (50 %)
   ¹H NMR (400 MHz, DMSO-d6): δ = 8.18 (t, J = 8.2 Hz, 2H), 8.09-8.12 (m, 1H), 7.97-7.98 (m, 1H), 7.74-7.79 (m, 1H), 7.58-7.64 (m, 8H), 7.25-7.54 (m, 14 H). MS (APCI(pos), m/z): 542 (M⁺¹).

### Example 3

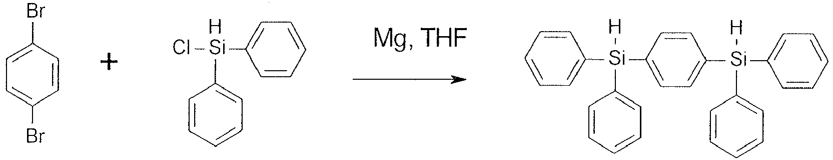

The synthesis of (4-diphenylsilylphenyl)-diphenyl-silane is described in J. Polymer Science: part A, 1964, 2, 15-19.
a) 5.67 g (25.9 mmol) chloro(diphenyl)silane and 540 mg (22.3 mmol) magnesium are placed under argon in 3 ml water free THF. To this mixture 2.50 g (10.6 mmol) 1,4-dibromobenzene are added in a way that the reaction mixture keeps boiling. After adding the 1,4-dibromobenzene the reaction mixture is refluxed for 1.5 h.
   The reaction mixture is poured into ice water and the water phase is extracted with diethyl ether. The organic phase is dried with magnesium sulfate and the solvent is distilled off. The product is decocted in ethanol and is than crystalized from diethyl ether (yield 3.83 g (82 %)). 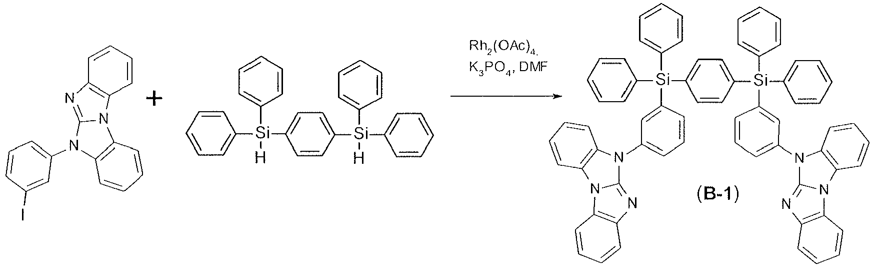
b) 970 mg (23.7 mmol) 5-(3-iodophenyl)benzimidazolo[1,2-a]benzimidazole (example 2 A) 500 mg (1.13 mmol) (4-diphenylsilylphenyl)-diphenyl-silane (example 3a)), 480 mg g (2.26 mmol) potassium phosphate tribasic in 25 ml dimethylformamide are degassed with argon. 15 mg (0.03 mmol) Rhodium(II)-acetate is added, the reaction mixture is degassed with argon, stirred at 60 °C for 5 h under argon and poured into water. The water phase is extracted with dichloromethane. The organic phase is washed with 1 % KCN solution in water. The organic phase is dried with magnesium sulfate. The organic phase is filtered on silica gel and Hyflo with dichloromethane. The solvent is distilled off. The crystalized product is washed with ethanol. The product is crystalized from methyl ethyl ketone (yield 460 mg (40 %)). MS (APCI(pos), m/z): 1005 (M⁺¹).

### Application Example 1

### Determination of triplet energy

The triplet energies of the materials are directly determined from the onsets of the measured phosphorescence spectra of the thin films of neat materials.
Thin films are prepared by first dissolving 2.5 mg of the materials, 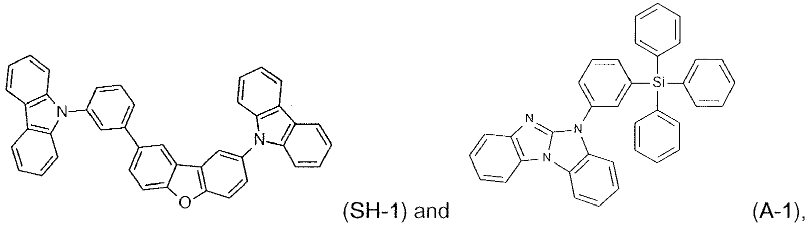 in 0.25 mL dichloromethane and second doctor-blading the solutions onto cleaned quartz-slides with a thin film applicator of 30 µm slot width (Erichsen, Model 360 02082).

For measurement the resulting thin film samples are inserted into a liquid-helium cryostat Optistat CF (Oxford Instruments) and cooled to a temperature of 4-5K. The phosphorescence spectra are measured with a fluorescence/phosphorescence spectrometer FLS-920P (Edinburgh Instruments). The samples are excited with an electrically pulsed LED model UVTOP 315-HL-T039 (Fa. Roithner, Vienna) with center wavelength 320 nm and pulse widths 5 µs). The emission spectra are detected via time-gated spectroscopy with a delay-time of 260 µs.

For compound 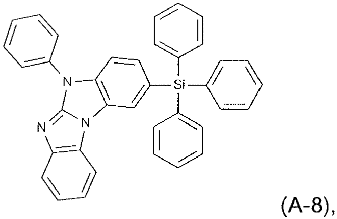 the compound is deposited by vapor deposition to the quartz substrates at a rate of approx. 0.5-5 nm/min at about 10⁻⁶ mbar until approx. 60 nm thick film is formed. The results are shown in Table 1 below.

| Material | E_{T} [eV]* |
|---|---|
| (SH-1) | 2.90 |
| (A-8) | 3.25 |
| (A-1) | 3.29 |

| | |
|---|---|
| *Onset of the neat film gated emission spectrum at 4 K | |

Compounds (A-8) and (A-1) of the present invention have larger triplet energy than the reference compound (SH-1).

### Comparative Example 1

The ITO substrate used as the anode is first cleaned with isopropanol mixture in an ultrasonic bath. To eliminate any possible organic residues, the substrate is exposed to a continuous ozone flow in an ozone oven for further 25 minutes. This treatment also improves the hole injection properties of the ITO. Then Plexcore® OC AJ20-1000 (commercially available from Plextronics Inc.) is spin-coated and dried to form a hole injection layer (-40 nm). Thereafter, the organic materials specified below are applied by vapor deposition to the Piexcore® coated substrate at a rate of approx. 0.5-5 nm/min at about 10⁻¹-10⁻⁹ mbar. As a hole transport, compound (SH-1) is applied by vapor deposition in a thickness of 10 nm doped with MoOₓ (∼10%) to improve the conductivity.

As exciton and electron blocker, 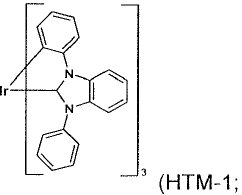 for preparation, see Ir complex (7) in the application WO2005/019373), is applied to the substrate with a thickness of 10 nm. Subsequently, a mixture of 10% by weight of emitter compound, 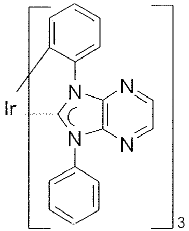 (BE-1), 5% by weight of compound (HTM-1) and 85% by weight of compound (SH-1) are applied by vapor deposition in a thickness of 40 nm. Subsequently, material (SH-1) is applied by vapour deposition with a thickness of 5 nm as blocker. Thereafter, a 20 nm thick electron transport layer is deposited consisting of 50% by weight of 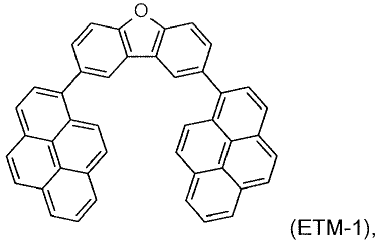 and of 50% of 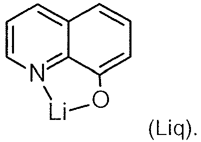 Finally a 2 nm KF layer serves as an electron injection layer and a 100 nm-thick Al electrode completes the device.

All fabricated parts are sealed with a glass lid and a getter in an inert nitrogen atmosphere.

### Application Examples 1 and 2

Comparative Application Example 1 is repeated except that the exciton blocker, (HTM-1), and the host (SH-1) are replaced by compounds (A-8) and (A-1), respectively.

### OLED characterization

To characterize the OLED, electroluminescence spectra are recorded at various currents and voltages. In addition, the current-voltage characteristic is measured in combination with the light output emitted. The light output is converted to photometric parameters by calibration with a photometer. The results are shown in Table 2. Data are given at luminance (L) = 1000 Cd/m² except otherwise stated.

**Table 2**

| Appl. Ex. | EBL | Host | U [V] | EQE¹⁾ [%] | CIEx | CIEy |
|---|---|---|---|---|---|---|
| 1 | (A-8) | (A-8) | 9.87 | 12.8 | 0.154 | 0.258 |
| 2 | (A-1) | (A-1) | 9.04 | 13.7 | 0.153 | 0.255 |
| Comp. Appl. Ex. 1 | (HTM-1) | (SH-1) | 7.59 | 14.1 | 0.163 | 0.302 |

| | | | | | | |
|---|---|---|---|---|---|---|
| ¹⁾ External quantum efficiency (EQE) is # of generated photons escaped from a substance or a device / # of electrons flowing through it. | | | | | | |

It is evident that the CIEy is reduced by replacing EBL/host (HTM-1)/(SH-1) by (A-8)/(A-8) and (A-1)/(A-1), respectively. Reducing the CIEy color coordinate corresponds directly to a deeper blue color.

### Comparative Application Example 2

The device is fabricated and characterized as described in Comparative Application Example 1 except for the following:
As a hole transport and exciton/electron blocker, (HTM-1), is applied to the substrate with a thickness of 20 nm, wherein the first 10 nm are doped with MoOₓ (∼10%) to improve the conductivity. Subsequently, a mixture of 10% by weight of emitter compound, (BE-1), 5% by weight of compound (HTM-1) and 85% by weight of compound (SH-1) is applied by vapor deposition in a thickness of 40 nm. Subsequently, material (SH-1) is applied by vapour deposition with a thickness of 5 nm as blocker. The ETL is evaporated according to application example 2.

### Application Examples 3 and 4

Comparative Application Examples 2 is repeated except that except that the host (SH-1) and the hole blocking layer are fully replaced by compound (A-8) and (A-1), respectively. The device results are shown in Table 3. Data are given at luminance (L) = 1000 Cd/m² except otherwise stated.

**Table 3**

| Appl. Ex. | Host | U [V] | EQE [%] | CIEx | CIEy |
|---|---|---|---|---|---|
| 3 | (A-1) | 7.52 | 14.0 | 0.161 | 0.256 |
| 4 | (A-8) | 8.57 | 12.9 | 0.153 | 0.251 |
| Comp. Appl. Ex. 1 | (SH-1) | 7.55 | 13.8 | 0.152 | 0.297 |

The results shown in Table 3 demonstrate that the CIEy is blue shifted significantly when using compounds (A-8) and (A-1) as host instead of reference compound (SH-1). Although the new materials are ultra high bandgap hosts the voltage for these devices is comparable or only slightly larger than for the reference device, which is not an ultrahigh bandgap material.

### Application Example 5 - Determination of triplet energy

The triplet energies of the materials are directly determined from the onsets of the measured phosphorescence spectra of the thin films of neat materials.

Thin pristine films are prepared by first dissolving 2.5 mg of the material in 0.25 ml dichloromethane respectively, and second doctor-blading the solutions onto pre-cleaned quartz-slides with a thin film applicator of 30 µm slot width (Erichsen, Model 360 02082).

The 2% in PMMA films are prepared by dissolving 1 mg of the respective material in 370 µl of a dichloromethane solution containing 10 wt% PMMA. A thin film applicator of 60 µm slot width (Erichsen, Model 360 02082) is used for doctor-blading.

For measurement the resulting thin film samples are inserted into a liquid-helium cryostat Optistat CF (Oxford Instruments) and cooled to a temperature of 4-5K. The phosphorescence spectra are measured with a fluorescence/phosphorescence spectrometer FLS-920P (Edinburgh Instruments). The samples are excited with an electrically pulsed LED model UVTOP 315-HL-TO39 (Fa. Roithner, Vienna) with a center wavelength of 320 nm and a pulse width of 5 µs. The emission spectra are detected via time-gated spectroscopy with a delay-time of 260 µs. The triplet energies (T₁) are determined from the onset of the phosphorescence spectra, the results are shown in the table below.

| Appl. Example | Comp. No. | T₁ (2% Host in PMMA) | T₁ (neat film) |
|---|---|---|---|
| 5a | A-8 | 3.35 eV | 3.24 eV |
| 5b | V-1 | 3.08 eV | 3.01 eV |

Compound (A-8) of the present invention has larger triplet energy than the reference compound 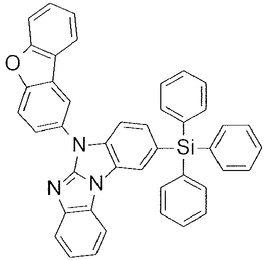 (V-1; correspondes to compound B-1 of WO2014009317).

## Claims

1. A compound of the formula 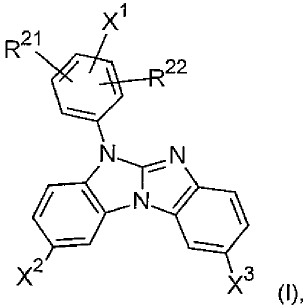 wherein
X¹ is H, a group of formula 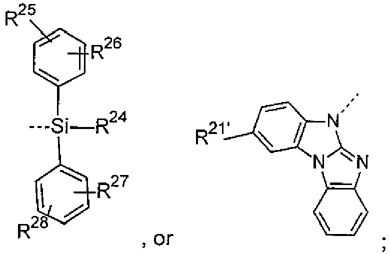
X² and X³ are independently of each other H, or a group of formula 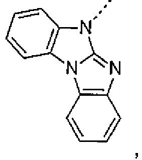 or 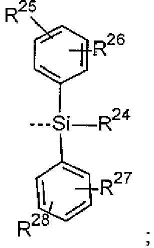
R²⁴ is a group of formula 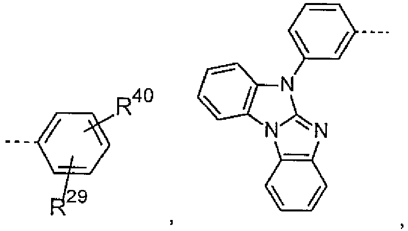 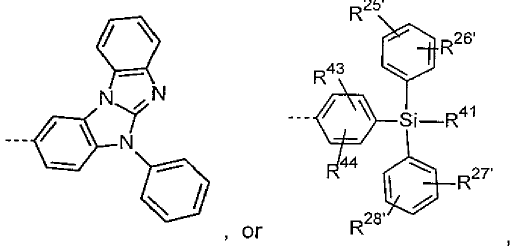
R⁴¹ is 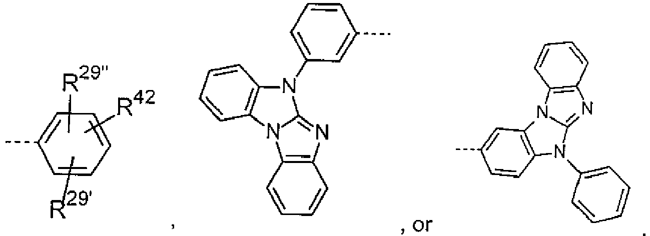
R⁴² is H, or 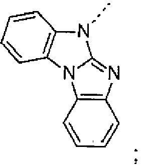
R²¹ and R^{21'} are independently of each other H, a C₁-C₁₈alkoxy group; a C₁-C₁₈alkyl group; or a C₁-C₁₈alkyl group which is interrupted by - O-, or a group of formula 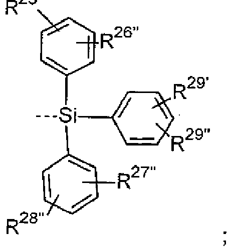
R²², R²⁵, R²⁶, R²⁷, R²⁸, R^{25'}, R^{26'}, R^{27'}, R^{28'}, R^{25"}, R^{26"}, R^{27"}, R^{26"}, R²⁹, R^{29'}, R^{29"}, R⁴⁰, R⁴³ and R⁴⁴ are indepndently of each other H, a C₁-C₁₆alkoxy group; a C₁-C₁₈alkyl group; or a C₁-C₁₈alkyl group which is interrupted by - O-;
with the proviso that at least one of X¹, X² and X³ is a group of formula 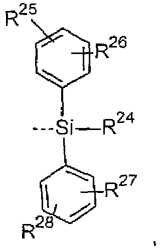 or comprises a group of formula

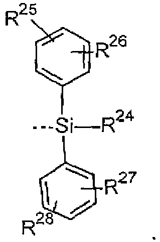

2. The compound according to claim 1, wherein
X¹ is H, a group of formula 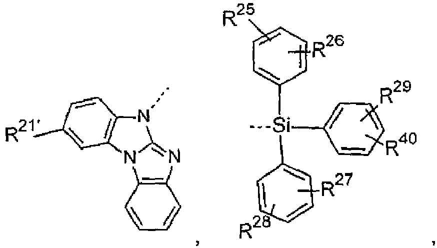 or 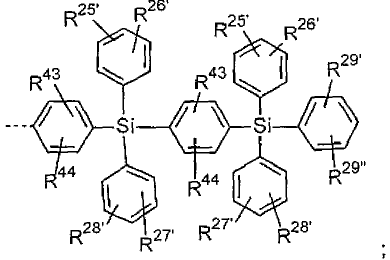
X² and X³ are independently of each other H, or a group of formula 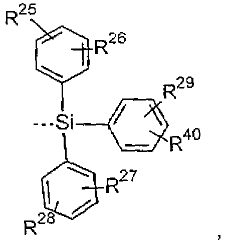 or 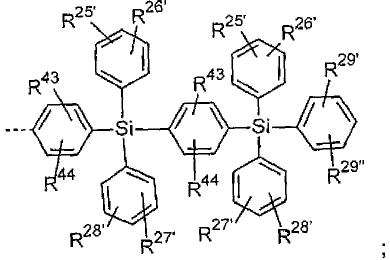
R²¹ and R^{21'} are independently of each other H, or a group of formula a group of formula 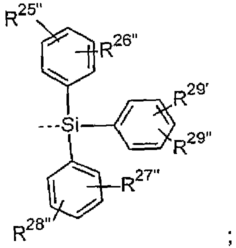
R²² is H;
R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29''}, R⁴⁰, R⁴³ and R⁴⁴ are independently of each other H, or a C₁-C₁₈alkyl group, with the proviso that at least one of X¹, X² and X³ is group of formula 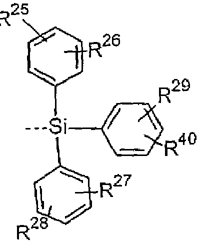 and/or

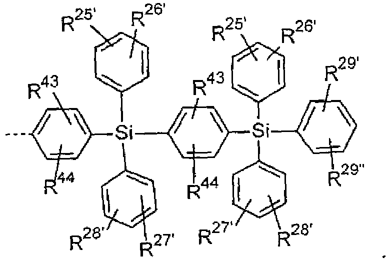

3. The compound according to claim 2, wherein R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ and R⁴⁴ are H.

4. The compound according to claim 1, or 2, wherein X¹ is a group of formula 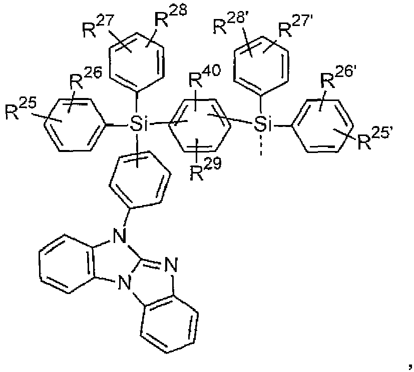 wherein R²⁵, R²⁶, R²⁷, R²⁸, R^{25'}, R^{26'}, R^{27'}, R^{28'}, R²⁹ and R⁴⁰ are independently of each other H, or a C₁-C₁₈alkyl group, and X², X³, R²¹, R²² and X³ are H.

5. The compound according to claim 1, or 2, wherein X² is a group of formula 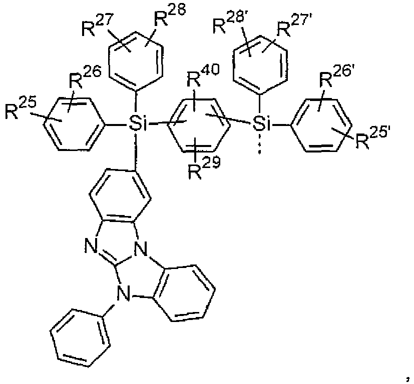 wherein R²⁵, R²⁶, R²⁷, R²⁸, R^{25'}, R^{26'}, R^{27'}, R^{28'}, R²⁹ and R⁴⁰ are independently of each other H, or a C₁-C₁₈alkyl group, and X¹, X³, R²¹, R²² and X³ are H.

6. The compound according to claim 4, or 5, wherein R²⁵, R²⁶, R²⁷, R²⁸, R^{25'} , R^{26'}, R^{27'}, R^{28'}, R²⁹ and R⁴⁰ are H.

7. The compound according to any of claims 1 to 6, which is a compound of formula 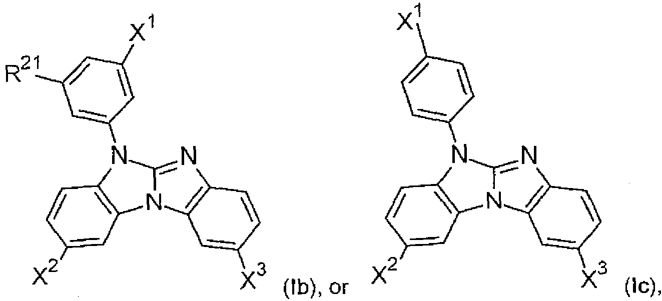 wherein
X¹ is H, a group of formula 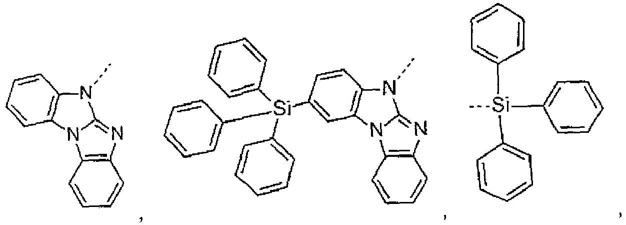 or 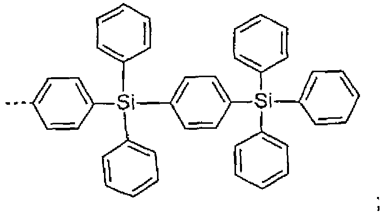
X² is H, or a group of formula 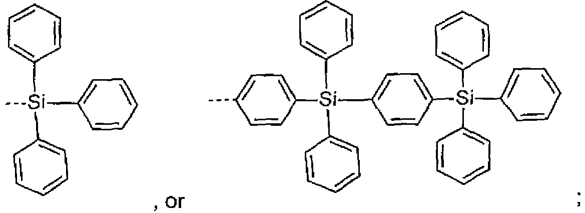
X³ is H, or a group of formula 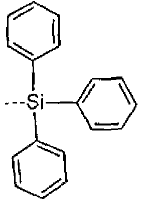 and
R²¹ is H, or a group of formula 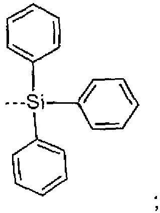 or
a compound of formula (Ib), or (Ic), wherein
X¹ is a group of formula 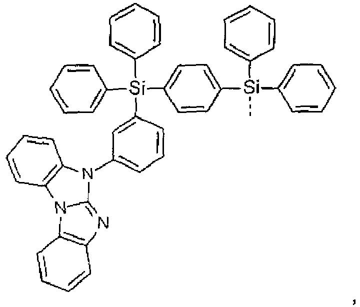 or 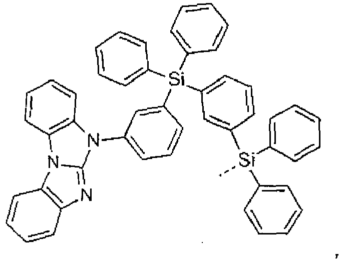 X² is H, X³ is H and R²¹ is H; or
a compound of formula (Ib), or (Ic), wherein
X² is a group of formula 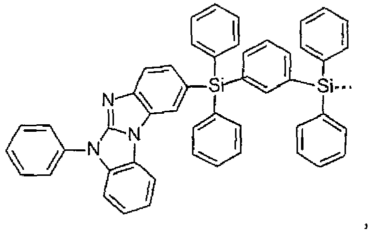 or 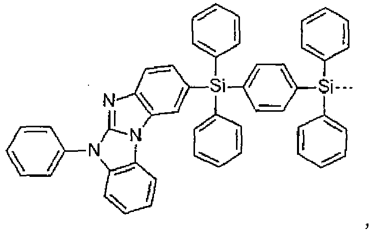 X¹ is H, X³ is H and R²¹ is H.

8. An electronic device, comprising a compound according to any of claims 1 to 7.

9. The electronic device according to claim 8, which is an electroluminescent device.

10. A hole transport layer, an electron/exciton blocking layer, or an emitting layer comprising a compound according to any of claims 1 to 7.

11. The emitting layer according to claim 10, comprising a compound according to any of claims 1 to 7 as host material in combination with a phosphorescent emitter.

12. An apparatus selected from the group consisting of stationary visual display units; mobile visual display units; illumination units; keyboards; items of clothing; furniture; wallpaper, comprising the organic electronic device according to claim 8, or 9, or the hole transport layer, the electron/exciton blocking layer, or the emitting layer according to claim 10.

13. Use of the compounds of formula I according to any of claims 1 to 7 for electrophotographic photoreceptors, photoelectric converters, organic solar cells, switching elements, organic light emitting field effect transistors, image sensors, dye lasers and electroluminescent devices.

## Patentansprüche

1. Verbindung der Formel 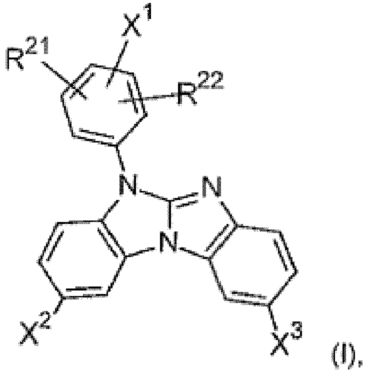 worin
X¹ für H, eine Gruppe der Formel 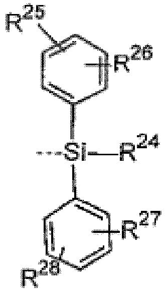 oder 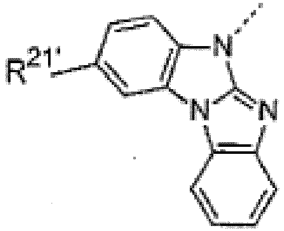 steht;
X² und X³ unabhängig voneinander für H oder eine Gruppe der Formel 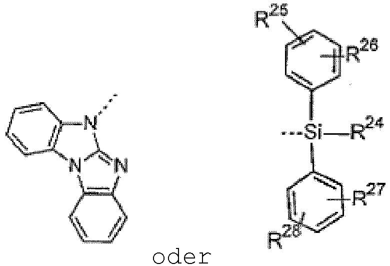 steht;
R²⁴ für eine Gruppe der Formel 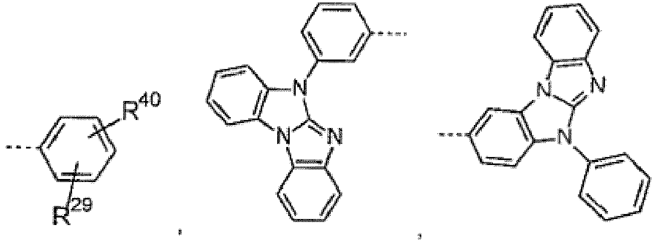 oder 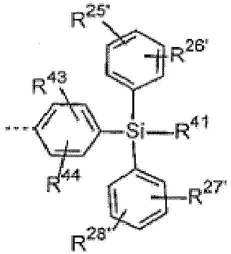 steht;
R⁴¹ für 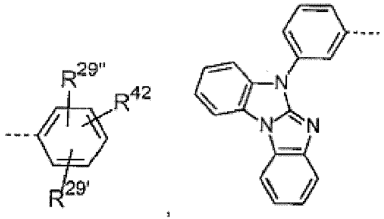 oder 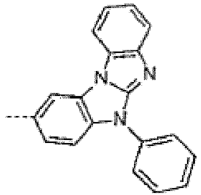 steht;
R⁴² für H oder 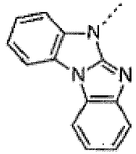 steht;
R²¹ und R^{21'} unabhängig voneinander für H, eine C₁-C₁₈-Alkoxygruppe, eine C₁-C₁₈-Alkylgruppe oder eine C₁-C₁₈-Alkylgruppe, die durch -O- unterbrochen ist, oder eine Gruppe der Formel 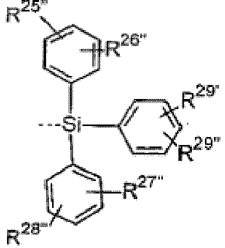 stehen;
R²², R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ und R⁴⁴ unabhängig voneinander für H, eine C₁-C₁₈-Alkoxygruppe, eine C₁-C₁₈-Alkylgruppe oder eine C₁-C₁₈-Alkylgruppe, die durch -O- unterbrochen ist, stehen;
mit der Maßgabe, dass mindestens eines von X¹, X²
und X³ für eine Gruppe der Formel 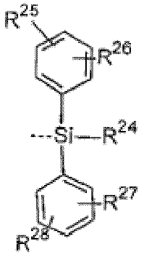 steht oder eine Gruppe der Formel 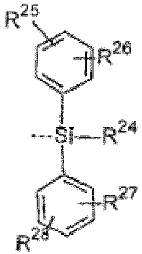 umfasst.

2. Verbindung nach Anspruch 1, wobei
X¹ für H, eine Gruppe der Formel 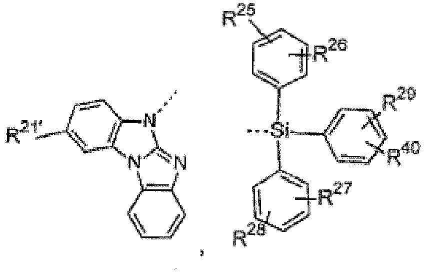 oder 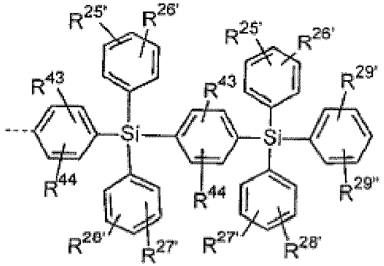 steht;
X² und X³ unabhängig voneinander für H oder eine Gruppe der Formel 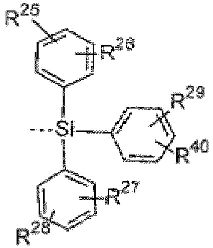 oder 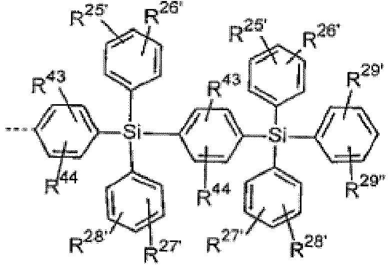 stehen;
R²¹ und R^{21'} unabhängig voneinander für H oder eine Gruppe der Formel 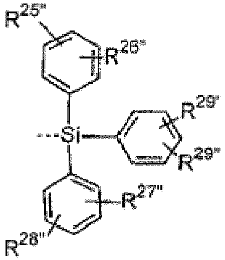 steht;
R²² für H steht;
R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ und R⁴⁴ unabhängig voneinander für H oder eine C₁-C₁₈-Alkylgruppe stehen, mit der Maßgabe, dass mindestens eines von X¹, X² und X³ für eine Gruppe der Formel 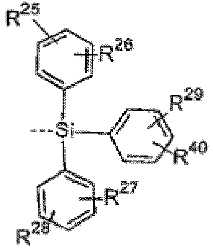 und/oder 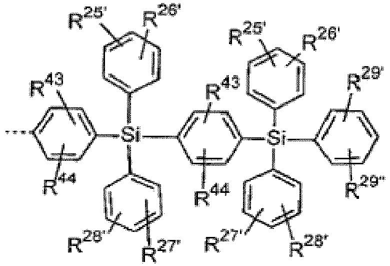 steht.

3. Verbindung nach Anspruch 2, wobei R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ und R⁴⁴ für H stehen.

4. Verbindung nach Anspruch 1 oder 2, wobei X¹ für eine Gruppe der Formel 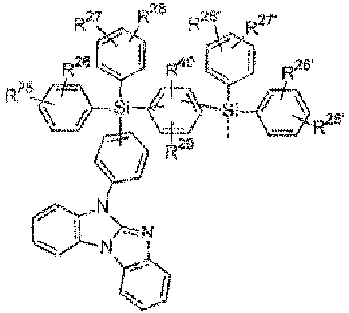 steht, wobei R²⁵, R²⁶, R²⁷, R²⁸, R^{25'}, R^{26'}, R^{27'}, R^{28'}, R²⁹ und R⁴⁰ unabhängig voneinander für H oder eine C₁-C₁₈-Alkylgruppe stehen und X², X³, R²¹, R²² und X³ für H stehen.

5. Verbindung nach Anspruch 1 oder 2, wobei X² für eine Gruppe der Formel 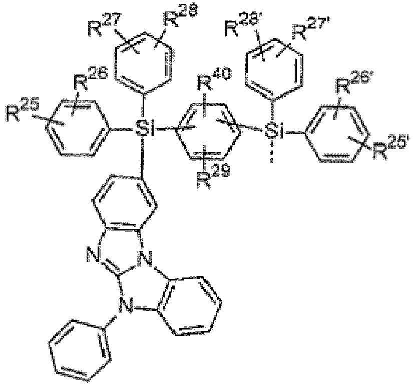 steht, wobei R²⁵, R²⁶, R²⁷, R²⁸, R^{25'}, R^{26'}, R^{27'}, R^{28'}, R²⁹ und R⁴⁰ unabhängig voneinander für H oder eine C₁-C₁₈-Alkylgruppe stehen und X¹, X³, R²¹, R²² und X³ für H stehen.

6. Verbindung nach Anspruch 4 oder 5, wobei R²⁵, R²⁶, R²⁷, R²⁸, R^{25'}, R^{26'}, R^{27'}, R^{28'}, R²⁹ und R⁴⁰ für H stehen.

7. Verbindung nach einem der Ansprüche 1 bis 6, bei der es sich um eine Verbindung der Formel 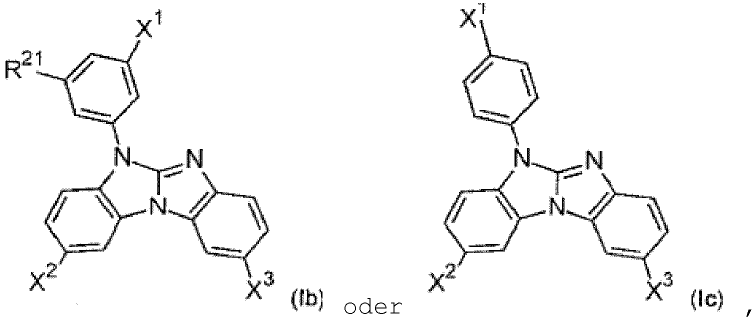 wobei
X¹ für H, eine Gruppe der Formel 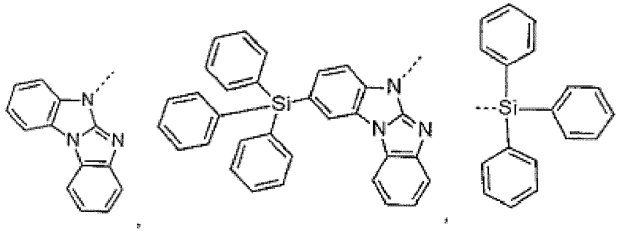 oder 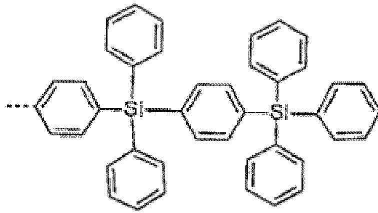 steht;
X² für H oder eine Gruppe der Formel 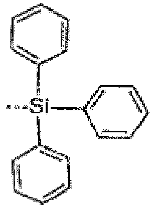 oder 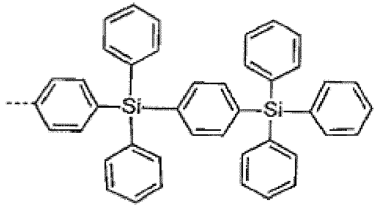 steht;
X³ für H oder eine Gruppe der Formel 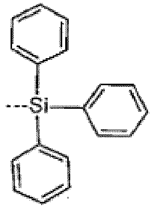 steht und
R²¹ für H oder eine Gruppe der Formel 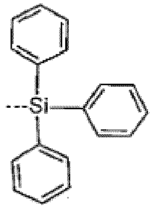 steht; oder
eine Verbindung der Formel (Ib) oder (Ic), worin
X¹ für eine Gruppe der Formel 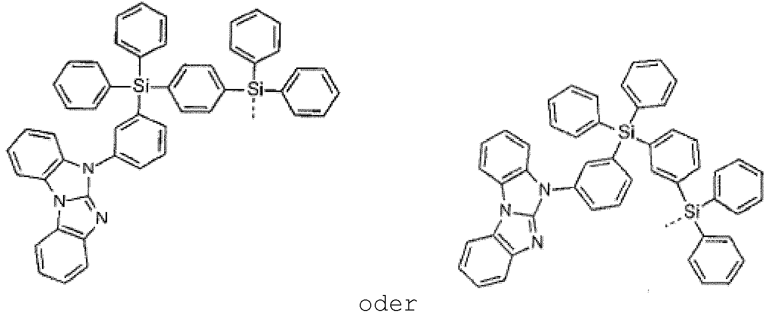 steht, X² für H steht, X³ für H steht und R²¹ für H steht; oder
eine Verbindung der Formel (Ib) oder (Ic), worin
X² für eine Gruppe der Formel 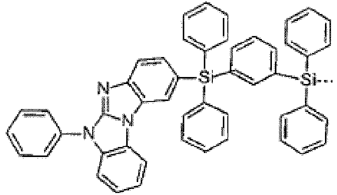 oder 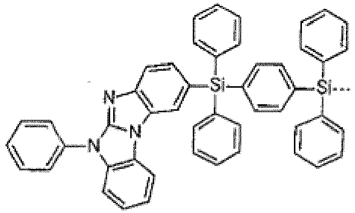 steht, X¹ für H steht, X³ für H steht und R²¹ für H steht;
handelt.

8. Elektronische Vorrichtung, umfassend eine Verbindung nach einem der Ansprüche 1 bis 7.

9. Elektronische Vorrichtung nach Anspruch 8, bei der es sich um eine Elektrolumineszenzvorrichtung handelt.

10. Lochtransportschicht, Elektronen/Excitonen-Blockierschicht oder Emissionsschicht, umfassend eine Verbindung nach einem der Ansprüche 1 bis 7.

11. Emissionsschicht nach Anspruch 10, umfassend eine Verbindung nach einem der Ansprüche 1 bis 7 als Wirtsmaterial in Kombination mit einem phosphoreszierenden Emitter.

12. Apparatur, ausgewählt aus der Gruppe bestehend aus stationären Bildschirmen, mobilen Bildschirmen, Beleuchtungseinheiten, Tastaturen, Kleidungsstücken, Möbeln, Tapeten, umfassend die organische elektronische Vorrichtung nach Anspruch 8 oder 9 oder die Lochtransportschicht, Elektronen/Excitonen-Blockierschicht oder Emissionsschicht nach Anspruch 10.

13. Verwendung der Verbindungen der Formel I nach einem der Ansprüche 1 bis 7 für elektrophotographische Photorezeptoren, photoelektrische Umwandler, organische Solarzellen, Schaltelemente, organische lichtemittierende Feldeffekttransistoren, Bildsensoren, Farbstofflaser und Elektrolumineszenzvorrichtungen.

## Revendications

1. Composé de formule 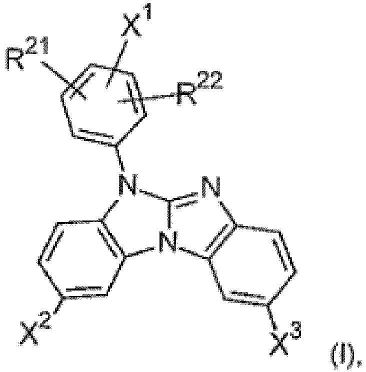
X¹ étant H, un groupe de formule 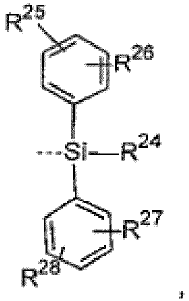 ou 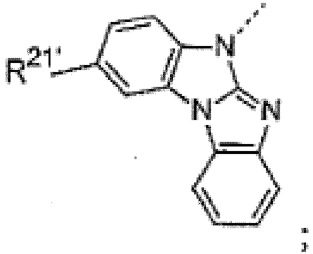
X² et X³ étant indépendamment l'un de l'autre H, ou un groupe de formule 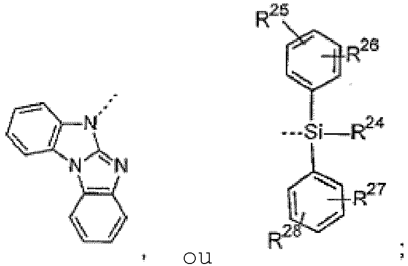
R²⁴ étant un groupe de formule 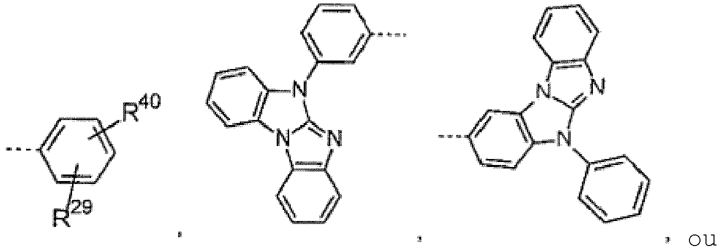 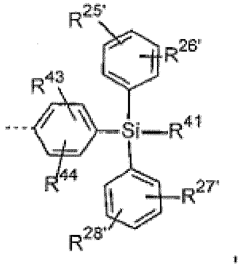
R⁴¹ étant 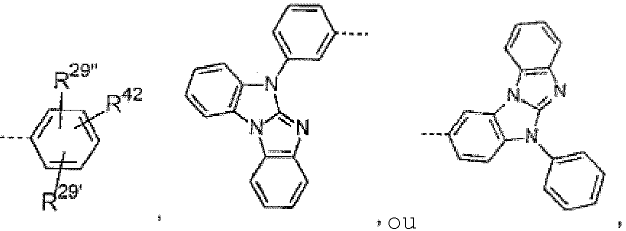
R⁴² étant H, 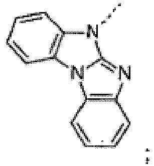
R²¹ et R^{21'} étant indépendamment l'un de l'autre H, un groupe C₁₋₁₈-alcoxy ; un groupe C₁₋₁₈-alkyle ; ou
un groupe C₁₋₁₈-alkyle qui est interrompu par -O-, ou un groupe de formule 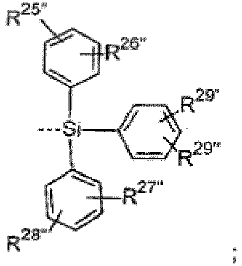 R²², R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ et R⁴⁴ étant indépendamment les uns des autres H, un groupe C₁₋₁₈-alcoxy ; un groupe C₁₋₁₈-alkyle ; ou un groupe C₁₋₁₈-alkyle qui est interrompu par -O- ;
étant entendu qu'au moins l'un parmi X¹, X² et X³ est un groupe de formule 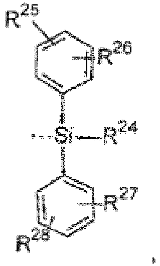 ou comprend un groupe de formule

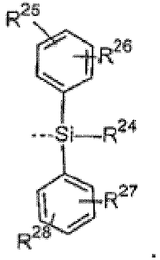

2. Composé selon la revendication 1,
X¹ étant H, un groupe de formule 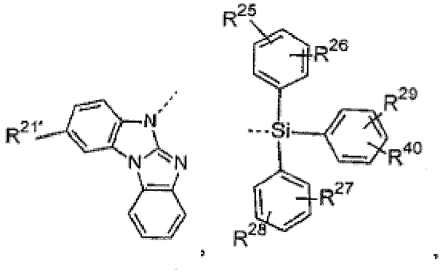 ou 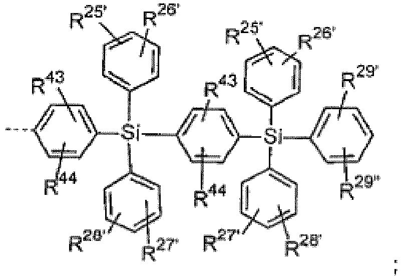
X² et X³ étant indépendamment l'un de l'autre H, ou
un groupe de formule 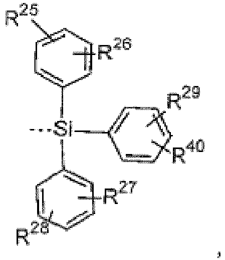 ou 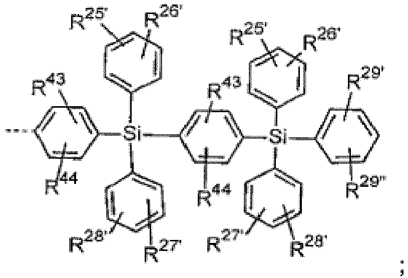
R²¹ et R^{21'} étant indépendamment l'un de l'autre H, ou un groupe de formule 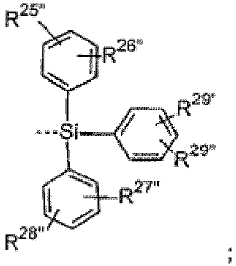
R²² étant H ;
R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ et R⁴⁴ étant indépendamment les uns des autres H, ou un groupe C₁₋₁₈-alkyle, étant entendu qu'au moins l'un parmi X¹, X² et X³ est un groupe de formule

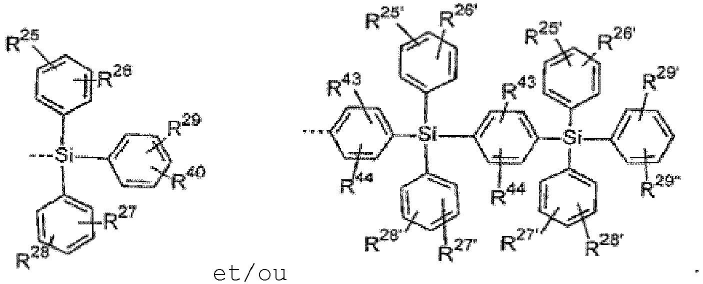

3. Composé selon la revendication 2, R²⁵, R²⁶, R²⁷, R²⁸, R^{25'}, R^{26'}, R^{27'}, R^{28'}, R^{25"}, R^{26"}, R^{27"}, R^{28"}, R²⁹, R^{29'}, R^{29"}, R⁴⁰, R⁴³ et R⁴⁴ étant H.

4. Composé selon la revendication 1, ou 2, X¹ étant un groupe de formule 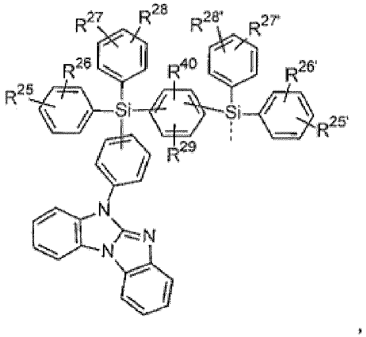 R²⁵, R²⁶, R²⁷, R²⁸, R^{25'}, R^{26'}, R^{27'}, R^{28'}, R²⁹ et R⁴⁰ étant indépendamment les uns des autres H, ou un groupe C₁₋₁₈-alkyle, et X², X³, R²¹, R²² et X³ étant H.

5. Composé selon la revendication 1, ou 2, X² étant un groupe de formule 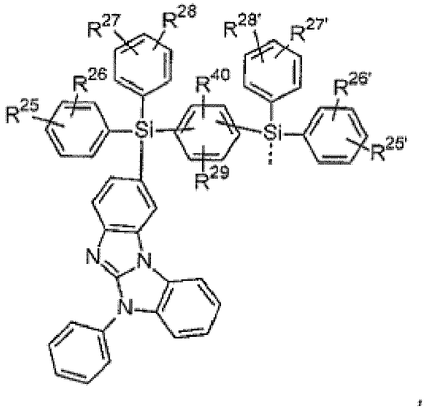 R²⁵, R²⁶, R²⁷, R²⁸, R^{25'}, R^{26'}, R^{27'}, R^{28'}, R²⁹ et R⁴⁰ étant indépendamment les uns des autres H, ou un groupe C₁₋₁₈-alkyle, et X¹, X³, R²¹, R²² et X³ étant H.

6. Composé selon la revendication 4, ou 5, R²⁵, R²⁶, R²⁷, R²⁸, R^{25'}, R^{26'}, R^{27'}, R^{28'}, R²⁹ et R⁴⁰ étant H.

7. Composé selon l'une quelconque des revendications 1 à 6, qui est un composé de formule 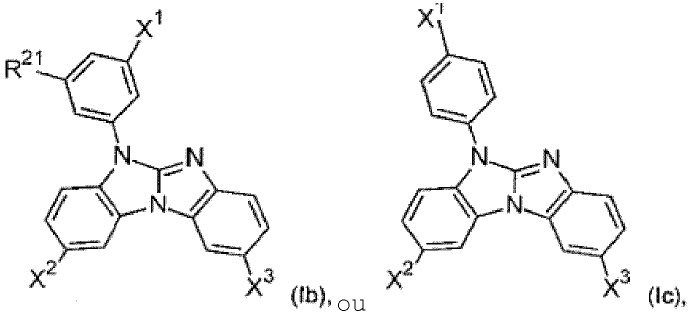
X¹ étant H, un groupe de formule 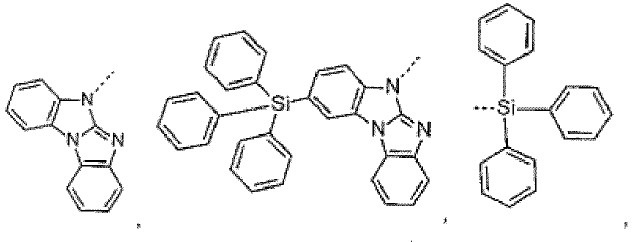 ou 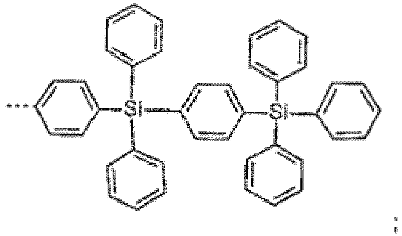
X² étant H, ou un groupe de formule 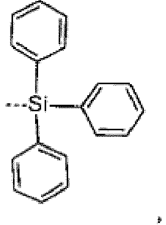 ou 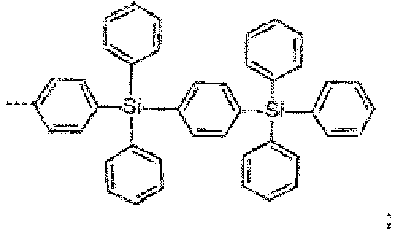
X³ étant H, ou un groupe de formule 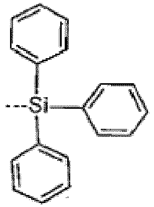 et
R²¹ étant H, ou un groupe de formule 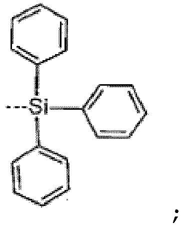 ou
un composé de formule (Ib), ou (Ic),
X¹ étant un groupe de formule 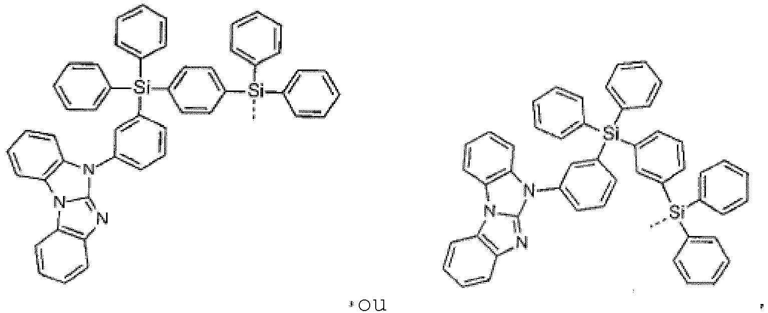
X² étant H, X³ étant H et R²¹ étant H ; ou
un composé de formule (Ib), ou (Ic),
X² étant un groupe de formule 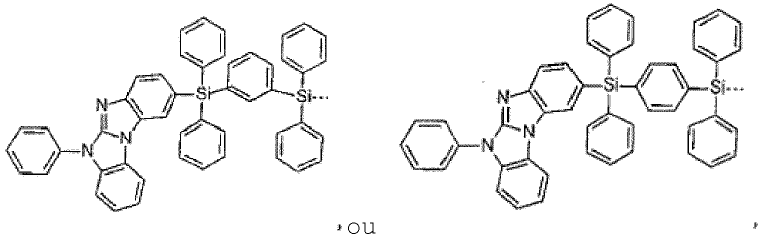 X¹ étant H, X³ étant H et R²¹ étant H.

8. Dispositif électronique, comprenant un composé selon l'une quelconque des revendications 1 à 7.

9. Dispositif électronique selon la revendication 8, qui est un dispositif électroluminescent.

10. Couche de transport de trous, couche de blocage d'électrons/excitons, ou couche émettrice comprenant un composé selon l'une quelconque des revendications 1 à 7.

11. Couche émettrice selon la revendication 10, comprenant un composé selon l'une quelconque des revendications 1 à 7 en tant que matériau hôte en combinaison avec un émetteur phosphorescent.

12. Appareil choisi dans le groupe constitué par des unités d'affichage visuel stationnaires ; des unités d'affichage visuel mobiles ; des unités d'éclairage ; des claviers ; des articles d'habillement ; un meuble ; du papier peint, comprenant le dispositif électronique organique selon la revendication 8, ou 9, ou la couche de transport de trous, la couche de blocage d'électrons/excitons, ou la couche émettrice selon la revendication 10.

13. Utilisation des composés de formule I selon l'une quelconque des revendications 1 à 7 pour des photorécepteurs électrophotographiques, des convertisseurs photoélectriques, des cellules solaires organiques, des éléments commutatifs, des transistors organiques luminescents à effet de champ, des capteurs d'images, des lasers à colorant et des dispositifs électroluminescents.
